(19) Europäisches Patentamt
European Patent Office
Office européen des brevets

(11) EP 4 395 211 A1

(12) EUROPEAN PATENT APPLICATION
published in accordance with Art. 153(4) EPC

(43) Date of publication:
**03.07.2024 Bulletin 2024/27**

(21) Application number: **22874561.8**

(22) Date of filing: **02.09.2022**

(51) International Patent Classification (IPC):
***H04L 1/18*** *(2023.01)* ***H04L 1/00*** *(2006.01)*

(52) Cooperative Patent Classification (CPC):
**H04L 1/00; H04L 1/18; H04L 1/1812; H04L 1/1867**

(86) International application number:
**PCT/CN2022/116911**

(87) International publication number:
**WO 2023/051170 (06.04.2023 Gazette 2023/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2021 CN 202111169363**

(71) Applicant: **Huawei Technologies Co., Ltd.**
**Shenzhen, Guangdong 518129 (CN)**

(72) Inventors:
- **QIN, Kangjian**
  **Shenzhen, Guangdong 518129 (CN)**
- **LI, Rong**
  **Shenzhen, Guangdong 518129 (CN)**
- **ZHANG, Huazi**
  **Shenzhen, Guangdong 518129 (CN)**
- **WANG, Xianbin**
  **Shenzhen, Guangdong 518129 (CN)**
- **DAI, Shengchen**
  **Shenzhen, Guangdong 518129 (CN)**
- **WANG, Jun**
  **Shenzhen, Guangdong 518129 (CN)**

(74) Representative: **Gill Jennings & Every LLP**
**The Broadgate Tower**
**20 Primrose Street**
**London EC2A 2ES (GB)**

# (54) RETRANSMISSION METHOD AND APPARATUS

(57) This application discloses a retransmission method and an apparatus. The method includes: obtaining a first bit sequence and a number E of to-be-retransmitted bits, performing second channel encoding based on the first bit sequence to obtain a second bit sequence, and performing retransmission based on the second bit sequence. The first bit sequence is obtained by performing first channel encoding based on K information bits, a length of the first bit sequence is N, N, E, and K are all integers greater than or equal to 1, and the second bit sequence includes the E to-be-retransmitted bits. According to the method, a code length can be flexibly extended based on different numbers E of to-be-retransmitted bits. This improves flexibility of code length extension.

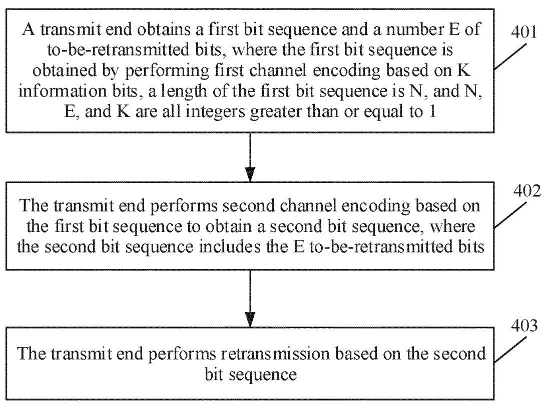


FIG. 4

EP 4 395 211 A1

## Description

This application claims priority to Chinese Patent Application No. 202111169363.4, filed with the China National Intellectual Property Administration on September 30, 2021 and entitled "RETRANSMISSION METHOD AND APPARATUS", which is incorporated herein by reference in its entirety.

## TECHNICAL FIELD

This application relates to the field of communication technologies, and in particular, to a retransmission method and an apparatus.

## BACKGROUND

A hybrid automatic repeat request (hybrid automatic repeat request, HARQ) has advantages of forward error correction coding and an automatic repeat request, and is a key technology for improving system throughput and data transmission reliability.

A channel encoding scheme of a data channel needs to support the HARQ. Generally, a HARQ scheme mainly includes a chase combining (chase combining, CC) HARQ, an incremental freezing (incremental freezing, IF) HARQ, and an incremental redundancy (incremental redundancy, IR) HARQ. The CC-HARQ is easy to implement, but does not generate a coding gain. Compared with the CC-HARQ, the IF-HARQ may have a coding gain, but increases a decoding delay and encoding/decoding complexity. The IR-HARQ may obtain performance close to that of long code by extending a code length. However, an extended information bit in the IR-HARQ scheme may come from any previous transmission, and original information bits and duplicated bits are read and duplicated in an irregular order, resulting in an inflexible application.

Therefore, how to flexibly perform retransmission is a problem that is being studied by a person skilled in the art.

## SUMMARY

This application provides a retransmission method and an apparatus, to effectively improve flexibility of code length extension.

According to a first aspect, an embodiment of this application provides a retransmission method. The method includes:

obtaining a first bit sequence and a number E of to-be-retransmitted bits, where the first bit sequence is obtained by performing first channel encoding based on K information bits, a length of the first bit sequence is N, and N, E, and K are all integers greater than or equal to 1; performing second channel encoding based on the first bit sequence to obtain a second bit sequence, where the second bit sequence includes the E to-be-retransmitted bits; and performing retransmission based on the second bit sequence.

In this embodiment of this application, second channel encoding is performed on a bit sequence for an initial transmission, for example, the first bit sequence, to obtain to-be-retransmitted bits corresponding to the number of to-be-retransmitted bits, for example, the E to-be-retransmitted bits. That is, the method provided in this embodiment of this application not only can directly perform encoding for retransmission based on the bit sequence for the initial transmission, but also can flexibly extend a code length (for example, flexibly extend the code length based on the number of to-be-retransmitted bits).

In a possible implementation, the performing second channel encoding based on the first bit sequence includes: performing second channel encoding based on the first bit sequence and an extended matrix, where the extended matrix includes E rows and N columns, the extended matrix is obtained based on an extended base matrix, the extended base matrix includes $E_0$ rows and $N_0$ columns, and both $E_0$ and $N_0$ are integers greater than or equal to 1.

In a possible implementation, a lifting size Z of the extended base matrix is a prime number; or $Z=2^n$, Z is a lifting size of the extended base matrix, and n is an integer greater than or equal to 0.

In a possible implementation, $Z=N/N_0$, and Z is the lifting size of the extended base matrix.

In a possible implementation, Z=16.

In a possible implementation, the E rows of the extended matrix are the first E rows of a first matrix, and the first matrix is a matrix obtained by extending the extended base matrix based on a lifting size; or the E rows of the extended matrix are E adj acent rows of a first matrix, the E adjacent rows of the first matrix are determined based on a bit rate of first channel encoding, and the first matrix is a matrix obtained by extending the extended base matrix based on a lifting size.

In a possible implementation, a row weight of a row of the extended matrix is related to N, K, and E.

In a possible implementation, the row weight of the row of the extended matrix meets any one or more of the following relationships: The row weight is negatively correlated with E, the row weight is positively correlated with K, the row weight is negatively correlated with N, and the row weight is positively correlated with K/N.

In a possible implementation, a row weight of a first row of the extended matrix meets any one or more of the following relationships: The row weight is negatively correlated with E, the row weight is positively correlated with K, the row weight is negatively correlated with N, and the row weight is positively correlated with K/N.

In a possible implementation, row weights of at least two rows of the extended matrix meet any one or more of the following relationships: The row weights are negatively correlated with E, the row weights are positively correlated with K, the row weights are negatively correlated with N, and the row weights are positively correlated with K/N.

In a possible implementation, a row weight of each row of the extended matrix meets any one or more of the following relationships: The row weight is negatively correlated with E, the row weight is positively correlated with K, the row weight is negatively correlated with N, and the row weight is positively correlated with K/N.

In a possible implementation, locations of the K information bits are determined based on a first reliability sequence, a length of the first reliability sequence is N, the first reliability sequence is a subsequence of a second reliability sequence, a length of the second reliability sequence is $N_{max}$, and $N_{max}$ is greater than or equal to N.

In a possible implementation, the second reliability sequence meets the following relationship.

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N_{max}}$ indicates a reliability sequence, an element is a sequence number of a subchannel, $W(Q_i^{N_{max}})$ indicates reliability corresponding to the reliability sequence, and i is an integer greater than or equal to 1 and less than or equal to $N_{max}$.

In a possible implementation, that the first bit sequence is obtained by performing first channel encoding based on the K information bits includes: The first bit sequence is obtained by performing first channel encoding based on the K information bits and an internal interleaver sequence, where a size of a block of the internal interleaver sequence is equal to a lifting size of the extended matrix.

In a possible implementation, the performing retransmission based on the second bit sequence includes: determining an initial transmission start point of a cyclic buffer based on N and K; determining a retransmission start point of the cyclic buffer based on the initial transmission start point and N, or determining a retransmission start point of the cyclic buffer based on the initial transmission start point and E; and performing retransmission based on the second bit sequence and the retransmission start point.

According to a second aspect, an embodiment of this application provides a retransmission method. The method includes:

obtaining a second to-be-decoded sequence, where the second to-be-decoded sequence includes information about E retransmitted bits, and E is an integer greater than or equal to 1; performing second channel decoding on the second to-be-decoded sequence based on an extended matrix to obtain a first to-be-decoded sequence, where the extended matrix includes E rows and N columns, the extended matrix is obtained based on an extended base matrix, the extended base matrix includes $E_0$ rows and $N_0$ columns, the first to-be-decoded sequence includes information about N bits, and both $E_0$ and $N_0$ are integers greater than or equal to 1; and performing first channel decoding on the first to-be-decoded sequence based on a first reliability sequence, to obtain K information bits, where a length of the first reliability sequence is N, the first reliability sequence is a subsequence of a second reliability sequence, a length of the second reliability sequence is $N_{max}$, $N_{max}$ is greater than or equal to N, and K is an integer greater than or equal to 1.

For example, the information about the E retransmitted bits may be understood as a soft information sequence obtained by processing the E retransmitted bits through a channel, and the information about the N bits may be understood as a soft information sequence obtained by processing N initially transmitted bits through a channel.

It may be understood that in the foregoing method, the first reliability sequence is the subsequence of the second reliability sequence. However, in this embodiment of this application, the first reliability sequence may alternatively be obtained based on the extended matrix. For example, a receive end may obtain the first reliability sequence by using an online construction method.

In a possible implementation, a lifting size Z of the extended base matrix is a prime number; or $Z=2^n$, Z is a lifting size of the extended base matrix, and n is an integer greater than or equal to 0.

In a possible implementation, $Z=N/N_0$, and Z is the lifting size of the extended base matrix.

In a possible implementation, Z=16.

In a possible implementation, the E rows of the extended matrix are the first E rows of a first matrix, and the first matrix is a matrix obtained by extending the extended base matrix based on a lifting size; or the E rows of the extended matrix are E adj acent rows of a first matrix, the E adjacent rows of the first matrix are determined based on a bit rate of first channel encoding, and the first matrix is a matrix obtained by extending the extended base matrix based on a lifting size.

In a possible implementation, a row weight of a row of the extended matrix is related to N, K, and E.

In a possible implementation, the row weight of the row of the extended matrix meets any one or more of the following relationships: The row weight is negatively correlated with E, the row weight is positively correlated with K, the row weight is negatively correlated with N, and the row weight is positively correlated with K/N.

In a possible implementation, a row weight of a first row of the extended matrix meets any one or more of the following relationships: The row weight is negatively correlated with E, the row weight is positively correlated with K, the row weight is negatively correlated with N, and the row weight is positively correlated with K/N.

In a possible implementation, row weights of at least two rows of the extended matrix meet any one or more of the following relationships: The row weights are negatively correlated with E, the row weights are positively correlated with K, the row weights are negatively correlated with N, and the row weights are positively correlated with K/N.

In a possible implementation, a row weight of each row of the extended matrix meets any one or more of the following relationships: The row weight is negatively correlated with E, the row weight is positively correlated with K, the row weight is negatively correlated with N, and the row weight is positively correlated with K/N.

In a possible implementation, the second reliability sequence meets the following relationship.

| $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ | $W\left(Q_i^{N_{max}}\right)$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N_{max}}$ indicates a reliability sequence, an element is a sequence number of a subchannel, $W(Q_i^{N_{max}})$ indicates reliability corresponding to the reliability sequence, and i is an integer greater than or equal to 1 and less than or equal to $N_{max}$.

In a possible implementation, the performing first channel decoding on the first to-be-decoded sequence based on a first reliability sequence includes: performing first channel decoding on the first to-be-decoded sequence based on the first reliability sequence and an internal interleaver sequence, where the internal interleaver sequence is determined based on the extended matrix, and a size of a block of the internal interleaver sequence is equal to a lifting size of the extended matrix.

According to a third aspect, an embodiment of this application provides a communication apparatus, configured to perform the method in any one of the first aspect or the possible implementations of the first aspect. The communication apparatus includes units that perform the method in any one of the first aspect or the possible implementations of the first aspect.

For example, the communication apparatus may be a transmit end, a chip in a transmit end, or the like.

According to a fourth aspect, an embodiment of this application provides a communication apparatus, configured to perform the method in any one of the second aspect or the possible implementations of the second aspect. The communication apparatus includes corresponding methods that perform the method in any one of the second aspect or the possible implementations of the second aspect.

For example, the communication apparatus may be a receive end, a chip in a receive end, or the like.

In the third aspect or the fourth aspect, the communication apparatus may include an input/output unit and a processing unit. For specific descriptions of the input/output unit and the processing unit, refer to apparatus embodiments described below.

According to a fifth aspect, an embodiment of this application provides a communication apparatus. The communication apparatus includes a processor, configured to perform the method in any one of the first aspect or the possible implementations of the first aspect. Alternatively, the processor is configured to execute a program stored in a memory. When the program is executed, the method in any one of the first aspect or the possible implementations of the first aspect is performed.

In a process of performing the foregoing method, a process of sending information, outputting information (for example, the second bit sequence), or obtaining information (for example, obtaining the first bit sequence) in the foregoing method may be understood as a process of outputting the foregoing information by the processor or a process of receiving the foregoing input information by the processor. When outputting the foregoing information, the processor outputs the foregoing information to a transceiver, so that the transceiver transmits the information. After the information is output by the processor, other processing may further need to be performed on the information before the information arrives at the transceiver. Similarly, when the receive end receives the input information, the transceiver receives the information, and inputs the information into the processor. Further, after the transceiver receives the foregoing information, other processing may need to be performed on the information before the information is input into the processor.

Based on the foregoing principle, for example, obtaining the first bit sequence mentioned in the foregoing method may be understood as that the processor receives the input first bit sequence. Outputting the second bit sequence mentioned in the foregoing method may be understood as that the processor outputs the second bit sequence or the like.

Unless otherwise specified, or if operations such as transmitting, sending, and receiving related to the processor do not contradict an actual function or internal logic of the operations in related descriptions, all the operations may be more generally understood as operations such as outputting, receiving, and inputting of the processor, instead of operations such as transmitting, sending, and receiving directly performed by a radio frequency circuit and an antenna.

In an implementation process, the processor may be a processor specially configured to perform these methods, or a processor, for example, a general-purpose processor, that executes computer instructions in the memory to perform these methods. The memory may be a non-transitory (non-transitory) memory, for example, a read-only memory (read-only memory, ROM). The memory and the processor may be integrated on a same chip, or may be separately disposed on different chips. A type of the memory and a manner of disposing the memory and the processor are not limited in embodiments of this application. It may be understood that the descriptions of the processor and the memory are also applicable to the sixth aspect described below. For brevity, the descriptions of the processor and the memory are not described in detail in the sixth aspect.

In a possible implementation, the memory is located outside the communication apparatus.

In a possible implementation, the memory is located inside the communication apparatus.

In this embodiment of this application, the processor and the memory may alternatively be integrated into one device. In other words, the processor and the memory may alternatively be integrated together.

For example, the memory may be configured to store one or more of a second reliability sequence or an extended base matrix.

In a possible implementation, the communication apparatus further includes a transceiver, and the transceiver is configured to receive a signal or send a signal. For example, the transceiver may be further configured to send a sequence obtained based on the second bit sequence, or the like.

In this embodiment of this application, the communication apparatus may be a transmit end, a chip in a transmit end, or the like.

According to a sixth aspect, an embodiment of this application provides a communication apparatus. The communication apparatus includes a processor, configured to perform the method in any one of the second aspect or the possible implementations of the second aspect. Alternatively, the processor is configured to execute a program stored in a memory. When the program is executed, the method in any one of the second aspect or the possible implementations of the second aspect is performed.

In a possible implementation, the memory is located outside the communication apparatus.

In a possible implementation, the memory is located inside the communication apparatus.

In this embodiment of this application, the processor and the memory may alternatively be integrated into one device. In other words, the processor and the memory may alternatively be integrated together.

For example, the memory may be configured to store any one or more of a second reliability sequence or an extended base matrix.

In a possible implementation, the communication apparatus further includes a transceiver, and the transceiver is configured to receive a signal or send a signal. For example, the transceiver may be configured to receive a sequence or the like.

In this embodiment of this application, the communication apparatus may be a receive end, a chip in a receive end, or the like.

According to a seventh aspect, an embodiment of this application provides a communication apparatus. The communication apparatus includes a logic circuit and an interface. The logic circuit is coupled to the interface. The logic circuit is configured to obtain a first bit sequence and a number E of to-be-retransmitted bits. The logic circuit is further configured to perform second channel encoding on the first bit sequence to obtain a second bit sequence, and perform retransmission based on the second bit sequence.

It may be understood that the logic circuit described above is configured to obtain the first bit sequence. It may be further understood that the logic circuit is configured to input to-be-processed data (for example, K information bits) through the interface, and process the to-be-processed data to obtain the first bit sequence.

In a possible implementation, the logic circuit is specifically configured to perform second channel encoding based on the second bit sequence and the extended matrix. The extended matrix includes N rows and E columns, the extended matrix is obtained based on an extended base matrix, the extended base matrix includes $N_0$ rows and $E_0$ columns, and both $E_0$ and $N_0$ are integers greater than or equal to 1.

It may be understood that, for descriptions of the first bit sequence, the second bit sequence, first channel encoding, second channel encoding, the extended matrix, the extended base matrix, a first reliability sequence, a second reliability sequence, and the like, refer to the descriptions in the first aspect, or refer to the following method embodiments. Details are not described herein again.

According to an eighth aspect, an embodiment of this application provides a communication apparatus. The communication apparatus includes a logic circuit and an interface. The logic circuit is coupled to the interface. The logic circuit is configured to: obtain a second to-be-decoded sequence, perform second channel decoding on the second to-be-decoded sequence based on an extended matrix to obtain a first to-be-decoded sequence, and perform first channel decoding on the first to-be-decoded sequence based on a first reliability sequence to obtain K information bits.

It may be understood that the logic circuit described above is configured to obtain the second to-be-decoded sequence. It may be further understood that the interface is configured to input to-be-processed data (for example, a receive sequence obtained through a channel), and the logic circuit is configured to process the to-be-processed data input through the interface, to obtain the second to-be-decoded sequence; or the logic circuit is configured to input the second to-be-decoded sequence or the like through the interface.

It may be understood that, for descriptions of the first to-be-decoded sequence, the second to-be-decoded sequence, first channel encoding, second channel encoding, the extended matrix, an extended base matrix, the first reliability sequence, a second reliability sequence, and the like, refer to the descriptions in the second aspect, or refer to the following method embodiments. Details are not described herein again.

According to a ninth aspect, an embodiment of this application provides a computer-readable storage medium. The computer-readable storage medium is configured to store a computer program, and when the computer program is run on a computer, the method shown in any one of the first aspect or the possible implementations of the first aspect is performed, or the method shown in any one of the second aspect or the possible implementations of the second aspect is performed.

According to a tenth aspect, an embodiment of this application provides a computer program product. The computer program product includes a computer program or computer code, and when the computer program product runs on a computer, the method shown in any one of the first aspect or the possible implementations of the first aspect is performed, or the method shown in any one of the second aspect or the possible implementations of the second aspect is performed.

According to an eleventh aspect, an embodiment of this application provides a computer program. When the computer program is run on a computer, the method shown in any one of the first aspect or the possible implementations of the first aspect is performed, or the method shown in any one of the second aspect or the possible implementations of the second aspect is performed.

According to a twelfth aspect, an embodiment of this application provides a wireless communication system. The wireless communication system includes a transmit end and a receive end. The transmit end is configured to perform the method shown in any one of the first aspect or the possible implementations of the first aspect. The receive end is configured to perform the method shown in any one of the second aspect or the possible implementations of the second aspect.

## BRIEF DESCRIPTION OF DRAWINGS

FIG. 1 is a schematic diagram of an architecture of a communication system according to an embodiment of this application;
FIG. 2 is a schematic diagram of polar code encoding according to an embodiment of this application;
FIG. 3a is a schematic flowchart of a polar code-based CC-HARQ according to an embodiment of this application;
FIG. 3b is a schematic flowchart of a polar code-based IF-HARQ according to an embodiment of this application;
FIG. 3c is a schematic flowchart of a polar code-based IR-HARQ according to an embodiment of this application;
FIG. 4 is a schematic flowchart of a retransmission method according to an embodiment of this application;
FIG. 5a is a schematic diagram of second channel encoding according to an embodiment of this application;
FIG. 5b is a schematic diagram of other second channel encoding according to an embodiment of this application;
FIG. 6a is a schematic diagram of an extended base matrix according to an embodiment of this application;
FIG. 6b is a schematic diagram of an extended base matrix according to an embodiment of this application;
FIG. 6c is a schematic flowchart of a method for generating an extended base matrix according to an embodiment of this application;
FIG. 6d is a schematic flowchart of a method for generating an extended base matrix according to an embodiment of this application;
FIG. 7a is a schematic diagram of decoding performance corresponding to different construction sequences according to an embodiment of this application;
FIG. 7b is a schematic diagram of a reliability difference between bit channels and a block-wise feature according to an embodiment of this application;
FIG. 7c is a schematic diagram of a check relationship between a check node and a variable node according to an embodiment of this application;

FIG. 7d is a schematic diagram of a relationship between an extended matrix and a first reliability sequence according to an embodiment of this application;

FIG. 8a is a schematic diagram of a representation form of an extended matrix according to an embodiment of this application;

FIG. 8b is a schematic diagram of a representation form of an extended matrix according to an embodiment of this application;

FIG. 9a is a schematic diagram of a cyclic buffer according to an embodiment of this application;

FIG. 9b is a schematic diagram of another cyclic buffer according to an embodiment of this application;

FIG. 10 is a schematic flowchart of a retransmission method according to an embodiment of this application;

FIG. 11a is a schematic flowchart of large iterative decoding according to an embodiment of this application;

FIG. 11b is a schematic diagram of a decoding method according to an embodiment of this application;

FIG. 11c is a schematic diagram of a retransmission method according to an embodiment of this application;

FIG. 12a is a schematic diagram of comparison between maximum decoding complexity and average decoding complexity according to an embodiment of this application;

FIG. 12b to FIG. 12e each are a schematic diagram of performance comparison among a HARQ method, a CC-HARQ method, and an IR-HARQ method according to an embodiment of this application;

FIG. 13 is a schematic diagram of an encoding method and a decoding method according to an embodiment of this application; and

FIG. 14 to FIG. 16 each are a schematic diagram of a structure of a communication apparatus according to an embodiment of this application.

## DESCRIPTION OF EMBODIMENTS

To make objectives, technical solutions, and advantages of this application clearer, this application is further described with reference to accompanying drawings.

Terms "first", "second", and the like in the specification, claims, and accompanying drawings of this application are merely used to distinguish between different objects, and are not used to describe a specific order. In addition, terms such as "include" and "have" and any other variants thereof are intended to cover a non-exclusive inclusion. For example, a process, a method, a system, a product, or a device that includes a series of steps or units is not limited to listed steps or units, but optionally further includes another unlisted step or unit, or optionally further includes another inherent step or unit of the process, the method, the system, the product, or the device.

An "embodiment" mentioned in this specification means that a specific feature, structure, or characteristic described with reference to an embodiment may be included in at least one embodiment of this application. The phrase shown at various locations in the specification may not necessarily mean a same embodiment, and is not an independent or alternative embodiment exclusive from another embodiment. It may be explicitly and implicitly understood by a person skilled in the art that embodiments described in the specification may be combined with another embodiment.

In this application, "at least one piece (item)" means one or more, "a plurality of" means two or more, "at least two pieces (items)" means two, three, or more, and "and/or" is used to describe an association relationship between associated objects and indicates that three relationships may exist. For example, "A and/or B" may indicate the following three cases: Only A exists, only B exists, and both A and B exist, where A and B may be singular or plural. The character "/" usually indicates an "or" relationship between the associated objects. "At least one item (piece) of the following" or a similar expression thereof means any combination of these items. For example, at least one item (piece) of a, b, or c may indicate a, b, c, "a and b", "a and c", "b and c", or "a, b, and c".

The method provided in this application may be applied to various communication systems, for example, may be an internet of things (internet of things, IoT) system, a narrow band internet of things (narrow band internet of things, NB-IoT) system, a long term evolution (long term evolution, LTE) system, or may be a 5th generation (5th generation, 5G) communication system (for example, enhanced mobile broadband (enhanced mobile broadband, eMBB), ultra-reliable and low-latency communication (ultra-reliable and low-latency communication, URLLC), and enhanced machine-type communication (enhanced machine-type communication, eMTC) are included), and a new communication system (for example, 6G) emerging in future communication development. In addition, the method provided in this application may be further applied to a wireless local area network (wireless local area network, WLAN) system, for example, wireless fidelity (wireless-fidelity, Wi-Fi).

The technical solutions provided in this application may be further applied to machine-type communication (machine-type communication, MTC), a long term evolution-machine (Long Term Evolution-machine, LTE-M) technology, and a device-to-device (device-to-device, D2D) network, a machine-to-machine (machine-to-machine, M2M) network, an internet of things (Internet of things, IoT) network, or another network. The IoT network may include, for example, an internet of vehicles. Communication manners in an internet of vehicles system are collectively referred to as vehicle-to-X (vehicle-to-X, V2X, where X may represent anything). For example, V2X may include vehicle-to-vehicle (vehicle-to-vehicle, V2V) communication, vehicle-to-infrastructure (vehicle-to-infrastructure, V2I) communication, vehicle-to-pedestrian (vehicle-to-pedestrian, V2P) communication, or vehicle-to-network (vehicle-to-network, V2N) communication.

Terms in this application are described below in detail.

1. Terminal device

The terminal device in this application is an apparatus with a wireless transceiver function. The terminal device may communicate with an access network device (or may be referred to as an access device) in a radio access network (radio access network, RAN).

The terminal device may also be referred to as user equipment (user equipment, UE), an access terminal, a terminal (terminal), a subscriber unit (subscriber unit), a subscriber station, a mobile station, a remote station, a remote terminal, a mobile device, a user terminal, a user agent, a user apparatus, or the like. In a possible implementation, the terminal device may be deployed on land, including an indoor device, an outdoor device, a handheld device, or a vehicle-mounted device, or may be deployed on water (for example, on a ship). In a possible implementation, the terminal device may alternatively be a handheld device, a vehicle-mounted device, a wearable device, a sensor, a terminal in an internet of things, a terminal in an internet of vehicles, an uncrewed aerial vehicle, a terminal device in any form in a 5th generation (5th generation, 5G) network and a future network, or the like that has a wireless communication function. This is not limited in this application.

It may be understood that the terminal device described in this application may not only include a vehicle (for example, a car) in the internet of vehicles, but also may include a vehicle-mounted device, a vehicle-mounted terminal, or the like in the internet of vehicles. A specific form of the terminal device when applied to the internet of vehicles is not limited in this application. It may be understood that the terminal devices described in this application may further communicate with each other by using a technology such as D2D, V2X, or M2M. A method for communication between the terminal devices is not limited in this application.

2. Network device

The network device in this application may be an apparatus that is deployed in a radio access network and that provides a wireless communication service for a terminal device. The network device may also be referred to as an access network device, an access device, a RAN device, or the like.

For example, the network device may be a next-generation nodeB (next-generation nodeB, gNB), a next-generation evolved base station (next-generation evolved nodeB, ng-eNB), a network device in future 6G communication, or the like. The network device may be any device having a wireless transceiver function, and includes but is not limited to the foregoing base station (including a base station deployed on a satellite). The network device may alternatively be an apparatus having a base station function in a sixth generation communication system. Optionally, the network device may be an access node, a wireless relay node, a wireless backhaul node, or the like in a wireless local area network (wireless fidelity, Wi-Fi) system. Optionally, the network device may be a wireless controller in a cloud radio access network (cloud radio access network, CRAN) scenario. Optionally, the network device may be a wearable device, a vehicle-mounted device, or the like. Optionally, the network device may alternatively be a small cell, a transmission reception point (transmission reception point, TRP) (or referred to as a transmission point), or the like. It may be understood that the network device may alternatively be a base station, a satellite, or the like in a future evolved public land mobile network (public land mobile network, PLMN). The network device may alternatively be a device that carries a base station function in a nonterrestrial communication system, D2D, V2X, or M2M. A specific type of the network device is not limited in this application. In systems using different radio access technologies, devices that each have a network device function may have different names.

Optionally, in some deployment of the network device, the network device may include a central unit (central unit, CU), a distributed unit (distributed unit, DU), and the like. In some other deployment of the network device, the CU may be further divided into a CU-control plane (control plane, CP), a CU-user plane (user plane, UP), and the like. In still other deployment of the network device, the network device may alternatively be an open radio access network (open radio access network, ORAN) architecture or the like. A specific deployment manner of the network device is not limited in this application.

Based on the terminal device and the network device described above, an embodiment of this application provides a communication system. FIG. 1 is a schematic diagram of an architecture of a communication system according to an embodiment of this application. As shown in FIG. 1, the communication system may include at least one network device and at least one terminal device, for example, a terminal device 1 to a terminal device 4 shown in FIG. 1.

For example, the terminal device 3 and the terminal device 4 shown in FIG. 1 may directly communicate with each other. For example, direct communication between the terminal devices may be implemented using a D2D technology or the like. For another example, the terminal device 1 to the terminal device 4 may separately communicate with the network device. It may be understood that the terminal device 3 and the terminal device 4 may directly communicate with the network device, or may indirectly communicate with the network device, for example, communicate with the network device by using another terminal device (not shown in FIG. 1). It should be understood that FIG. 1 shows an example of one network device, a plurality of terminal devices, and a communication link between communication devices. Optionally, the communication system may include a plurality of network devices, and a coverage area of each network device may include another number of terminal devices, for example, more or fewer terminal devices. This is not limited in this application.

A network architecture and a service scenario that are described in embodiments of this application are intended to describe the technical solutions in embodiments of this application more clearly, and do not constitute a limitation on the technical solutions provided in embodiments of this application. A person of ordinary skill in the art may know that with evolution of the network architecture and emergence of new service scenarios, the technical solutions provided in embodiments of this application are also applicable to similar technical problems.

3. Quasi-cyclic (quasi cyclic, QC) matrix

The QC matrix may also be referred to as a quasi-cyclic shift, a QC form, a quasi-cyclic shift matrix, or the like. For example, a matrix $\begin{bmatrix} 3 & 0 & 0 \\ 0 & 5 & 0 \\ 1 & 0 & 2 \end{bmatrix}$ is a QC matrix whose lifting size (lifting size) is equal to 5, and a non-zero element in the QC matrix is referred to as a shifting value (shifting value). In this case, when the matrix corresponds to a binary field, a matrix may be obtained in the following manner:

Each element in the QC matrix is converted into an identity matrix I whose size is equal to the lifting size.

For example, if a value of the non-zero element in the foregoing QC matrix is referred to as a shifting value (shifting value), an identity matrix at a location of the non-zero element may be shifted toward the right by z columns.

For example, a matrix, namely, $\begin{bmatrix} 0 & 0 & 0 & 1 & 0 \\ 0 & 0 & 0 & 0 & 1 \\ 1 & 0 & 0 & 0 & 0 \\ 0 & 1 & 0 & 0 & 0 \\ 0 & 0 & 1 & 0 & 0 \end{bmatrix}$, corresponding to a non-zero element 3 in the QC matrix may be obtained by cyclically shifting I toward the right by three columns. For another example, because a non-zero element 5 in the QC matrix is equal to the lifting size, it is equivalent that no cyclic right shift is performed on a column. For another example, a matrix, namely, $\begin{bmatrix} 0 & 1 & 0 & 0 & 0 \\ 0 & 0 & 1 & 0 & 0 \\ 0 & 0 & 0 & 1 & 0 \\ 0 & 0 & 0 & 0 & 1 \\ 1 & 0 & 0 & 0 & 0 \end{bmatrix}$, corresponding to a non-zero element 1 in the QC matrix may be obtained by cyclically shifting I toward the right by one column. For another example, a matrix, namely, $\begin{bmatrix} 0 & 0 & 1 & 0 & 0 \\ 0 & 0 & 0 & 1 & 0 \\ 0 & 0 & 0 & 0 & 1 \\ 1 & 0 & 0 & 0 & 0 \\ 0 & 1 & 0 & 0 & 0 \end{bmatrix}$, corresponding to a non-zero element 2 in the QC matrix may be obtained by cyclically shifting I toward the right by two columns.

Based on a lifting size 5, a binary field matrix corresponding to the QC matrix may be shown as follows:

$$\begin{bmatrix} 0&0&0&1&0&0&0&0&0&0&0&0&0&0&0\\ 0&0&0&0&1&0&0&0&0&0&0&0&0&0&0\\ 1&0&0&0&0&0&0&0&0&0&0&0&0&0&0\\ 0&1&0&0&0&0&0&0&0&0&0&0&0&0&0\\ 0&0&1&0&0&0&0&0&0&0&0&0&0&0&0\\ 0&0&0&0&0&1&0&0&0&0&0&0&0&0&0\\ 0&0&0&0&0&0&1&0&0&0&0&0&0&0&0\\ 0&0&0&0&0&0&0&1&0&0&0&0&0&0&0\\ 0&0&0&0&0&0&0&0&1&0&0&0&0&0&0\\ 0&0&0&0&0&0&0&0&0&1&0&0&0&0&0\\ 0&1&0&0&0&0&0&0&0&0&0&0&1&0&0\\ 0&0&1&0&0&0&0&0&0&0&0&0&0&1&0\\ 0&0&0&1&0&0&0&0&0&0&0&0&0&0&1\\ 0&0&0&0&1&0&0&0&0&0&1&0&0&0&0\\ 1&0&0&0&0&0&0&0&0&0&0&1&0&0&0 \end{bmatrix}$$

That is, the QC matrix with three rows and three columns is converted into a binary field matrix based on the lifting size, and then the binary field matrix with 15 rows and 15 columns may be obtained.

Usually, when the shifting value is equal to the lifting size, it is equivalent to that the identity matrix is not cyclically shifted toward the right. When the shifting value is greater than the lifting size, it is equivalent to that the identity matrix is cyclically shifted toward the right by mod(shifting value, lifting size) columns. It may be understood that the foregoing lifting size 5 is merely an example, and a value of the lifting size is not limited in this application. For example, the lifting size may alternatively be equal to 3, 7, or the like. In addition, another name of the lifting size is not limited in this application.

For example, a row weight of a corresponding row (which may also be referred to as a row) of the matrix shown in this application may be indicated by a number of non-zero elements of the corresponding row (which may also be referred to as the row) of the matrix. For example, if a first row and a second row of the QC matrix each include one non-zero element, row weights of the first row and the second row of the QC matrix may be indicated by 1. For another example, if a third row of the QC matrix includes two non-zero elements, a row weight of the third row of the QC matrix may be indicated by 2. In addition, after the QC matrix is converted into the binary field matrix, a row weight of a corresponding row of the QC matrix is equal to a row weight of a corresponding row of the binary field matrix of the QC matrix. For example, if the row weight of the first row of the QC matrix is 1, it may be obtained, based on the lifting size, that the first row of the QC matrix corresponds to a first row to a fifth row of the binary field matrix of the QC matrix. Therefore, the row weights of the first row to the fifth row of the binary field matrix of the QC matrix are all 1. Similarly, if the row weight of the third row of the QC matrix is 2, row weights of an eleventh row to a fifteenth row in the binary field matrix of the QC matrix are all 2. It may be understood that the row weight of the first row is less than the row weight of the eleventh row. That is, a larger number of non-zero elements in a corresponding row of the matrix indicates a heavier row weight (which may also be referred to as a larger row weight) of the corresponding row of the matrix. Similarly, a smaller number of non-zero elements in a corresponding row of the matrix indicates a lighter row weight (which may also be referred to as a smaller row weight) of the corresponding row of the matrix.

4. Polar (polar) code encoding

A polar code encoding matrix G may be obtained by performing a Kronecker product operation for n times based on a standard polar kernel $F=\begin{bmatrix}1&0\\1&1\end{bmatrix}$. For example, when n=2, a polar code encoding matrix $G=F^{\otimes n}=\begin{bmatrix}1&0&0&0\\1&1&0&0\\1&0&1&0\\1&1&1&1\end{bmatrix}$ whose code length is N=4 may be obtained.

FIG. 2 is a schematic diagram of polar code encoding according to an embodiment of this application. For example, when n=3, a polar code encoding matrix G whose code length is N=8 is shown as follows:

$$\begin{bmatrix}1&0&0&0&0&0&0&0\\1&1&0&0&0&0&0&0\\1&0&1&0&0&0&0&0\\1&1&1&1&0&0&0&0\\1&0&0&0&1&0&0&0\\1&1&0&0&1&1&0&0\\1&0&1&0&1&0&1&0\\1&1&1&1&1&1&1&1\end{bmatrix}$$

As shown in FIG. 2, to-be-encoded bits may be classified into two types: a frozen (frozen) bit (which may also be referred to as a fixed bit) and an information bit (data) based on respective reliability. Generally, a bit with high reliability is set as an information bit (data), and a bit with low reliability is set as a frozen (frozen) bit. A value of the frozen (frozen) bit is usually set to 0, which is known to both a transmit end and a receive end in actual transmission. As shown in FIG. 2, $u_7$, $u_6$, $u_5$, and $u_3$ are four bits with higher reliability, and are set as information bits (data); and $u_4$, $u_2$, $u_1$, and $u_0$ are four bits with lower reliability, and are set as frozen (frozen) bits.

5. Reliability sequence

The reliability sequence is a sequence in which location numbers are sorted in ascending order of reliability. For example, in a reliability sequence A=[$a_1$, $a_2$, ..., $a_N$] whose length is N, a first location $a_1$ is a location number with lowest reliability, and a last location $a_N$ is a location number with highest reliability. Certainly, the sequence may alternatively be sorted in descending order of reliability. Due to a same essence, this application is still described by using the sequence in which the location numbers are sorted in ascending order of reliability as an example. Alternatively, the location number with lowest reliability may start from 0, or the like. This is not limited in this application. For example, if one information bit with a length K and one reliability sequence A=[$a_1$, $a_2$, ..., $a_N$] with a length N are given, K information bits may be placed at most reliable K locations, for example, [$a_{N-K+1}$, ..., $a_N$] (which is merely an example), in A, and frozen bits (for example, 0) may be placed at remaining N-K locations [$a$1, ..., $a_{N-K}$] in A, to obtain an information bearing sequence [$b_1$, $b_2$, ..., $b_N$].

6. Polar code-based CC-HARQ

FIG. 3a is a schematic flowchart of a polar code-based CC-HARQ according to an embodiment of this application. As shown in FIG. 3a, a bit sequence $c_1$, ..., $c_N$ ($c_1$, ..., $c_8$ shown in FIG. 3a) is obtained after polar code encoding is performed. An initially transmitted bit sequence is retransmitted in a back-to-front order based on a retransmission resource, to obtain a to-be-retransmitted bit sequence ($c_8$, ..., $c_1$ shown in FIG. 3a). For example, if a number of to-be-retransmitted bits is 3, $c_N$, $c_{N-1}$, and $c_{N-2}$ are sent; if two more bits need to be retransmitted, $c_{N-3}$ and $c_{N-4}$ are sent; and if a number of to-be-retransmitted resources is N+6, $c_N$, ..., $c_1$ are sent, and then $c_N$, ..., and $c_{N-5}$ are sent.

It can be learned from the above that a gain of the CC-HARQ retransmission scheme is limited. For example, the CC-HARQ has only an energy gain brought by retransmission, but has no coding gain.

7. Polar code-based IF-HARQ

FIG. 3b is a schematic flowchart of a polar code-based IF-HARQ according to an embodiment of this application. As shown in FIG. 3b, for example, it is assumed that a code length N of polar code is 16 and a length of K information bits is 12, for example, $u_1$, $u_2$, ..., $u_{12}$.

For example, in an initial transmission, a transmit end may first encode the 12 information bits to obtain a codeword whose code length is N and bit rate is $\mathrm{R}=\frac{3}{4}$, and send the codeword. If a receive end fails to perform decoding in the initial transmission, the transmit end may place information bits at six most unreliable locations in 12 information bit locations during the initial transmission at the first six most reliable information locations for re-encoding, to obtain a codeword whose code length is N and bit rate is $\frac{R}{2}=\frac{3}{8}$ for retransmission. If the receive end still fails to perform decoding in the retransmission, the transmit end places information bits at two most unreliable locations in six information locations in a first retransmission and information bits at the locations in the initial transmission (namely, 2+2=4 bits in all) at the first four most reliable information locations for re-encoding, to obtain a codeword whose bit rate is $\frac{R}{3}=\frac{1}{4}$, and then a second retransmission is performed. If the receive end still fails to perform decoding in the second retransmission, the transmit end places an information bit at a most unreliable location in the four information locations in the second retransmission and the information bits at the locations in the first retransmission and the initial transmission (namely, 1+1+1=3 bits in all) at the first three most reliable information locations for re-encoding, to obtain a codeword whose code length is N and bit rate is $\frac{R}{4}=\frac{3}{16}$, and then a third retransmission is performed.

A bit rate in the third retransmission is already extremely low. Once decoding succeeds, the three information bits that are successfully decoded may be separately mapped back to the fourth information location in the second retransmission, the first retransmission, and the initial transmission, and are considered as frozen bits. In this way, a bit rate in the second retransmission is reduced from the original $\frac{1}{4}$ to the same bit rate as that in the third retransmission. Therefore, decoding can also succeed in the second retransmission. Then, the four information bits that are successfully decoded in the second retransmission are respectively placed at the fifth and sixth information locations in the first retransmission and the initial transmission, and are considered as frozen bits. In this way, a bit rate in the first retransmission is also reduced to the same bit rate as that in the third retransmission. Therefore, decoding can also succeed. The six information bits that are successfully decoded in the first retransmission are respectively placed at the seventh to the twelfth information locations in the initial transmission, and are considered as frozen bits. In this way, an initial transmission bit rate is also reduced from the original $\frac{3}{4}$ to the same bit rate as that in the third retransmission, and the first three bits in the initially transmitted bits can also be successfully decoded. Therefore, the 12 information bits are successfully decoded.

It can be learned from FIG. 3b that, although the IF-HARQ has a higher coding gain than the CC-HARQ, N-length polar code encoding needs to be performed once in each retransmission, and the IF-HARQ has a backtracking characteristic during decoding. Therefore, a decoding delay and implementation complexity of the IF-HARQ are higher than those of the CC-HARQ.

8. Polar code-based IR-HARQ

For example, a basic principle of the IR-HARQ is to find, by increasing a code length of a codeword, an information location that is more reliable than that in an initial transmission, and place a retransmitted bit at the newly generated more reliable information location, to obtain a coding gain close to long code.

FIG. 3c is a schematic flowchart of a polar code-based IR-HARQ according to an embodiment of this application. As shown in FIG. 3c, for example, parity-check polar (parity-check polar, PC-polar) code whose length is an extended code length is first constructed; then a new information bit location is found in an extended part; in addition, an information bit that needs to be checked in an initially transmitted information bit is duplicated to the newly generated information location; and finally a bit sequence for transmission is obtained through re-encoding. For example, N1 indicates a length of the initially transmitted information bit including a frozen bit, and N2 indicates a length of a retransmitted information bit including a frozen bit. Polar encoding is performed on the N1 initially transmitted information bits to obtain C1 initially transmitted codewords. Then, in a retransmission, polar encoding may be performed based on the N2 retransmitted information bits, to obtain C2' intermediate bits, and then C2 retransmitted codewords are obtained based on the C2' intermediate bits and the C1 initially transmitted codewords.

It can be learned from FIG. 3c that, in the IR-HARQ retransmission method, the coding gain close to the long code can be obtained by increasing the code length. However, information bits of the extended part may come from a previous transmission. In addition, an original information bit and a duplicated bit are read and duplicated in an irregular order, resulting in inflexible implementation.

In view of this, this application provides a retransmission method and an apparatus, so that a long code gain can be obtained, and implementation is more flexible.

Optionally, the method provided in this application may be applied to the terminal device or the network device described above. For example, the terminal device may serve as a transmit end, for example, encode K information bits, and then send, to the network device, encoded bits (which may also be briefly referred to as initially transmitted K information bits) obtained based on the K information bits. For another example, the terminal device processes the K information bits, and retransmits K information bits (which may also be briefly referred to as K to-be-retransmitted information bits) obtained through processing. The network device, as a receive end, decodes an encoded sequence received from the terminal device, to obtain K information bits. For example, the network device may decode an initially transmitted sequence, decode a retransmitted sequence, and the like. For another example, the network device may serve as a transmit end, and the terminal device may serve as a receive end. This is not limited in this application. Optionally, the method provided in this application may be further applied to an application-specific integrated circuit (application-specific integrated circuit, ASIC) (which may also be referred to as an application-specific integrated chip or the like), a field-programmable gate array (field-programmable gate array, FPGA), a programmable chip, or the like. Optionally, the method provided in this application may alternatively be implemented by using software (for example, by using program code stored in a memory). This is not limited in this application.

The following describes in detail the retransmission method shown in this application.

FIG. 4 is a schematic flowchart of a retransmission method according to an embodiment of this application. As shown in FIG. 4, the method includes the following steps.

401: A transmit end obtains a first bit sequence and a number E of to-be-retransmitted bits, where the first bit sequence is obtained by performing first channel encoding based on K information bits, a length of the first bit sequence is N, and N, E, and K are all integers greater than or equal to 1.

The first bit sequence may be understood as a bit sequence obtained after the transmit end performs first channel encoding when performing an initial transmission based on the K information bits. That is, the first bit sequence includes N bits, or may be referred to as N initially transmitted bits. For ease of differentiation, the following uses the N initially transmitted bits as an example to describe the method provided in this embodiment of this application. In a possible implementation, the K information bits may include a cyclic redundancy check (cyclic redundancy check, CRC) bit and/or a parity check (parity check, PC) bit. For example, for uplink transmission, K may be greater than or equal to 18 bits, and the CRC bit may include 6 bits, 11 bits, or the like. For another example, for downlink transmission, K may be greater than or equal to 36 bits, and the CRC bit may include 16 bits, 24 bits, or the like. In another possible implementation, the K information bits may alternatively not include a CRC bit, or may not include a PC bit or the like. In an example, when the K information bits do not include the CRC bit, the transmit end may add the CRC bit based on the obtained K information bits, or the transmit end may add the CRC bit to the N initially transmitted bits after obtaining the first bit sequence. In another example, when the K information bits do not include the PC bit, the transmit end may add the PC bit based on the obtained K information bits, or the transmit end may add the PC bit to the N initially transmitted bits after obtaining the first bit sequence. In still another example, when the K information bits include neither the CRC bit nor the PC bit, the transmit end may add the CRC bit and the PC bit based on the obtained K information bits, or the transmit end may add the CRC bit and the PC bit to the N initially transmitted bits after obtaining the first bit sequence. A location at which the transmit end adds the CRC bit or the PC bit is not limited in embodiments of this application. It may be understood that the CRC bit and the PC bit shown above each are a check method, and another check method is not limited in embodiments of this application.

N may be a mother code length, or may be a code length obtained through rate matching. For example, if N is a mother code length, the transmit end may perform polar code encoding on the K information bits, for example, $U = u_1, u_2, \ldots, u_K$, to obtain the first bit sequence. For example, the first bit sequence is $C = c_1, c_2, \ldots, c_N$. For another example, if the mother code length is greater than N, the transmit end may obtain bits whose length is N through rate matching. To be specific, when the mother code length is greater than N, the transmit end may adapt to a length of an available resource by using a rate matching method, to obtain the first bit sequence. The rate matching method may include repetition (repetition), puncturing (puncture), shortening (shorten), and the like. This is not limited in embodiments of this application.

Generally, $\mathrm{K} = \lceil N \times R_0 \rceil$, $R_0$ is an initial transmission bit rate, and the initial transmission bit rate is a positive integer that is less than or equal to a maximum initial transmission bit rate $R_h$ and that is greater than 0. For example, a specific value of the maximum initial transmission bit rate may be set by a network device, or may be defined by a standard or a protocol. This is not limited in embodiments of this application. It may be understood that the initial transmission bit rate shown in this embodiment of this application may be indicated by a parameter $R_0$, or may be indicated by R.

Optionally, the transmit end may obtain the number E of to-be-retransmitted bits based on a retransmission bit rate, for example, $R_1$. For example, $R_1$=K/(N+E). The retransmission bit rate is less than the initial transmission bit rate. For example, the retransmission bit rate $R_1$ may be equal to a half of the initial transmission bit rate. For example, $\mathrm{R}_1 = \frac{1}{2} \times \mathrm{R}_0$, and for another example, $\mathrm{R}_1 = \frac{1}{3} \times \mathrm{R}_0$. A relationship between the initial transmission bit rate and the retransmission bit rate is not limited in embodiments of this application. For example, the retransmission bit rate may be predefined by a standard or a protocol, may be fed back by a receive end (for example, the receive end indicates the retransmission bit rate based on feedback information), or may be set by the network device. A method for setting the retransmission bit rate is not limited in embodiments of this application. It may be understood that the retransmission bit rate $R_1$ shown above is merely an example. For example, when $R_1$ is defined as a bit rate in a first retransmission, Ri=K/(N+ei), (ei indicates a number of bits in the first retransmission), and the transmit end may further obtain a number $e_2$ of bits in a second retransmission based on a bit rate $R_2$ in the second retransmission. Details are not described herein again.

Optionally, the transmit end may obtain the number E of to-be-retransmitted bits based on the feedback information of the receive end. For example, the feedback information is used to feed back whether the receive end correctly decodes the initially transmitted bit or the last retransmitted bit. For example, the feedback information may indicate information about E. For example, the feedback information may indicate the number $e_1$ of bits in the first retransmission, or indicate the number $e_2$ of bits in the second retransmission. It may be understood that, for a specific description of this manner, refer to FIG. 9a. Details are not described herein again.

Optionally, the transmit end determines the number E of to-be-retransmitted bits. For example, the receive end may not feed back the number E of to-be-retransmitted bits. For example, the transmit end may ratelessly send a to-be-retransmitted bit, and stop retransmission until the transmit end receives an acknowledgment (acknowledgment, ACK) fed back by the receive end. That is, this implementation may be understood as that a number of bits to be retransmitted each time is not fixed, and may be independently determined by the transmit end (which may also be referred to as ratelessly sending the to-be-retransmitted bit). It may be understood that, for a specific description of this manner, refer to FIG. 9b. Details are not described herein again.

First channel encoding includes any one or more of polar code encoding, Bose-Chaudhuri-Hocquenghem (Bose-Chaudhuri-Hocquenghem, BCH) code encoding, Reed-Solomon (Reed-Solomon, RS) code encoding, low-density parity-check (low-density parity-check, LDPC) encoding, convolutional encoding, or the like. Probability encoding (for example, LDPC encoding) or algebraic encoding (for example, BCH encoding) may be used as first channel encoding. This is not limited in embodiments of this application.

It may be understood that the method provided in this embodiment of this application may be applied to not only a bit sequence whose length is N in the initial transmission, but also a data packet layer, for example, a data packet whose length is N. For example, the transmit end may obtain an N-length data packet obtained by performing first channel encoding based on K data packets. Then, the K data packets are retransmitted in step 402 and step 403 shown below.

402: The transmit end performs second channel encoding based on the first bit sequence to obtain a second bit sequence, where the second bit sequence includes the E to-be-retransmitted bits.

The second channel encoding may also be referred to as redundant encoding, redundant extended encoding, redundant channel encoding, or the like. A name of second channel encoding is not limited in embodiments of this application. Each to-be-retransmitted bit may be obtained based on one or more initially transmitted bits, and the one or more initially transmitted bits are included in the first bit sequence.

In a possible implementation, performing second channel encoding based on the first bit sequence includes: performing second channel encoding based on the first bit sequence and a first polynomial, to obtain the second bit sequence. For example, the first polynomial may indicate a relationship between the E to-be-retransmitted bits and the N initially transmitted bits. The transmit end may obtain the E to-be-retransmitted bits based on the N initially transmitted bits and the first polynomial. For example, each to-be-retransmitted bit may be a linear combination of one or more initially transmitted bits in the N initially transmitted bits, in other words, the first polynomial may include a linear polynomial. For example, a linear combination of each to-be-retransmitted bit and one or more of the N initially transmitted bits may alternatively be obtained based on an extended matrix shown below.

In another possible implementation, performing second channel encoding based on the first bit sequence includes: performing second channel encoding based on the first bit sequence and an extended matrix, where the extended matrix includes E rows and N columns, the extended matrix is obtained based on an extended base matrix, the extended base matrix includes $E_0$ rows and $N_0$ columns, and both $E_0$ and $N_0$ are integers greater than or equal to 1.

In other words, the transmit end may perform second channel encoding on the first bit sequence based on the extended matrix to obtain the second bit sequence. The extended matrix is obtained based on the extended base matrix. The extended base matrix may adapt to one or more of different N, different E, or different initial transmission bit rates, to obtain the extended matrix that matches N, E, and the initial transmission bit rate. The extended base matrix may also be referred to as a base matrix (base matrix), a base graph (base graph), a protograph (protograph), or the like. The extended matrix may also be referred to as a check matrix, a redundant extended matrix, a redundant encoding matrix, or the like. Names of the extended base matrix and the extended matrix are not limited in embodiments of this application. It may be understood that the extended matrix and the extended base matrix each have a QC structure. For a specific description of the extended base matrix, refer to related descriptions of FIG. 6a to FIG. 6d. Details are not described herein again.

For example, FIG. 5a is a schematic diagram of second channel encoding according to this embodiment of this application. For example, $H_{EN}$ shown in FIG. 5a is a representation form of the extended matrix, or $G_{check}$=[$H_{EN}$, $E_{EE}$] shown in FIG. 5a may be a representation form of the extended matrix. $H_{EN}$ corresponds to the initially transmitted bit, and may be understood as a matrix indicating a check relationship. $E_{EE}$ corresponds to the to-be-retransmitted bit, and is an identity matrix. That is, each row of the $G_{check}$ matrix corresponds to one check equation that needs to be met by one to-be-retransmitted bit. For example, a first row of $G_{check}$ corresponds to a first to-be-retransmitted bit $c_{N+1}$, for example, meets a check equation $c_2+c_{N+1}=0$; and a second row of $G_{check}$ corresponds to a second to-be-retransmitted bit $c_{N+2}$, for example, meets a check equation $c_3+c_N+c_{N+2}=0$. It may be understood that the check equations shown herein are merely examples, and are not listed one by one in this embodiment of this application. $Z_{NE}$ shown in FIG. 5a may be understood as an all-zero matrix with N rows and E columns. It may be understood that $I_{NN}$ shown in FIG. 5a may be understood as an initial transmission identity matrix with N rows and N columns, and $E_{EE}$ may be understood as a retransmission identity matrix with E rows and E columns.

As shown in FIG. 5a, polar code encoding is performed on the K information bits, for example, $u_1$, $u_2$, ..., $u_K$, to obtain the first bit sequence, for example, $c_1$, $c_2$, ..., $c_N$. For example, after the first bit sequence is processed based on the identity matrix with N rows and N columns, N initially transmitted bits (that is, the first bit sequence in the initial transmission) may be sequentially output. For example, E to-be-retransmitted bits may be obtained by processing the N initially transmitted bits based on the extended matrix $H_{EN}$, and the E to-be-retransmitted bits may be sequentially output after being processed based on the identity matrix $E_{EE}$. It may be understood that forms of the identity matrix and the extended matrix shown in FIG. 5a are merely examples. This is not limited in embodiments of this application.

It may be understood that the foregoing matrix operation may be performed in a binary field or may be performed in a non-binary field. For example, the extended matrix may alternatively be in a form of a non-binary field. When the extended matrix shown in FIG. 5a is a non-binary field matrix, each black square in the matrix $H_{EN}$ may be a matrix that is cyclically shifted toward the right based on a shifting value and whose dimension is Z*Z. It may be understood that, when the extended matrix shown in FIG. 5a, for example, $H_{EN}$, is a non-binary field matrix, a number of rows and a number of columns of the extended matrix $H_{EN}$ shown in FIG. 5a may not be respectively E and N, but are respectively a number of rows and a number of columns that are obtained when the binary field matrix with E rows and N columns is converted into the non-binary field matrix. In other words, second channel encoding shown in FIG. 5a is merely an example, and should not be construed as a limitation on embodiments of this application.

For ease of description, the following describes the method provided in this application by using an example in which the extended matrix $H_{EN}$ is a binary field matrix.

For example, FIG. 5b is a schematic diagram of other second channel encoding according to this embodiment of this application. FIG. 5b is a schematic diagram of second channel encoding used when the method provided in this embodiment of this application is applied to the data packet layer. As shown in FIG. 5b, $A_{NN}$ may be understood as an initial transmission identity matrix with N rows and N columns, $D_{EE}$ may be understood as a retransmission identity matrix with E rows and E columns, $C_{EN}$ may be understood as an extended matrix with E rows and N columns, or $G_{check}$=[$C_{EN}$, $D_{EE]}$ may be considered as another representation form of the extended matrix. For example, N initially transmitted data packets, such as $P_1$, $P_2$, ..., and $P_N$ may be sequentially output after being processed based on the identity matrix with N rows and N columns. For example, E to-be-retransmitted data packets may be obtained by processing the N initially transmitted data packets based on the extended matrix $C_{EN}$, and the E to-be-retransmitted data packets may be sequentially output after being processed based on the identity matrix $E_{EE}$. It may be understood that, for a specific description of FIG. 5b, refer to the description of FIG. 5a. Details are not described herein again.

It may be understood that, that the foregoing to-be-retransmitted bit may be obtained based on a linear combination of one or more initially transmitted bits is merely an example. For example, a manner of the linear combination includes: The to-be-retransmitted bit may be generated based on an LT-LDPC check matrix, or the to-be-retransmitted bit may be generated based on an LT-LDPC generator matrix. It may be understood that forms shown in FIG. 5a and FIG. 5b are merely examples, and the forms are not limited in embodiments of this application. For example, provided that an expression manner can generate a linear combination of initially transmitted bits, all the forms fall within the protection scope of this application.

403: The transmit end performs retransmission based on the second bit sequence.

Optionally, after obtaining the second bit sequence, the transmit end may further perform modulation and the like. A modulation scheme or the like of the transmit end for the second bit sequence is not limited in embodiments of this application.

In this embodiment of this application, second channel encoding is performed on a bit sequence for an initial transmission, for example, the first bit sequence, to obtain to-be-retransmitted bits corresponding to the number of to-be-retransmitted bits, for example, the E to-be-retransmitted bits. That is, the method provided in this embodiment of this application not only can directly perform encoding for retransmission based on the bit sequence for the initial transmission, but also can flexibly extend a code length (for example, flexibly extend the code length based on the number of to-be-retransmitted bits).

The following describes in detail the extended base matrix and the extended matrix shown in this embodiment of this application.

When performing second channel encoding, the transmit end needs to determine a size of the extended matrix $H_{EN}$ (which may also be briefly referred to as H) or $G_{Check}$=[$H_{EN}$, $E_{EE}$]. For example, the transmit end may determine the size of $H_{EN}$ based on the length N of the first bit sequence and the number E of to-be-retransmitted bits. It may be understood that, because $E_{EE}$ is the identity matrix with E rows and E columns, the extended matrix or the extended base matrix provided in this embodiment of this application is described below by using an example in which the extended matrix is $H_{EN}$. However, the extended matrix shown in this embodiment of this application may alternatively be $G_{check}$=[$H_{EN}$, $E_{EE}$]. Therefore, the following description of $H_{EN}$ is also applicable to $G_{check}$. The extended matrix shown in this embodiment of this application may have a nesting property, for example, may flexibly adapt to different N, E, and initial transmission bit rates, as shown below.

1. Adaptation to different initial transmission code lengths N

It needs to be ensured that a number of columns of the extended matrix $H_{EN}$ can be flexibly scaled, to adapt to different initial transmission code lengths N (namely, the length N of the first bit sequence). In other words, a lifting size Z and/or a rate matching method can be changed to adapt to different N.

In an example, different N may be adapted based on the number of columns $N_0$ of the extended base matrix and the lifting size Z. For example, if $N_0$=16, and the length of the first bit sequence obtained when the transmit end performs first channel encoding is 1024, Z=N/$N_0$=64. In other words, the extended base matrix may be converted into a binary field matrix based on the lifting size Z=64, to obtain an extended matrix. For another example, if $N_0$=16, and the length of the first bit sequence obtained when the transmit end performs first channel encoding is 512, Z=N/$N_0$=32. In other words, the extended base matrix may be converted into a binary field matrix based on the lifting size Z=32, to obtain an extended matrix. It may be understood that the number of columns $N_0$=16 of the extended base matrix shown in this embodiment of this application is merely an example. For example, the number of columns $N_0$=32, $N_0$=64, or the like of the extended base matrix is not limited in embodiments of this application. For example, if $N_0$=64, and the length of the first bit sequence obtained when the transmit end performs first channel encoding is 1024, Z=N/$N_0$=16. In other words, the extended base matrix may be converted into a binary field matrix based on the lifting size Z=16, to obtain an extended matrix. It may be understood that, in this embodiment of this application, Z=$2^n$, and n is an integer greater than or equal to 0 (that is, n may be a natural number). For example, n=0, 1, 2, 3, 4, 5, 6, or the like.

In another example, different initial transmission code lengths N may be adapted based on the number of columns $N_0$ of the extended base matrix, the lifting size Z, and the rate matching method. For example, if $N_0$=16, and the length of the first bit sequence obtained when the transmit end performs first channel encoding is 1000, Z may be determined based on [N/$N_0$] (that is, N/$N_0$ is rounded up) and Z=$2^n$, for example, Z=64. In other words, the extended base matrix may be converted into a binary field matrix (namely, a matrix including 1024 columns) based on the lifting size Z=64, and then an extended matrix with 1000 columns is obtained through puncturing (puncture) or shortening (shorten). For example, $N_0$=64, and the length of the first bit sequence obtained when the transmit end performs first channel encoding is 2000, Z=32 may be determined based on [N/$N_0$]=32 because 32 is a power of 2. In other words, the extended base matrix is converted into a binary field matrix (namely, a matrix including 2048 rows) based on Z=32, and then an extended matrix with 2000 columns is obtained through puncturing (puncture) or shortening (shorten).

It may be understood that the foregoing is described by using an example in which different N is adapted based on $N_0$ and Z. However, in this embodiment of this application, N may be further determined based on $N_0$ and Z. In other words, Z may also be a fixed value. Then the transmit end may determine, based on Z, a length N of a to-be-initially-transmitted bit to be transmitted by the transmit end. For example, the transmit end may determine the length N of the to-be-initially-transmitted bit when an initial transmission is not performed. For another example, the transmit end may determine, based on Z, a length N of a bit in a next initial transmission. For example, the transmit end may determine N based on $N_0$ and Z, then perform first channel encoding on the K information bits to obtain the first bit sequence, to initially transmit the K information bits, and then perform second channel encoding based on the first bit sequence and the extended matrix to obtain E to-be-retransmitted bits and the like.

For example, N=$N_0$*Z. For example, if $N_0$=16 and Z=64, N=1024, to be specific, the length of the first bit sequence obtained by the transmit end is 1024. For another example, if $N_0$=16 and Z=32, N=512, to be specific, the length of the first bit sequence obtained by the transmit end is 521. In this embodiment of this application, Z=$2^n$, and n is an integer greater than or equal to 0. For example, n=0, 1, 2, 3, 4, 5, 6, or the like.

2. Adaptation to different initial transmission bit rates R

The extended matrix $H_{EN}$ further has flexibility of adapting to different initial transmission bit rates. For example, the extended matrix $H_{EN}$ may meet a submatrix nesting property. The submatrix nesting property may be understood as that an extended matrix with a low initial transmission bit rate is a submatrix of an extended matrix with a high initial transmission bit rate. In other words, the extended matrix shown in this embodiment of this application may be compatible with different initial transmission bit rates.

3. Adaptation to different numbers E of to-be-retransmitted bits

The initial transmission code length N and the initial transmission bit rate R are given, and the extended matrix has flexibility of adapting to different numbers E of to-be-retransmitted bits, that is, the $H_{EN}$ needs to meet a row nesting property. For example, the row nesting property may be understood as that, if a number of bits in a first retransmission is ei, and a number of bits in a second retransmission is $e_2$, an extended matrix $H_{e1,\ N}$ corresponding to retransmitted $e_1$ bits is a submatrix of an extended matrix $H_{e1+e2,\ N}$ corresponding to retransmitted $e_1+e_2$ bits. That is, it is required that a submatrix $H_{e1,\ N}$ obtained by extracting the first $e_1$ rows of the extended matrix $H_{e1+e2,\ N}$ whose number of to-be-retransmitted bits is $e_{1+}e_2$ can also obtain good performance when the number E of to-be-retransmitted bits=$e_1$. In other words, the extended matrix shown in this embodiment of this application may be compatible with different E.

In an example, E rows of the extended matrix are the first E rows of a first matrix, and the first matrix is a matrix obtained by extending the extended base matrix based on a lifting size. For example, when a bit rate (namely, a bit rate R of first channel encoding) obtained based on K/N is equal to a maximum initial transmission bit rate $R_h$, the E rows of the extended matrix are the first E rows of the first matrix. For example, the extended base matrix is extended based on the lifting size, to obtain the first matrix, and then the first E rows of the first matrix are determined as the E rows of the extended matrix based on the number E of to-be-retransmitted bits. It may be understood that, for a description of the lifting size, refer to the foregoing description of adaptation to different initial transmission code lengths N. Details are not described herein again.

In another example, E rows of the extended matrix are E adjacent rows of the first matrix, the E adjacent rows of the first matrix are determined based on a bit rate of first channel encoding (which may also be referred to as being related to the bit rate R of first channel encoding, or may be referred to as being related to the initial transmission bit rate R), and the first matrix is a matrix obtained by extending the extended base matrix based on a lifting size. For example, when a bit rate obtained based on K/N is less than a maximum initial transmission bit rate, the E rows of the extended matrix may be E adjacent rows of the first matrix. That is, it may be determined, based on an operation result between the bit rate obtained based on K/N and the maximum initial transmission bit rate, that the E rows of the extended matrix are E adjacent rows of the first matrix. In this case, the E rows of the extended matrix are not the first E rows of the first matrix. For example, a first row of the extended matrix is obtained based on an operation result j between the bit rate obtained based on K/N and the maximum initial transmission bit rate. j is related to the initial transmission bit rate R, the maximum initial transmission bit rate $R_h$, and N. For example, j may meet any one of the following relationships:

$$j=\left\lceil\frac{N\times(R_h-R)}{R}+\Delta\right\rceil$$

$$j=\left\lceil\frac{N\times(R_h-R)}{R}\right\rceil+\Delta$$

$$j=\left\lfloor\frac{N\times(R_h-R)}{R}+\Delta\right\rfloor$$

$$j=\left\lfloor\frac{N\times(R_h-R)}{R}\right\rfloor+\Delta$$

R indicates the initial transmission bit rate, $R_h$ indicates the maximum initial transmission bit rate, and N indicates the length of the first bit sequence (which may also be referred to as an initial transmission code length). Δ indicates an offset value, and may be a real number (for example, a positive integer, 0, or a negative integer). ⌈⌉ indicates rounding up, and ⌊⌋ indicates rounding down. For example, Δ may be equal to 0. Alternatively, Δ may be equal to - 1, -2, -3, -4, -5, or the like. Examples are not provided herein one by one. Alternatively, Δ may be equal to 1, 2, 3, 4, 5, or the like. Examples are not provided herein one by one.

For example, if R=0.5, $R_h$=0.75, and N=1024, j=1024*0.25/0.5=512 is determined based on the foregoing relationship. If the number E of to-be-retransmitted bits is equal to 200, 512 rows of the first matrix may be extracted downwards to obtain a first row of the extended matrix. For example, when Δ= 0, 200 rows may be extracted from a

513th row of the first matrix to obtain an extended matrix, where the first row of the extended matrix is the 513th row of the first matrix, and a 200th row of the extended matrix is a 712th row of the first matrix.

The extended base matrix shown in this embodiment of this application can flexibly adapt to different Es. In other words, performance of second channel encoding can be ensured when different values of E are used. For example, a submatrix $H_{sub}$ obtained by extracting the first 180 rows of an extended matrix with E=200 can also obtain good performance when E=180.

In this embodiment of this application, a row weight of a row of the extended matrix meets any one or more of the following relationships: The row weight is negatively correlated with E, the row weight is positively correlated with K, the row weight is negatively correlated with N, and the row weight is positively correlated with K/N (that is, the bit rate of first channel encoding). For example, a larger bit rate of first channel encoding indicates a heavier row weight of the row. For example, a row weight of the first row of the extended matrix may meet the foregoing relationship. For another example, a row weight of each of at least two rows of the extended matrix meets the foregoing relationship. For another example, a row weight of each row of the extended matrix meets the foregoing relationship. For ease of description, the following uses the row weight of each row as an example to describe a relationship between the row weight and the foregoing parameters.

For example, a smaller value of E indicates a heavier row weight (namely, a larger row weight), a larger value of K indicates a heavier row weight, a smaller value of N indicates a heavier row weight, or a larger value of K/N indicates a heavier row weight. Similarly, a larger value of E indicates a lighter row weight (namely, a smaller row weight), a smaller value of K indicates a lighter row weight, a larger value of N indicates a lighter row weight, or a smaller value of K/N indicates a lighter row weight.

In this embodiment of this application, the row weight of the extended matrix may be a function of N, K, and E. For example, when a value of K/N is fixed, a smaller value of E indicates a heavier row weight. Similarly, when a value of K/N is fixed, a larger value of E indicates a lighter row weight. For example, when a value of E is fixed, a larger value of K/N indicates a heavier row weight. Similarly, when a value of E is fixed, a smaller value of K/N indicates a lighter row weight. For example, a larger value of K/N and a smaller value of E indicate a heavier row weight. Similarly, a smaller value of K/N and a larger value of E indicate a lighter row weight. It may be understood that the foregoing description of the extended matrix is also applicable to the extended base matrix. In addition, the description of the extended base matrix is also applicable to the extended matrix.

With reference to the foregoing extended matrix, an embodiment of this application provides an example of an extended base matrix. FIG. 6a is a schematic diagram of an extended base matrix according to this embodiment of this application. It may be understood that FIG. 6a is shown in a QC form, but should not be understood as a limitation on embodiments of this application. For example, FIG. 6a shows an extended base matrix shown when E=1024, Z=16, N=1024, and R=0.75. It may be understood that the extended base matrix is shown by using 64 rows and 64 columns as an example. For example, as shown in FIG. 6b, the extended base matrix (for example, $G_{check}$ shown above) shown in this embodiment of this application is indicated by a matrix including the matrix shown in FIG. 6a and an identity matrix with 1024 rows and 1024 columns (when the identity matrix is converted into a QC form, the identity matrix may be represented as a matrix with 64 rows and 64 columns, and an element in the matrix is 16, as shown in FIG. 6b). For example, in this embodiment of this application, one reason for indicating the extended base matrix by $G_{check}$ is that the receive end needs to convert the extended matrix into a Tanner graph in decoding, and the Tanner graph can be better drawn by including the identity matrix $E_{EE}$, to assist in decoding according to a belief propagation (belief propagation, BP) algorithm. Certainly, if the extended matrix is indicated by $H_{EN}$, the receive end may also autonomously add the identity matrix $E_{EE}$ in decoding.

With reference to the foregoing description of the extended matrix, the $H_{EN}$ needs to have flexibility of adapting to different initial transmission code lengths and different initial transmission bit rates, and also needs to meet flexibility of retransmission under different numbers of retransmitted bits. This embodiment of this application further provides a method for generating an extended base matrix. For example, the nesting property of the extended base matrix shown in this embodiment of this application may be realized based on a QC matrix according to a tree search algorithm. It may be understood that the method for generating the extended base matrix shown in this embodiment of this application may be implemented by the transmit end, the receive end, or the like. This is not limited in embodiments of this application. For example, if the extended base matrix is implemented by the transmit end, the transmit end may send information about the extended base matrix to the receive end. For another example, if the extended base matrix is implemented by the receive end, the receive end may send information about the extended base matrix to the transmit end. It may be understood that the extended base matrix shown in this embodiment of this application may alternatively be predefined by a protocol, a standard, or the like. This is not limited in embodiments of this application.

FIG 6c and FIG. 6d each are a schematic flowchart of a method for generating an extended base matrix according to this embodiment of this application. In FIG. 6c and FIG. 6d, L indicates a search width. For example, the search width may be understood as a number of initialized random matrices or the like. $D_{max}$ and $D_{min}$ respectively indicate a maximum row weight and a minimum row weight of the extended base matrix; $E_0$ indicates a maximum number of rows of the extended base matrix; maxIter indicates a maximum number of iterations that are used for protograph-based extrinsic information transfer (protograph-based extrinsic information transfer, PEXIT) when performance of the extended base matrix is calculated; Z indicates a lifting size (lifting size) of a QC matrix corresponding to the extended base matrix; $N_0$ indicates a maximum number of columns of the extended base matrix; R indicates the initial transmission bit rate; and *e* indicates a number of rows of a currently generated extended base matrix. FIG 6c and FIG. 6d each show a progressive tree search process. Optionally, in the tree search process shown in each of FIG. 6c and FIG. 6d, the lifting size Z in each of FIG. 6c and FIG. 6d may also be a prime number, to reduce search complexity.

For example, as shown' in FIG. 6c, the method for generating the extended base matrix includes: L QC matrices are generated based on input parameters L, $D_{max}$, $D_{min}$, $E_0$, maxIter, Z, $N_0$, and R, where the L QC matrices may be understood as a first row of an initialized extended base matrix. When a number of rows e of the current matrix is less than $E_0$, L QC matrices with one row and $N_0$ columns may be randomly generated based on the L QC matrices, the maximum row weight, the minimum row weight, and the lifting size. For example, another matrix is randomly generated based on each of the L QC matrices, that is, L*L QC matrices are obtained. Then SC decoding performance of the L*L QC matrices (which is merely an example) is obtained, and the first L QC matrices with best performance are reserved. The cycle is performed. When the number of rows e of the current matrix is equal to $E_0$, an extended base matrix with $N_0$ rows and $E_0$ columns with best performance is output.

For example, as shown in FIG. 6d, the method for generating the extended base matrix includes the following steps.

601: Initialize the extended base matrix to an empty set.

602: Randomly generate L QC matrices with one row and $N_0$ columns that have no 4-cycle.

For example, the L QC matrices that have no 4-cycle may be randomly generated based on the shifting value (shifting value). For example, if the shifting value is a positive integer less than or equal to 16, that is, shifting value=1 to 16, it indicates that a value range of a non-zero element in the generated L QC matrices with one row and $N_0$ columns is greater than or equal to 1 and less than or equal to 16. For example, the L QC matrices that have no 4-cycle may be randomly generated based on the row weight. For example, if a range of the row weight is 1 to 9, it indicates that a range of a row weight of the randomly generated L QC matrices with one row and $N_0$ columns is greater than or equal to 1 and less than or equal to 9.

For example, whether the generated QC matrix has no 4-cycle may be determined based on the lifting size (lifting size) and the shifting value. For a specific description of no 4-cycle, details are not described in this embodiment of this application.

For example, after the L QC matrices with one row and $N_0$ columns that have no 4-cycle are randomly generated, the L QC matrices may be further sorted based on performance (for example, based on SC decoding performance). As shown in FIG. 6d, the QC matrices obtained through sorting from good performance to poor performance are $H_{1N_0}^1, H_{1N_0}^2, H_{1N_0}^3, \ldots$, and $H_{1N_0}^L$ in sequence (in the method shown in FIG. 6d, all the QC matrices being sorted based on performance is used as an example). It may be understood that a form (a form in the accompanying drawing description) of a matrix with best performance in the L QC matrices shown in FIG. 6d is different from $H_{1N_0}^1$, and should not be construed as a limitation on embodiments of this application.

603: Randomly generate an additional row based on each QC matrix $H_{1N_0}^i, i = 1,2, \ldots, L$ with one row and $N_0$ columns to obtain $L^2$ QC matrices $H_{2N_0}^i$ with two rows and $N_0$ columns.

604: Calculate performance of (N, K)-polar code in the $L^2$ QC matrices $H_{2N_0}^i$, with two rows and $N_0$ columns, and obtain L QC matrices with two rows and $N_0$ columns and with best performance through sorting based on the performance as the first two rows of the extended base matrix.

605: Randomly generate a third row of the extended base matrix based on the L QC matrices with two rows and $N_0$ columns and with best performance, to obtain $L^2$ QC matrices $H_{3N_0}^i$ with three rows and $N_0$ columns.

606: Obtain L QC matrices $H_{E_0N_0}^1$ to $H_{E_0N_0}^L$ with $E_0$ rows and $N_0$ columns in a progressive manner by analogy (according to the method shown in step 603 and step 604).

607: Select $H^1_{E_0N_0}$ as the finally output extended base matrix.

It may be understood that the reason of using $H^1_{E_0N_0}$ as the extended base matrix is that, when the L QC matrices with $E_0$ rows and $N_0$ columns are obtained, the L QC matrices are sorted based on the performance. That is, $H^1_{E_0N_0}$ is a QC matrix with best performance. Certainly, alternatively, sorting may not be performed, and a QC matrix with best performance is directly output as the extended base matrix. This is not limited in embodiments of this application.

It may be understood that the foregoing method for generating the extended base matrix is also applicable to an extended matrix. Details are not described herein again.

With reference to the methods shown in FIG. 6c and FIG. 6d, the following describes the method for generating the extended base matrix by using an example.

For example, the initial transmission code length N=1024, the initial transmission bit rate R=0.5 (that is, K=512), the number E of to-be-retransmitted bits=1000, the lifting size=16, the shifting value=1 to 16, the range of the row weight is 1 to 9, and L=50. In this embodiment of this application, the extended matrix is a binary field matrix with 1000 rows and 1024 columns, and the extended base matrix may be a matrix with $\left\lceil \frac{1000}{16} \right\rceil$ rows× columns=63 rows×64 columns. Therefore, a search tree (as shown in FIG. 6d) shown in this embodiment of this application needs to generate 63 rows in a progressive manner, and corresponds to a tree search process, to be specific, the search tree needs to grow 63 layers downward in the progressive manner, and L=50 candidate matrices with best performance need to be reserved for each layer.

First, L=50 empty matrices at a zeroth layer are generated, and *e*=0 is set. Because *e*<63, L=50 QC matrices with one row and 64 columns are randomly generated based on each matrix at the zeroth layer as candidate matrices at a first layer, and *e*=e+1=1. Then one additional column is randomly generated based on each QC matrix with one row and 64 columns, to obtain 2500 random QC matrices with two rows and 64 columns. In addition, row weights of these random QC matrices meet a maximum value 9 and a minimum value 1. A signal-to-noise ratio (signal-to-noise ratio, SNR) required for the polar code (N=1024, K=512) to meet BLER=0.01 under the 2500 random QC matrices is calculated according to a PEXIT algorithm and a Gaussian approximation (Gaussian approximation, GA) algorithm. L=50 matrices with a minimum SNR are selected from the 2500 random QC matrices as candidate matrices at a second layer, and *e*=*e*+1=2. In this way, the search tree completes growth of the second layer. Because e is still less than 63, the search tree continues to grow downwards: additional L=50 QC matrices with one row and 64 columns whose row weights are between 1 and 9 are randomly generated based on each matrix at the second layer, to obtain 2500 random QC matrices with 3 rows and 64 columns at a third layer. An SNR required for the polar code (N=1024, K=512) to meet BLER=0.01 under the 2500 random QC check matrices is calculated according to the PEXIT algorithm and the GA algorithm, and L=50 matrices with a minimum SNR are selected from the 2500 random QC check matrices as candidate matrices at the third layer, and *e*=*e*+1=3. In this way, the search tree completes growth of the third layer. The rest may be deduced by analogy until a length of the search tree reaches a 63$^{rd}$ layer (*e*=63). L=50 candidate matrices with 63 rows and 64 columns may be obtained, and a first candidate matrix with best performance is output as the extended base matrix. It may be understood that the matrix with 63 rows and 64 columns (for example, in a form of a binary field) and an identity matrix may be concatenated, and a matrix obtained through concatenation is used as the extended base matrix.

It may be understood that the methods for generating the extended base matrix shown in FIG. 6c and FIG. 6d are merely examples. This is not limited in embodiments of this application.

It may be understood that the extended matrix shown in this application is shown by using E rows and N columns as an example. Atranspose matrix of the extended matrix, for example, a matrix with N rows and E columns, a shifted matrix (for example, a right-shifted matrix or a leftshifted matrix) of the extended matrix, or a deformation such as rotation of the extended matrix falls within the protection scope of this application. Similarly, a deformation of the extended base matrix also falls within the protection scope of this application. For example, as shown above, a row weight of each row of the extended matrix meets any one or more of the following relationships: The row weight is negatively correlated with E, the row weight is positively correlated with K, the row weight is negatively correlated with N, and the row weight is positively correlated with R. After the extended matrix is transposed, a relationship may be obtained: A column weight of each column of the extended matrix meets any one or more of the following relationships: The column weight is negatively correlated with E, the column weight is positively correlated with K, the column weight is negatively correlated with N, and the column weight is positively correlated with R.

It may be understood that, in the foregoing method for obtaining the E to-be-retransmitted bits based on the extended matrix, the E to-be-retransmitted bits may be obtained based on a check matrix of Luby transform LDPC (Luby transform-LDPC, LT-LDPC) code or LT code, or the E to-be-retransmitted bits may be obtained based on a generator matrix of LT-LDPC code.

In the method shown in FIG. 4, the transmit end needs to perform first channel encoding on the K information bits. For example, the transmit end may perform first channel encoding on the K information bits based on a first reliability sequence. Locations of the K information bits shown in FIG. 4 are determined based on the first reliability sequence, a length of the first reliability sequence is N, the first reliability sequence is a subsequence of a second reliability sequence, a length of the second reliability sequence is $N_{max}$, and $N_{max}$ is greater than or equal to N.

Because the first reliability sequence needs to be flexibly changed based on different code lengths, there may be a plurality of sequences having this type of feature, as shown in FIG. 7a. FIG. 7a is a schematic diagram of decoding performance corresponding to different construction sequences according to this embodiment of this application. FIG. 7a shows decoding performance comparison between an online construction sequence, an offline construction sequence shown in this application, an NR polar construction sequence, and a PQ construction sequence. It can be seen from FIG. 7a that performance of the second reliability sequence provided in this embodiment of this application is optimal, and the performance of the second reliability sequence can be further close to that of a sequence obtained in an online construction manner. The second reliability sequence in this embodiment of this application may support a maximum code length $N_{max}$ and/or a maximum number $E_{max}$ of to-be-retransmitted bits. Optionally, the second reliability sequence may further support a maximum lifting size $Z_{max}$. In this embodiment of this application, an initial transmission sequence is the same as a retransmission sequence, and both the retransmission sequence and the initial transmission sequence meet the nesting property. For example, both the initial transmission sequence and the retransmission sequence each are a nested sequence with one code length.

For example, the transmit end may perform first channel encoding on the first bit sequence based on a same set of first reliability sequence. For example, the first reliability sequence may be represented as $Q^N = \{Q_1^N, Q_2^N, Q_3^N, ..., Q_N^N\}$. An element $Q_i^N$ in $Q^N$ indicates a sequence number of a subchannel, a value of the element does not exceed N, and sorting is performed in ascending order of reliability $W(Q_1^N) < W(Q_2^N) < W(Q_3^N) < ... < W(Q_N^N)$, where i=1, ..., N. For another example, the second reliability sequence may be represented as $Q^{N_{max}}$, $Q^N$ is a subsequence of $Q^{N_{max}}$, a value of an element $Q_i^{N_{max}}$ in $Q^{N_{max}}$ does not exceed $N_{max}$, and sorting is performed in ascending order of reliability $W(Q_1^{N_{max}}) < W(Q_2^{N_{max}}) < W(Q_3^{N_{max}}) < ... < W(Q_{N_{max}}^{N_{max}})$, where $i = 1,...,N_{max}$.

For example, the second reliability sequence $Q^{N_{max}} = \{Q_1^{N_{max}}, Q_2^{N_{max}}, ..., Q_{N_{max}}^{N_{max}}\}$ may be shown in Table 1, where $Q_i^{N_{max}} (1 \le Q_i^{N_{max}} \le N_{max})$ is a bit number before first channel encoding. The second reliability sequence $Q^{N_{max}}$ is a sequence sorted in ascending order of reliability $W(Q_1^{N_{max}}) < W(Q_2^{N_{max}}) < ... < W(Q_{N_{max}}^{N_{max}})$, where $W(Q_i^{N_{max}})$ is reliability corresponding to the bit number

## Table 1

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

For example, the first reliability sequence may alternatively be represented as $Q^N = \{Q_0^N, Q_1^N, Q_2^N, ..., Q_{N-1}^N\}$ An element $Q_i^N$ in $Q^{N-1}$ indicates a sequence number of a subchannel, a value of the element does not exceed N-1, and sorting is performed in ascending order of reliability $W(Q_0^N) < W(Q_1^N) < W(Q_2^N) < ... < W(Q_{N-1}^N)$, where i=0, ..., N-1. For another example, the second reliability sequence may be represented as $Q^{N_{max}}$, $Q^N$ is a subsequence of $Q^{N_{max}}$, a value of an element $Q_i^{N_{max}}$ in $Q^{N_{max}}$ does not exceed $N_{max}$-1, and sorting is performed in ascending order of reliability $W(Q_0^N) < W(Q_1^N) < W(Q_2^N) < ... < W(Q_{N_{max}-1}^{N_{max}})$, where $i = 0,1, ..., N_{max} -1$.

For example, the second reliability sequence $Q^{N_{max}} = \{Q_0^{N_{max}}, Q_1^{N_{max}}, ..., Q_{N_{max}-1}^{N_{max}}\}$ may be shown in Table 2, where $Q_i^{N_{max}} (0 \le Q_i^{N_{max}} \le N_{max} - 1)$ is a bit number before first encoding. The second reliability sequence $Q^{N_{max}}$ is a sequence sorted in ascending order of reliability $W(Q_0^{N_{max}}) < W(Q_1^{N_{max}}) < ... < W(Q_{N_{max}-1}^{N_{max}})$, where $W(Q_i^{N_{max}})$ is reliability corresponding to the bit number $Q_i^{N_{max}}$.

**Table 2**

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 0 | 0 | 128 | 58 | 256 | 325 | 384 | 213 | 512 | 315 | 640 | 373 | 768 | 694 | 896 | 861 |
| 1 | 1 | 129 | 85 | 257 | 580 | 385 | 308 | 513 | 788 | 641 | 721 | 769 | 791 | 897 | 862 |
| 2 | 2 | 130 | 135 | 258 | 110 | 386 | 187 | 514 | 127 | 642 | 793 | 770 | 504 | 898 | 863 |
| 3 | 3 | 131 | 544 | 259 | 352 | 387 | 448 | 515 | 422 | 643 | 716 | 771 | 697 | 899 | 867 |
| 4 | 4 | 132 | 276 | 260 | 533 | 388 | 216 | 516 | 412 | 644 | 414 | 772 | 415 | 900 | 869 |
| 5 | 5 | 133 | 86 | 261 | 271 | 389 | 407 | 517 | 235 | 645 | 374 | 773 | 717 | 901 | 870 |
| 6 | 6 | 134 | 139 | 262 | 641 | 390 | 608 | 518 | 451 | 646 | 722 | 774 | 698 | 902 | 871 |
| 7 | 7 | 135 | 515 | 263 | 171 | 391 | 595 | 519 | 802 | 647 | 794 | 775 | 718 | 903 | 873 |
| 8 | 8 | 136 | 196 | 264 | 305 | 392 | 550 | 520 | 598 | 648 | 805 | 776 | 375 | 904 | 874 |
| 9 | 9 | 137 | 60 | 265 | 560 | 393 | 649 | 521 | 372 | 649 | 377 | 777 | 700 | 905 | 875 |
| 10 | 10 | 138 | 384 | 266 | 117 | 394 | 228 | 522 | 720 | 650 | 737 | 778 | 723 | 906 | 876 |
| 11 | 11 | 139 | 289 | 267 | 158 | 395 | 158 | 523 | 611 | 651 | 724 | 779 | 795 | 907 | 877 |
| 12 | 12 | 140 | 99 | 268 | 225 | 396 | 419 | 524 | 792 | 652 | 796 | 780 | 379 | 908 | 878 |
| 13 | 16 | 141 | 89 | 269 | 326 | 397 | 309 | 525 | 425 | 653 | 427 | 781 | 725 | 909 | 879 |
| 14 | 17 | 142 | 141 | 270 | 300 | 398 | 540 | 526 | 653 | 654 | 806 | 782 | 726 | 910 | 881 |
| 15 | 18 | 143 | 517 | 271 | 212 | 399 | 772 | 527 | 601 | 655 | 378 | 783 | 797 | 911 | 882 |
| 16 | 20 | 144 | 176 | 272 | 534 | 400 | 609 | 528 | 317 | 656 | 655 | 784 | 798 | 912 | 883 |
| 17 | 24 | 145 | 290 | 273 | 400 | 401 | 656 | 529 | 833 | 657 | 603 | 785 | 807 | 913 | 884 |
| 18 | 32 | 146 | 101 | 274 | 547 | 402 | 332 | 530 | 804 | 658 | 738 | 786 | 255 | 914 | 885 |
| 19 | 33 | 147 | 90 | 275 | 329 | 403 | 118 | 531 | 376 | 659 | 319 | 787 | 381 | 915 | 886 |
| 20 | 34 | 148 | 147 | 276 | 642 | 404 | 599 | 532 | 736 | 660 | 728 | 788 | 382 | 916 | 887 |
| 21 | 36 | 149 | 142 | 277 | 584 | 405 | 338 | 533 | 426 | 661 | 835 | 789 | 383 | 917 | 888 |
| 22 | 40 | 150 | 518 | 278 | 306 | 406 | 217 | 534 | 237 | 662 | 809 | 790 | 431 | 918 | 889 |
| 23 | 48 | 151 | 280 | 279 | 279 | 407 | 367 | 535 | 343 | 663 | 380 | 791 | 439 | 919 | 890 |
| 24 | 64 | 152 | 200 | 280 | 173 | 408 | 651 | 536 | 453 | 664 | 740 | 792 | 443 | 920 | 891 |
| 25 | 65 | 153 | 102 | 281 | 118 | 409 | 229 | 537 | 654 | 665 | 429 | 793 | 445 | 921 | 892 |
| 26 | 66 | 154 | 521 | 282 | 537 | 410 | 390 | 538 | 602 | 666 | 239 | 794 | 446 | 922 | 893 |
| 27 | 68 | 155 | 149 | 283 | 199 | 411 | 312 | 539 | 659 | 667 | 810 | 795 | 447 | 923 | 894 |
| 28 | 72 | 156 | 292 | 284 | 63 | 412 | 449 | 540 | 318 | 668 | 455 | 796 | 463 | 924 | 895 |
| 29 | 80 | 157 | 105 | 285 | 387 | 413 | 541 | 541 | 613 | 669 | 605 | 797 | 471 | 925 | 903 |
| 30 | 96 | 158 | 92 | 286 | 226 | 414 | 333 | 542 | 834 | 670 | 615 | 798 | 475 | 926 | 907 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 31 | 128 | 159 | 522 | 287 | 121 | 415 | 232 | 543 | 808 | 671 | 744 | 799 | 477 | 927 | 909 |
| 32 | 129 | 160 | 150 | 288 | 179 | 416 | 554 | 544 | 433 | 672 | 837 | 800 | 478 | 928 | 910 |
| 33 | 130 | 161 | 576 | 289 | 549 | 417 | 773 | 545 | 428 | 673 | 430 | 801 | 479 | 929 | 911 |
| 34 | 132 | 162 | 31 | 290 | 330 | 418 | 174 | 546 | 238 | 674 | 817 | 802 | 487 | 930 | 915 |
| 35 | 136 | 163 | 163 | 291 | 216 | 419 | 122 | 547 | 243 | 675 | 812 | 803 | 491 | 931 | 917 |
| 36 | 256 | 164 | 263 | 292 | 174 | 420 | 657 | 548 | 454 | 676 | 435 | 804 | 493 | 932 | 918 |
| 37 | 512 | 165 | 106 | 293 | 538 | 421 | 611 | 549 | 559 | 677 | 606 | 805 | 494 | 933 | 919 |
| 38 | 144 | 166 | 153 | 294 | 644 | 422 | 340 | 550 | 604 | 678 | 752 | 806 | 495 | 934 | 921 |
| 39 | 13 | 167 | 321 | 295 | 283 | 423 | 776 | 551 | 897 | 679 | 838 | 807 | 499 | 935 | 922 |
| 40 | 14 | 168 | 529 | 296 | 308 | 424 | 219 | 552 | 614 | 680 | 818 | 808 | 501 | 936 | 923 |
| 41 | 19 | 169 | 47 | 297 | 389 | 425 | 313 | 553 | 836 | 681 | 899 | 809 | 502 | 937 | 924 |
| 42 | 21 | 170 | 165 | 298 | 203 | 426 | 423 | 554 | 816 | 682 | 841 | 810 | 503 | 938 | 925 |
| 43 | 22 | 171 | 524 | 299 | 416 | 427 | 394 | 555 | 434 | 683 | 820 | 811 | 505 | 939 | 926 |
| 44 | 25 | 172 | 267 | 300 | 122 | 428 | 672 | 556 | 457 | 684 | 437 | 812 | 506 | 940 | 927 |
| 45 | 26 | 173 | 296 | 301 | 592 | 429 | 582 | 557 | 661 | 685 | 459 | 813 | 507 | 941 | 931 |
| 46 | 35 | 174 | 208 | 302 | 228 | 430 | 354 | 558 | 617 | 686 | 663 | 814 | 508 | 942 | 933 |
| 47 | 257 | 175 | 154 | 303 | 337 | 431 | 286 | 559 | 898 | 687 | 842 | 815 | 509 | 943 | 934 |
| 48 | 37 | 176 | 113 | 304 | 181 | 432 | 182 | 560 | 399 | 688 | 619 | 816 | 510 | 944 | 935 |
| 49 | 258 | 177 | 322 | 305 | 550 | 433 | 233 | 561 | 840 | 689 | 824 | 817 | 511 | 945 | 937 |
| 50 | 38 | 178 | 108 | 306 | 295 | 434 | 124 | 562 | 775 | 690 | 438 | 818 | 607 | 946 | 938 |
| 51 | 28 | 179 | 530 | 307 | 95 | 435 | 556 | 563 | 347 | 691 | 901 | 819 | 623 | 947 | 939 |
| 52 | 160 | 180 | 55 | 308 | 332 | 436 | 659 | 564 | 436 | 692 | 849 | 820 | 631 | 948 | 940 |
| 53 | 41 | 181 | 166 | 309 | 579 | 437 | 615 | 565 | 245 | 693 | 844 | 821 | 635 | 949 | 941 |
| 54 | 260 | 182 | 269 | 310 | 553 | 438 | 341 | 566 | 458 | 694 | 441 | 822 | 637 | 950 | 942 |
| 55 | 42 | 183 | 114 | 311 | 540 | 439 | 315 | 567 | 662 | 695 | 247 | 823 | 638 | 951 | 943 |
| 56 | 44 | 184 | 169 | 312 | 285 | 440 | 240 | 568 | 618 | 696 | 902 | 824 | 639 | 952 | 945 |
| 57 | 67 | 185 | 156 | 313 | 390 | 441 | 777 | 569 | 191 | 697 | 461 | 825 | 671 | 953 | 946 |
| 58 | 49 | 186 | 79 | 314 | 205 | 442 | 562 | 570 | 675 | 698 | 850 | 826 | 687 | 954 | 947 |
| 59 | 264 | 187 | 275 | 315 | 648 | 443 | 344 | 571 | 900 | 699 | 621 | 827 | 695 | 955 | 948 |
| 60 | 69 | 188 | 324 | 316 | 312 | 444 | 451 | 572 | 848 | 700 | 442 | 828 | 699 | 956 | 949 |
| 61 | 50 | 189 | 195 | 317 | 338 | 445 | 396 | 573 | 440 | 701 | 905 | 829 | 701 | 957 | 950 |
| 62 | 70 | 190 | 59 | 318 | 182 | 446 | 402 | 574 | 246 | 702 | 462 | 830 | 702 | 958 | 951 |
| 63 | 73 | 191 | 532 | 319 | 124 | 447 | 206 | 575 | 465 | 703 | 865 | 831 | 703 | 959 | 952 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 64 | 52 | 192 | 270 | 320 | 393 | 448 | 673 | 576 | 665 | 704 | 852 | 832 | 719 | 960 | 953 |
| 65 | 74 | 193 | 545 | 321 | 769 | 449 | 557 | 577 | 625 | 705 | 622 | 833 | 727 | 961 | 954 |
| 66 | 76 | 194 | 640 | 322 | 232 | 450 | 784 | 578 | 460 | 706 | 467 | 834 | 729 | 962 | 955 |
| 67 | 272 | 195 | 170 | 323 | 527 | 451 | 431 | 579 | 359 | 707 | 667 | 835 | 730 | 963 | 956 |
| 68 | 81 | 196 | 304 | 324 | 299 | 452 | 356 | 580 | 620 | 708 | 444 | 836 | 731 | 964 | 957 |
| 69 | 192 | 197 | 116 | 325 | 448 | 453 | 186 | 581 | 349 | 709 | 906 | 837 | 732 | 965 | 958 |
| 70 | 56 | 198 | 277 | 326 | 211 | 454 | 235 | 582 | 904 | 710 | 627 | 838 | 733 | 966 | 959 |
| 71 | 82 | 199 | 87 | 327 | 185 | 455 | 663 | 583 | 249 | 711 | 866 | 839 | 734 | 967 | 963 |
| 72 | 131 | 200 | 224 | 328 | 608 | 456 | 623 | 584 | 864 | 712 | 856 | 840 | 735 | 968 | 965 |
| 73 | 133 | 201 | 197 | 329 | 554 | 457 | 586 | 585 | 466 | 713 | 351 | 841 | 739 | 969 | 966 |
| 74 | 84 | 202 | 61 | 330 | 286 | 458 | 779 | 586 | 666 | 714 | 913 | 842 | 741 | 970 | 967 |
| 75 | 134 | 203 | 385 | 331 | 581 | 459 | 704 | 587 | 626 | 715 | 908 | 843 | 742 | 971 | 969 |
| 76 | 137 | 204 | 546 | 332 | 111 | 460 | 125 | 588 | 677 | 716 | 251 | 844 | 743 | 972 | 970 |
| 77 | 513 | 205 | 177 | 333 | 206 | 461 | 241 | 589 | 567 | 717 | 868 | 845 | 745 | 973 | 971 |
| 78 | 138 | 206 | 328 | 334 | 353 | 462 | 564 | 590 | 350 | 718 | 469 | 846 | 746 | 974 | 972 |
| 79 | 514 | 207 | 278 | 335 | 340 | 463 | 397 | 591 | 779 | 719 | 669 | 847 | 747 | 975 | 973 |
| 80 | 97 | 208 | 172 | 336 | 394 | 464 | 345 | 592 | 912 | 720 | 914 | 848 | 748 | 976 | 974 |
| 81 | 288 | 209 | 291 | 337 | 770 | 465 | 455 | 593 | 250 | 721 | 629 | 849 | 749 | 977 | 975 |
| 82 | 98 | 210 | 536 | 338 | 656 | 466 | 357 | 594 | 481 | 722 | 679 | 850 | 750 | 978 | 977 |
| 83 | 88 | 211 | 91 | 339 | 561 | 467 | 404 | 595 | 468 | 723 | 872 | 851 | 751 | 979 | 978 |
| 84 | 140 | 212 | 198 | 340 | 186 | 468 | 302 | 596 | 668 | 724 | 470 | 852 | 753 | 980 | 979 |
| 85 | 516 | 213 | 62 | 341 | 159 | 469 | 568 | 597 | 628 | 725 | 670 | 853 | 754 | 981 | 980 |
| 86 | 145 | 214 | 386 | 342 | 327 | 470 | 243 | 598 | 678 | 726 | 929 | 854 | 755 | 982 | 981 |
| 87 | 100 | 215 | 143 | 343 | 301 | 471 | 594 | 599 | 407 | 727 | 916 | 855 | 756 | 983 | 982 |
| 88 | 146 | 216 | 519 | 344 | 213 | 472 | 188 | 600 | 928 | 728 | 630 | 856 | 757 | 984 | 983 |
| 89 | 15 | 217 | 281 | 345 | 240 | 473 | 565 | 601 | 707 | 729 | 253 | 857 | 758 | 985 | 984 |
| 90 | 23 | 218 | 120 | 346 | 582 | 474 | 675 | 602 | 252 | 730 | 483 | 858 | 759 | 986 | 985 |
| 91 | 520 | 219 | 201 | 347 | 556 | 475 | 360 | 603 | 482 | 731 | 473 | 859 | 760 | 987 | 986 |
| 92 | 148 | 220 | 178 | 348 | 535 | 476 | 705 | 604 | 472 | 732 | 880 | 860 | 761 | 988 | 987 |
| 93 | 27 | 221 | 103 | 349 | 401 | 477 | 588 | 605 | 681 | 733 | 633 | 861 | 762 | 989 | 988 |
| 94 | 259 | 222 | 548 | 350 | 354 | 478 | 214 | 606 | 632 | 734 | 930 | 862 | 763 | 990 | 989 |
| 95 | 104 | 223 | 293 | 351 | 643 | 479 | 785 | 607 | 363 | 735 | 920 | 863 | 764 | 991 | 990 |
| 96 | 39 | 224 | 93 | 352 | 585 | 480 | 646 | 608 | 781 | 736 | 254 | 864 | 765 | 992 | 991 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 97 | 29 | 225 | 282 | 353 | 307 | 481 | 347 | 609 | 591 | 737 | 474 | 865 | 766 | 993 | 993 |
| 98 | 161 | 226 | 523 | 354 | 119 | 482 | 418 | 610 | 484 | 738 | 634 | 866 | 767 | 994 | 994 |
| 99 | 261 | 227 | 151 | 355 | 396 | 483 | 405 | 611 | 960 | 739 | 932 | 867 | 799 | 995 | 995 |
| 100 | 43 | 228 | 388 | 356 | 562 | 484 | 463 | 612 | 682 | 740 | 485 | 868 | 811 | 996 | 996 |
| 101 | 30 | 229 | 577 | 357 | 772 | 485 | 679 | 613 | 571 | 741 | 961 | 869 | 813 | 997 | 997 |
| 102 | 162 | 230 | 202 | 358 | 344 | 486 | 800 | 614 | 782 | 742 | 683 | 870 | 814 | 998 | 998 |
| 103 | 262 | 231 | 107 | 359 | 227 | 487 | 361 | 615 | 709 | 743 | 476 | 871 | 815 | 999 | 999 |
| 104 | 152 | 232 | 336 | 360 | 188 | 488 | 589 | 616 | 787 | 744 | 636 | 872 | 819 | 1000 | 1000 |
| 105 | 45 | 233 | 180 | 361 | 302 | 489 | 408 | 617 | 488 | 745 | 936 | 873 | 821 | 1001 | 1001 |
| 106 | 320 | 234 | 294 | 362 | 214 | 490 | 569 | 618 | 689 | 746 | 486 | 874 | 822 | 1002 | 1002 |
| 107 | 265 | 235 | 94 | 363 | 672 | 491 | 787 | 619 | 365 | 747 | 783 | 875 | 823 | 1003 | 1003 |
| 108 | 528 | 236 | 578 | 364 | 402 | 492 | 596 | 620 | 684 | 748 | 962 | 876 | 825 | 1004 | 1004 |
| 109 | 51 | 237 | 525 | 365 | 356 | 493 | 571 | 621 | 710 | 749 | 489 | 877 | 826 | 1005 | 1005 |
| 110 | 46 | 238 | 297 | 366 | 331 | 494 | 218 | 622 | 411 | 750 | 944 | 878 | 827 | 1006 | 1006 |
| 111 | 164 | 239 | 209 | 367 | 217 | 495 | 310 | 623 | 496 | 751 | 685 | 879 | 828 | 1007 | 1007 |
| 112 | 71 | 240 | 552 | 368 | 586 | 496 | 707 | 624 | 690 | 752 | 964 | 880 | 829 | 1008 | 1008 |
| 113 | 266 | 241 | 155 | 369 | 175 | 497 | 597 | 625 | 223 | 753 | 490 | 881 | 830 | 1009 | 1009 |
| 114 | 112 | 242 | 284 | 370 | 539 | 498 | 600 | 626 | 366 | 754 | 711 | 882 | 831 | 1010 | 1010 |
| 115 | 53 | 243 | 323 | 371 | 645 | 499 | 650 | 627 | 573 | 755 | 686 | 883 | 839 | 1011 | 1011 |
| 116 | 75 | 244 | 204 | 372 | 564 | 500 | 420 | 628 | 371 | 756 | 968 | 884 | 843 | 1012 | 1012 |
| 117 | 54 | 245 | 109 | 373 | 309 | 501 | 791 | 629 | 713 | 757 | 497 | 885 | 845 | 1013 | 1013 |
| 118 | 268 | 246 | 531 | 374 | 776 | 502 | 801 | 630 | 789 | 758 | 691 | 886 | 846 | 1014 | 1014 |
| 119 | 77 | 247 | 167 | 375 | 417 | 503 | 610 | 631 | 692 | 759 | 492 | 887 | 847 | 1015 | 1015 |
| 120 | 273 | 248 | 392 | 376 | 123 | 504 | 601 | 632 | 574 | 760 | 367 | 888 | 851 | 1016 | 1016 |
| 121 | 193 | 249 | 768 | 377 | 593 | 505 | 409 | 633 | 714 | 761 | 976 | 889 | 853 | 1017 | 1017 |
| 122 | 57 | 250 | 115 | 378 | 229 | 506 | 230 | 634 | 423 | 762 | 498 | 890 | 854 | 1018 | 1018 |
| 123 | 168 | 251 | 526 | 379 | 404 | 507 | 687 | 635 | 413 | 763 | 693 | 891 | 855 | 1019 | 1019 |
| 124 | 83 | 252 | 298 | 380 | 704 | 508 | 652 | 636 | 790 | 764 | 500 | 892 | 857 | 1020 | 1020 |
| 125 | 78 | 253 | 210 | 381 | 551 | 509 | 247 | 637 | 803 | 765 | 575 | 893 | 858 | 1021 | 1021 |
| 126 | 274 | 254 | 184 | 382 | 218 | 510 | 368 | 638 | 696 | 766 | 992 | 894 | 859 | 1022 | 1022 |
| 127 | 194 | 255 | 157 | 383 | 360 | 511 | 189 | 639 | 599 | 767 | 715 | 895 | 860 | 1023 | 1023 |

For example, $Q^{N_{max}}$ under different numbers E of check bits may be obtained based on performance of the sequence $Q^{N_{max}}$, obtained by using an online construction method, as an offline construction sequence. For example, the offline construction sequence shown in Table 1 or Table 2 may be obtained based on $Q^{N_{max}}$ corresponding to different E.

For example, because the to-be-retransmitted bit may be a linear combination of initially transmitted bits, each retransmission is an enhancement of an initially transmitted bit participating in a check. Therefore, the initially transmitted bit participating in the check has higher reliability than an initially transmitted bit that does not participate in a check. For example, if an initially transmitted bit participates in more checks, the initially transmitted bit is more reliable. As a number of to-be-retransmitted bits increases, a reliability difference between initially transmitted bits $c_1$, $c_2$, ..., and $c_N$ that originally have same reliability gradually increases. That is, reliability of the N initially transmitted bits is related to the row weight of the extended matrix. In addition, because the extended matrix has a QC form, channels of the N checked initially transmitted bits also present a block-wise (block-wise) feature. That is, reliability in a block is the same, and reliability between blocks is different. For example, a block size is equal to the lifting size of the extended base matrix. For example, FIG. 7b is a schematic diagram of a reliability difference between bit channels and a block-wise feature according to this embodiment of this application. As shown in FIG. 7b, a check relationship between the N initially transmitted bits and the E to-be-retransmitted bits may be obtained based on a check relationship between a check node and a variable node. The reliability between the N initially transmitted bits included in the first bit sequence obtained through polar code encoding may be shown in a figure on the right of FIG. 7b. After being zoomed in, the figure shown on the right of FIG. 7b may be shown in a figure on the bottom of FIG. 7b. For example, FIG. 7b shows an example in which the length of the first bit sequence is 1024, the initial transmission bit rate is 0.75, and the lifting size is 16. It may be understood that because the lifting size is 16, each column shown in FIG. 7b may indicate 16 bits. It may be understood that, for a relationship between the N initially transmitted bits and the E to-be-retransmitted bits on the left of FIG. 7b, refer to FIG. 7c. It may be understood that reliability between different initially transmitted bits shown in FIG. 7b is merely an example.

Table 1 and Table 2 show reliability sequences shown in an offline construction manner. This embodiment of this application further provides an online construction manner. For example, the transmit end may determine reliability of each of N initial transmission locations based on a channel status and an extended matrix, where reliability of one initial transmission location is positively correlated with a number of bits that participate in retransmission; determine a first reliability sequence in ascending order of reliability of the N initial transmission locations; and perform first channel encoding on the K information bits based on the first reliability sequence. The channel status may be a status of a channel between the transmit end and the receive end. In other words, the online construction sequence shown in this embodiment of this application may be a function of N, K, E, and Z. That is, the online construction sequence is not only related to N and K, but also related to E and Z.

For example, a method for constructing the first reliability sequence online may be as follows:

(1) Input a bit length N, a number K of information bits, and a number E of check bits (which may also be a target code length M) after first channel encoding, a lifting size Z of the extended matrix, a search range from $SNR_{min}$ to $SNR_{max}$ (for example, $SNR_{min}$=-5, $SNR_{max}$=20) and $SNR_{step}$ (for example, 0.25) of the SNR, a maximum number of iterations iterMax (for example, 4) of PEXIT analysis, and a target BLER, for example, BLER* (for example, $10^{-2}$).

(2) Determine an extended matrix $H_{EN}$ based on N, E, and Z, and initialize $SNR_{cur}=SNR_{min}-SNR_{step}$.

(3) Set $SNR_{cur}=SNR_{cur}+SNR_{step}$, and calculate, based on the extended matrix $H_{EN}$ and through PEXIT, extrinsic information $I_{EC}$ sent from the check node to the variable node.

(4) Calculate, according to EXIT functions such as J(·) and $J^{-1}(\cdot)$ under a Gaussian channel, a variance $\sigma_i^2$ and an average value $\sigma_i = \frac{\sigma_i^2}{2}$ of a transition probability of a channel corresponding to the variable node $c_i$ ($i$=1, 2, ..., N). It may be understood that, that the average value indicates a value of the reliability herein is merely an example.

(5) Sort the average values $\sigma_i$ in ascending order to obtain $\overline{\sigma} = [\overline{\sigma}_1 \overline{\sigma}_2, \ldots, \overline{\sigma}_N]$ and an internal interleaver sequence such as I=[$i_1$, ..., $i_N$], and calculate reliability $W(Q_i^{N_{max}})$ of a bit channel of the polar code based on $\overline{\sigma}$ and according to GA, where $i$=1, 2, ..., N.

(6) Sort numbers of the bit channels in ascending order of $W(Q_i^N)$ to obtain a construction sequence $Q_i^N$, select K locations with highest reliability as information bits, and calculate a BLER of the K locations under current $SNR_{cur}$.

(7) If BLER≤BLER*, output the current sequence $B=Q_i^N$, $i$=1, 2, ..., N as a construction sequence, otherwise, return to step (2).

It may be understood that the foregoing online construction method is merely an example, and a specific construction method is not limited in embodiments of this application.

The following describes a relationship between the extended matrix and the first reliability sequence with reference to a specific example. For example, a length of the second bit sequence is 8, that is, $c_1c_2c_3c_4c_5c_6c_7c_8$, and an extended base matrix is shown as follows:

$$\begin{bmatrix} 3 & 0 & 0 & 0 & 0 \\ 0 & 1 & 0 & 2 & 0 \\ 2 & 1 & 3 & 0 & 0 \\ 1 & 0 & 2 & 3 & 2 \end{bmatrix}$$

For example, if Z=2, the extended base matrix is converted into a binary field matrix, and the binary field matrix may be shown as follows:

$$\begin{matrix} 1 & 0 & 0 & 0 & 0 & 0 & 0 & 0 & 0 & 0 \\ 0 & 1 & 0 & 0 & 0 & 0 & 0 & 0 & 0 & 0 \\ 0 & 0 & 1 & 0 & 0 & 0 & 1 & 0 & 0 & 0 \\ 0 & 0 & 0 & 1 & 0 & 0 & 0 & 1 & 0 & 0 \\ 1 & 0 & 1 & 0 & 1 & 0 & 0 & 0 & 0 & 0 \\ 0 & 1 & 0 & 1 & 0 & 1 & 0 & 0 & 0 & 0 \\ 1 & 0 & 0 & 0 & 1 & 0 & 1 & 0 & 1 & 0 \\ 0 & 1 & 0 & 0 & 0 & 1 & 0 & 1 & 0 & 1 \end{matrix}$$

An extended matrix obtained through shifting toward the right by a corresponding column based on the shifting value is shown as follows:

$$\begin{matrix} 0 & 1 & 0 & 0 & 0 & 0 & 0 & 0 & 0 & 0 \\ 1 & 0 & 0 & 0 & 0 & 0 & 0 & 0 & 0 & 0 \\ 0 & 0 & 0 & 1 & 0 & 0 & 1 & 0 & 0 & 0 \\ 0 & 0 & 1 & 0 & 0 & 0 & 0 & 1 & 0 & 0 \\ 1 & 0 & 0 & 1 & 0 & 1 & 0 & 0 & 0 & 0 \\ 0 & 1 & 1 & 0 & 1 & 0 & 0 & 0 & 0 & 0 \\ 0 & 1 & 0 & 0 & 1 & 0 & 0 & 1 & 1 & 0 \\ 1 & 0 & 0 & 0 & 0 & 1 & 1 & 0 & 0 & 1 \end{matrix}$$

FIG. 7d is a schematic diagram of the relationship between the extended matrix and the first reliability sequence according to this embodiment of this application. As shown in FIG. 7d, based on the check relationship between the check node and the variable node, it may be obtained that $p_1+c_2+c_5+c_8=0$ and $p_2+c_1+c_6+c_7=0$ in a binary field, that is, $p_1=c_2+c_5+c_8$, and $p_2=c_1+c_6+c_7$. It may be understood that FIG. 7d shows only an example of a relationship between some to-be-retransmitted bits and the N initially transmitted bits. It can be seen from the schematic diagram shown in FIG. 7d that both $c_1$ and $c_2$ participate in one to-be-retransmitted bit, both $c_3$ and $c_4$ participate in two to-be-retransmitted bits, both $c_5$ and $c_6$ participate in three to-be-retransmitted bits, and both $c_7$ and $c_8$ participate in four to-be-retransmitted bits. It indicates that when the first reliability sequence is constructed, if N=8, reliability of a seventh location and an eighth location is highest, and reliability of a first location and a second location is lowest. Because the lifting size Z=2, it indicates that a size of a block in an internal interleaver is equal to 2. For example, $c_1$ and $c_2$ correspond to a same block, and reliability of locations corresponding to $c_1$ and $c_2$ is the same. For another example, $c_7$ and $c_8$ correspond to a same block, and reliability of locations corresponding to $c_7$ and $c_8$ is the same. For example, sorting is performed for the reliability sequence in ascending order to obtain an internal interleaver sequence I=[12345678].

It may be understood that FIG. 7d is the schematic diagram for describing the relationship between the extended matrix and the first reliability sequence. The extended matrix shown in FIG. 7d is not limited in embodiments of this application.

In this embodiment of this application, virtual channels corresponding to the N initially transmitted bits have different reliability, and an optimized constructed sequence is obtained by sorting the channels in ascending order of reliability. Therefore, an internal interleaver corresponding to the sequence is further needed in encoding and decoding processes. To be specific, in the method shown in FIG. 4, the transmit end may perform first channel encoding on the K information bits based on an internal interleaver sequence, the internal interleaver sequence is determined based on the extended matrix, and a size of a block in the internal interleaver sequence is equal to the lifting size of the extended matrix. For example, for a description of the internal interleaver sequence, refer to the foregoing description of the first reliability sequence. Details are not described herein again.

For example, the internal interleaver sequence may have a block-wise interleaving feature. For example, interleaving is performed between blocks in ascending order of reliability, interleaving may be performed or may not be performed within a block, and a block size may be equal to a lifting size.

Based on the description of the internal interleaver sequence shown in this embodiment of this application, for example, an internal interleaver sequence I corresponding to an initially transmitted polar code with lifting size=16 and N=256 may have a form shown in Table 3.

**Table 3**

| | | | | | | | | | | | | | | | |
|---|---|---|---|---|---|---|---|---|---|---|---|---|---|---|---|
| 1 | 2 | 3 | 4 | 5 | 6 | 7 | 8 | 9 | 10 | 11 | 12 | 13 | 14 | 15 | 16 |
| 33 | 34 | 35 | 36 | 37 | 38 | 39 | 40 | 41 | 42 | 43 | 44 | 45 | 46 | 47 | 48 |
| 81 | 82 | 83 | 84 | 85 | 86 | 87 | 88 | 89 | 90 | 91 | 92 | 93 | 94 | 95 | 96 |
| 65 | 66 | 67 | 68 | 69 | 70 | 71 | 72 | 73 | 74 | 75 | 76 | 77 | 78 | 79 | 80 |
| 17 | 18 | 19 | 20 | 21 | 22 | 23 | 24 | 25 | 26 | 27 | 28 | 29 | 30 | 31 | 32 |
| 97 | 98 | 99 | 100 | 101 | 102 | 103 | 104 | 105 | 106 | 107 | 108 | 109 | 110 | 111 | 112 |
| 209 | 210 | 211 | 212 | 213 | 214 | 215 | 216 | 217 | 218 | 219 | 220 | 221 | 222 | 223 | 224 |
| 129 | 130 | 131 | 132 | 133 | 134 | 135 | 136 | 137 | 138 | 139 | 140 | 141 | 142 | 143 | 144 |
| 145 | 146 | 147 | 148 | 149 | 150 | 151 | 152 | 153 | 154 | 155 | 156 | 157 | 158 | 159 | 160 |
| 161 | 162 | 163 | 164 | 165 | 166 | 167 | 168 | 169 | 170 | 171 | 172 | 173 | 174 | 175 | 176 |
| 49 | 50 | 51 | 52 | 53 | 54 | 55 | 56 | 57 | 58 | 59 | 60 | 61 | 62 | 63 | 64 |
| 225 | 226 | 227 | 228 | 229 | 230 | 231 | 232 | 233 | 234 | 235 | 236 | 237 | 238 | 239 | 240 |
| 193 | 194 | 195 | 196 | 197 | 198 | 199 | 200 | 201 | 202 | 203 | 204 | 205 | 206 | 207 | 208 |
| 113 | 114 | 115 | 116 | 117 | 118 | 119 | 120 | 121 | 122 | 123 | 124 | 125 | 126 | 127 | 128 |
| 177 | 178 | 179 | 180 | 181 | 182 | 183 | 184 | 185 | 186 | 187 | 188 | 189 | 190 | 191 | 192 |
| 241 | 242 | 243 | 244 | 245 | 246 | 247 | 248 | 249 | 250 | 251 | 252 | 253 | 254 | 255 | 256 |

It may be understood that the internal interleaver sequence shown in Table 3 is merely an example, and should not be construed as a limitation on embodiments of this application.

The following describes an encoding method shown in this embodiment of this application with reference to a specific example. An example is shown below:

(1) Input the initial transmission code length N, the initial transmission bit rate R, the internal interleaver sequence $I_{perm}$, and the number E of to-be-retransmitted bits.

(2) Determine the lifting size of the extended base matrix based on $Z=\left\lceil \frac{N}{N_0} \right\rceil$, and extend the extended base matrix to obtain the first matrix.

It may be understood that the number of columns, indicating the check relationship, of the QC matrix of the $G_{check}$ may be alternatively understood as the number of columns $N_0$ in the extended base matrix shown above.

(3) Puncture/Shorten a corresponding column of the first matrix in a rate matching manner of the to-be-initially transmitted polar code; or puncture ($Z \times N_0$ -N) columns with a maximum column weight of the extended matrix to obtain a number of columns $H_N$ of an extended matrix whose initial transmission code length is N.

(4) Extract E rows downwards from a $(j=\frac{N\times(R_h-R)}{R})^{th}$ row based on $H_N$ to obtain an extended matrix $H_R$ with E rows$\times$(N+E) columns whose initial transmission bit rate is R.

It may be understood that a calculation manner of j shown herein is merely an example. For a specific description of j, refer to the foregoing descriptions of j, R, $R_h$, N, and $\Delta$. Details are not described herein again.

(5) Perform a column transposing operation on the first N columns of $H_R$ based on the interleaver sequence $I_{perm}$ of the polar code, to obtain $H_{perm}$.

(6) Generate E to-be-retransmitted bits based on $H_{perm}$, where each row of $H_{perm}$ corresponds to one to-be-retransmitted bit. For example, $e^{th}$ ($e$=1, 2, ..., E) to-be-retransmitted bit $c_e$=$H_{perm}$ ($e$, 1:N)×[$c_1$, $c_2$, ..., $c_N$]$^T$.

For example, as shown in FIG. 8a, a first row of the extended matrix that adapts to the initial transmission bit rate may be extracted through shifting up and down, and different initial transmission code lengths may be adapted through rate matching.

For example, the following provides an example in which the extended matrix adapts to different initial transmission bit rates.

It is assumed that when the initial transmission code length N=$2^{10}$ (namely, 1024), and the lifting size=16, the initial transmission bit rate R=0.5, and the maximum initial transmission bit rate $R_h$=0.75. In step (4) in the foregoing encoding method, $j=\frac{1024\times(0.75-0.5)}{0.5}=512$ rows need to be shifted downward from a first row of the first matrix to obtain a retransmission start point. If the number E of to-be-retransmitted bits=400, 400 rows are extracted downward from a $513^{th}$ row of the first matrix to obtain an extended matrix whose initial transmission bit rate is 0.5 and the number of to-be-retransmitted bits is 400, as shown on the left of FIG. 8b. It may be understood that, for a description of the first matrix, refer to the foregoing description. Details are not described herein again.

For another example, the following provides an example in which the extended matrix adapts to different initial transmission code lengths.

It is assumed that when the initial transmission bit rate R=0.75 and the lifting size=16, the initial transmission code length N=992, and the maximum initial transmission bit rate $R_h$=0.75=R, in other words, an operation of adapting to the initial transmission bit rate is not needed. To adapt to the initial transmission code length, 32 (1024-992) columns may be removed through puncturing in a puncture mode according to a 5G NR polar rate matching method, to obtain an extended matrix with the initial transmission code length N=992, as shown on the right of FIG. 8b.

It may be understood that the foregoing example is merely an example, and should not be construed as a limitation on embodiments of this application.

The following describes a method for sending a HARQ provided in this embodiment of this application.

As shown above, performing retransmission based on the second bit sequence includes:

determining an initial transmission start point of a cyclic buffer based on N and K;
determining a retransmission start point of the cyclic buffer based on the initial transmission start point and N, or determining a retransmission start point of the cyclic buffer based on the initial transmission start point and E; and
performing retransmission based on the second bit sequence and the retransmission start point.

The cyclic buffer (buffer) includes an open-loop buffer and a closed-loop buffer. Descriptions are separately provided below.

Manner 1 of sending the to-be-retransmitted bit:

The left of FIG. 9a is a schematic diagram of an initial transmission bit rate matching buffer. For example, shortening or puncturing may be adopted for rate matching of the initially transmitted polar code. This is not limited in embodiments of this application. The right of FIG. 9a is a schematic diagram of a retransmission buffer whose maximum number of retransmissions is e. It may be understood that FIG. 9a may also be understood as a schematic diagram of a closed-loop cyclic buffer with a maximum number of sending times. Bits in the buffer may be obtained according to the first channel encoding method or the second channel encoding method.

The retransmission buffer may calculate an initial transmission start point and a retransmission start point based on the maximum initial transmission bit rate $R_h$, the initial transmission code length N, and the initial transmission bit rate R and according to the following formulas:

$$\text{Initial transmission start point } v_{0_start}=\frac{N\times(R_h-R)}{R}+\Delta,$$

for example, when $R_0$=$R_h$, and Δ= 0, $v_{0_start}$=0

$$\text{First retransmission start point } v_{1_start}=v_{0_start}+N$$

$$\text{Second retransmission start point } v_{2_start}=v_{1_start}+E_1$$

$$\text{Third retransmission start point } v_{3_start}=v_{2_start}+E_2$$

Δ indicates an offset value, and may be a real number (for example, a positive integer, 0, or a negative integer). For example, the initial transmission start point may further meet the following conditions:

$$v_{0_star}=\left\lceil\frac{N\times(R_h-R)}{R}+\Delta\right\rceil$$

$$v_{0_star}=\left\lceil\frac{N\times(R_h-R)}{R}\right\rceil+\Delta$$

$$v_{0_star}=\left\lfloor\frac{N\times(R_h-R)}{R}+\Delta\right\rfloor$$

$$v_{0_star}=\left\lfloor\frac{N\times(R_h-R)}{R}\right\rfloor+\Delta$$

For example, ⌈⌉ indicates rounding up, and ⌊⌋ indicates rounding down. For example, Δ may be equal to 0. Alternatively, Δ may be equal to -1, -2, -3, -4, -5, or the like. Examples are not provided herein one by one. Alternatively, Δ may be equal to 1, 2, 3, 4, 5, or the like. Examples are not provided herein one by one.

It may be understood that the maximum number of retransmissions 3 shown above is merely an example. For example, the maximum number of retransmissions may alternatively be 4, 5, or the like. This is not limited in embodiments of this application.

Manner 2 of sending the to-be-retransmitted bit:

This embodiment of this application further provides a method for designing an open-loop cyclic buffer that supports rateless sending. In other words, in the encoding method provided in this embodiment of this application, retransmission may be flexibly performed at a granularity of 1 bit based on the number E of to-be-retransmitted bits (for example, $E_1$ shown in FIG. 9a may be equal to 1, or $E_2$ may be equal to 1), and a similar rateless sending manner may be used, for example, to-be-retransmitted bits are constantly generated based on a buffer free of a closed loop. The left of FIG. 9b is a schematic diagram of an initial transmission bit rate matching buffer. For example, shortening or puncturing may be adopted for rate matching of the initially transmitted polar code. The right of FIG. 9b is a schematic diagram of a retransmission buffer using a rateless sending manner.

For example, the maximum initial transmission bit rate $R_h$, the initial transmission code length N, and the initial transmission bit rate R are given, and an initial transmission start point and a retransmission start point may be calculated according to the following formulas:

$$\text{Initial transmission start point } v_{0_start}=\frac{N\times(R_h-R)}{R}+\Delta\text{, for example, when } R_0=R_h\text{, and } \Delta=0\text{, } v_{0_start}=0$$

$$\text{First retransmission start point } v_{1_start}=v_{0_start}+N$$

$$\text{Second retransmission start point } v_{2_start}=v_{1_start}+E_1$$

$$\text{Third retransmission start point } v_{3_start}=v_{2_start}+E_2$$

...

$$e^{th}\text{ retransmission start point } v_{e_start}=v_{e-1_start}+E_e$$

That is, a to-be-retransmitted bit for a next transmission may be determined based on previous e transmissions. For example, a frequency at which each bit in the initially transmitted bits in the previous e transmissions participates in a check is counted. In an (e+1)$^{th}$ transmission, two initially transmitted bits with a lowest frequency are selected and added as to-be-retransmitted bits. In other words, the manner 2 of sending the to-be-retransmitted bit may be understood as that a bit to be retransmitted this time is determined based on the previously sent bit, and is sent until decoding succeeds. It may be understood that, for a description of the initial transmission start point, refer to the foregoing description of the manner 1 of sending the to-be-retransmitted bit. Details are not described herein again.

It may be understood that, in this embodiment of this application, a manner of direct sending without encoding (for example, a CC-HARQ) may be used for retransmission of the open-loop cyclic buffer that supports rateless sending: Transmission starts from the initial transmission bit rate R (R<maximum initial transmission bit rate $R_h$), and a to-be-retransmitted bit is first generated based on the extended matrix. As the number of retransmissions increases, when the bit rate decreases to less than $R_l$ (for example, $R_l$=0.25), a to-be-retransmitted bit is selected from back to front to be directly retransmitted without being encoded. For example, the maximum initial transmission bit rate $R_h$, the initial transmission code length N, and the initial transmission bit rate R are given, and an initial transmission start point and a retransmission start point may be calculated according to the following formulas:

Initial transmission start point $v_{0_start}=\frac{N\times(R_h-R)}{R}+\Delta$, for example, when $R_0=R_h$, and $\Delta=0$, $v_{0_start}=0$

First retransmission start point $v_{1_start}=v_{0_start}+N_0$

Second retransmission start point $v_{2_start}=v_{1_start}+E_1$

Third retransmission start point $v_{3_start}=v_{2_start}+E_2$

...

e$^{th}$ retransmission start point $v_{e_start}=v_{e-1_start}+E_e$

When $R=\frac{N_0R_0}{N0+E1+E2+\cdots+Ee}<R_l$, the to-be-retransmitted bit is selected to be directly retransmitted without being encoded (the selection method may perform selection from back to front, and may be the CC-HARQ method described above).

The foregoing is the encoding method for retransmission provided in this embodiment of this application. An embodiment of this application further provides a decoding method for retransmission. FIG. 10 is a schematic flowchart of a retransmission method according to an embodiment of this application. As shown in FIG. 10, the retransmission method includes the following steps.

1001: A receive end obtains a second to-be-decoded sequence, where the second to-be-decoded sequence includes information about E retransmitted bits, and E is an integer greater than or equal to 1.

It may be understood that, that the receive end obtains the second to-be-decoded sequence herein means that the receive end may process a receive sequence and then obtain the second to-be-decoded sequence. For example, the receive end may perform processing such as demodulation on the receive sequence to obtain the second to-be-decoded sequence. The information about the E retransmitted bits may be understood as a soft information sequence obtained by processing the E retransmitted bits through a channel, or a soft information sequence obtained by processing the second bit sequence through a channel.

1002: The receive end performs second channel decoding on the second to-be-decoded sequence based on an extended matrix to obtain a first to-be-decoded sequence, where the extended matrix includes E rows and N columns, the extended matrix is obtained based on an extended base matrix, the extended base matrix includes $E_0$ rows and $N_0$ columns, the first to-be-decoded sequence includes information about N bits, and both $E_0$ and $N_0$ are integers greater than or equal to 1.

The information about the N bits may be understood as a soft information sequence obtained by processing the N bits through a channel, a soft information sequence obtained by processing the first bit sequence through a channel, or a soft information sequence obtained by processing N initially transmitted bits through a channel.

1003: The receive end performs first channel decoding on the first to-be-decoded sequence based on a first reliability sequence to obtain K information bits, where a length of the first reliability sequence is N, the first reliability sequence is a subsequence of a second reliability sequence, a length of the second reliability sequence is $N_{max}$, $N_{max}$ is greater than or equal to N, and K is an integer greater than or equal to 1.

It may be understood that, for specific descriptions of the first reliability sequence, the second reliability sequence, the extended matrix, the extended base matrix, and the like shown in FIG. 10, refer to the encoding method described above in this application. Details are not described herein again. For example, for descriptions of the extended matrix and the extended base matrix, refer to the foregoing descriptions shown in FIG. 6a to FIG. 6d. For the first reliability sequence and the second reliability sequence, refer to the foregoing descriptions shown in Table 1, Table 2, FIG. 7a to FIG. 7d, and the like. Details are not described herein again.

It may be understood that how the receive end and a transmit end learn of the extended base matrix and the second reliability sequence is not limited in embodiments of this application.

For example, the following describes the decoding method provided in embodiments of this application by using a large iterative decoding procedure as an example. However, the decoding method described below should not be understood as a limitation on embodiments of this application.

For example, for the receive end, the receive end may input a receive sequence $y_1, y_2, ..., y_T$, where T indicates a length of the receive sequence; may input encoding parameters: an initial transmission code length N, a number E of retransmitted bits, an extended matrix $H_{EN}$ (which is merely an example, and may also be $G_{check}$), an internal interleaver sequence I, and a first reliability sequence (an information location indication sequence B may be obtained based on the first reliability sequence, a location of 0 in the sequence B indicates a frozen bit, and a location of 1 indicates an information bit), a puncture mode Q, and a CRC polynomial crc_poly; and may input decoding parameters: a maximum number of iterations $ITER_{max}$ for BP decoding, and a list dimension List of CRC-aided SCL (CRC-Aided SCL, CA-SCL) decoding. For example, List described herein may be equal to any value in {1, 2, 4, 8, 16, 32}.

Based on the foregoing input, the receive end may output a decoding result of the decoding method for retransmission provided in this application, for example, an information sequence $u_1, ..., u_K$, soft values $L_s=l_{s1}, ..., l_{sN}$ corresponding to the K information bits, and a soft value $L_c=L_{c1}, ..., L_{cE}$ corresponding to the retransmitted bit. It may be understood that an example in which the information sequence output by the receive end includes information bits is used for description herein. For example, the information sequence output by the receive end further includes a frozen bit. For example, the receive end may further output N bits, and the N bits include K information bits and N-K frozen bits. Whether the output result of the receive end includes only the information bit or includes both the information bit and the frozen bit is not limited in embodiments of this application. It may be understood that the soft value $L_s$ and the soft value $L_c$ described above may also be referred to as a soft value $L_{EF}$, that is, the soft value $L_{EF}$ includes the soft value $L_s$ and the soft value $L_c$.

For example, FIG. 11a is a schematic flowchart of large iterative decoding according to this embodiment of this application. As shown in FIG. 11a, the decoding method includes: determining a receive sequence, an encoding parameter, and a decoding parameter; then initializing, based on a soft value of the receive sequence, a soft value $L_{EF}$ corresponding to the retransmitted bit, for example, $l_{EF1}, ..., l_{EFN+E}$, and initializing, based on soft values $L_s$ (for example, $l_{s1}, ..., l_{sN}$) corresponding to the N initially transmitted bits, soft values $L_p$ corresponding to the first N bits of polar code; when curIter (indicating a number of current iterations) is less than $ITER_{max}$, calculating extrinsic information $L_{ex}=L_p-L_s$; then inputting $L_{EF}$ and $L_{ex}$ to a BP decoder for one iteration, to obtain an updated soft value $L_{EF}$ corresponding to the retransmitted bit; taking out soft values $L_s$ at locations of the N initially transmitted bits in $L_{EF}$, and inputting the soft values $L_s$ into a CA-SCL decoder for decoding, to obtain an optimal decoding path $u_1, ..., u_K$ of the polar code and a soft value $L_p$ of a corresponding sequence $c_1, ..., c_N$, for example, $lp_1, ..., lp_N$; and when $u_1, ..., u_K$ fails to pass through a CRC check, performing a next iteration. The rest is deduced by analogy until curIter is not less than $ITER_{max}$, and the optimal decoding path $u_1,..., u_K$, $L_s$, and $L_c$ is output.

For example, FIG. 11b is a schematic diagram of a decoding method according to this embodiment of this application. The receive end obtains a receive sequence $y_1, y_2, ..., Y_{N+E}$, (namely, the second to-be-decoded sequence described above). It may be understood that N+E described herein indicates a length of a received symbol. Then, a receive sequence (namely, the first to-be-decoded sequence described above) of the N initially transmitted bits is obtained through LDPC decoding (LDPC Dec), and a decoding path $u_1, ..., u_K$ of the N initially transmitted bits and corresponding $lp_1, ..., lp_N$ are obtained through polar code decoding (polar Dec). If decoding is incorrect or $ITER_{max}$ is not reached, LDPC decoding and polar code decoding are performed again based on the extrinsic information $lex_1, ...,$ and $lex_N$ until decoding is correct or $ITER_{max}$ is reached, and an optimal decoding path $u_1, ..., u_K$ is output. Optionally, $L_s$ and $L_c$ may be further output.

It may be understood that the methods shown in FIG. 11a and FIG. 11b are merely examples, and should not be construed as limitations on embodiments of this application. LDPC decoding and polar code decoding are merely examples of this embodiment of this application, and specific methods for second channel decoding and first channel decoding are not limited.

According to the method provided in this embodiment of this application, decoding of the N initially transmitted bits may be assisted by using soft values generated by the E retransmitted bits, and a decoding scheme of early stopping is supported. To be specific, after each LDPC Dec iteration, a decoding result is sent to Polar Dec decoding. A maximum number of allowed attempts is $ITER_{max}$, and a stop condition is that $ITER_{max}$ is reached or Polar Dec decoding succeeds. It may be understood that the decoding method shown in FIG. 11b is merely an example. For example, decoding of the retransmitted bit may also be completed through BP decoding, and then a soft value generated through BP decoding is sent to polar code decoding for decoding. If decoding fails and the maximum number of iterations is not reached, a soft value of polar code is output to BP decoding to generate a new soft value, and the new soft value is sent to polar code decoding. Once decoding succeeds or the maximum number of iterations $ITER_{max}$ is reached through decoding, the decoder can stop decoding. In addition, in the decoding method shown in this embodiment of this application, when a bit in an $(e+1)^{th}$ retransmission is decoded, results of previous e times of decoding may be reused (to be specific, the results of the previous e times of decoding are reused to assist in decoding in the $(e+1)^{th}$ retransmission). This improves decoding performance and reduces decoding complexity.

FIG. 11c is a schematic diagram of a retransmission method according to an embodiment of this application. For a specific description of the retransmission method, refer to the foregoing retransmission method. Details are not described herein again. As shown in FIG. 11c, as a number of retransmissions increases, an extended matrix and a Tanner graph corresponding to the extended matrix may be extended in a nested manner, to be specific, a Tanner graph (or an extended matrix) corresponding to an $i^{th}$ retransmission may be generated based on Tanner graphs (or extended matrices) of the first (i-1) retransmissions. Therefore, when information about a bit in an $i^{th}$ (i is a natural number greater than 0) transmission is decoded, results in processes of previous (i-1) times of decoding may be used. The results in the processes of the previous (i-1) times of decoding are stored, to reduce complexity required for $i^{th}$ decoding.

FIG. 12a is a schematic diagram of comparison between maximum decoding complexity and average decoding complexity according to this embodiment of this application. It may be understood that, in FIG. 12a, a horizontal axis indicates an SNR, and a vertical axis indicates a number of iterations (iterNum). The left of FIG. 12a shows a maximum number and an average number of iterations of the decoding method provided in this embodiment of this application in large iterative decoding by using an example in which an initial transmission bit rate R=0.5, N=1024, K=512, and E={0, 200, 400, 600, 800, 1000}. The right of FIG. 12a shows a maximum number and an average number of iterations of the decoding method provided in this embodiment of this application in large iterative decoding by using an example in which an initial transmission bit rate R=0.75, N=1024, K=768, and E={0, 200, 400, 600, 800, 1000}. It can be seen from FIG. 12a that, when the number E of retransmitted bits is given, the average number of iterations decreases rapidly as the SNR increases; and as the number E of retransmitted bits increases, a minimum number of iterations required for performance convergence shows an increasing trend. It may be understood that, in FIG. 12a, a used modulation scheme is quadrature phase shift keying (quadrature phase shift keying, QPSK) QPSK or additive white Gaussian noise (additive white Gaussian noise, AWGN).

The encoding method and the decoding method provided in this application have advantages of flexible code length extension of LDPC code and easy generation of the soft value when maintaining features of a strong polar code structure and high decoding efficiency, and effectively combine advantages of the LDPC code and NR polar code.

FIG. 12b to FIG. 12e each are a schematic diagram of performance comparison among a HARQ method, a CC-HARQ method, and an IR-HARQ method according to this embodiment of this application. It may be understood that, in FIG. 12b to FIG. 12e, the number of retransmitted bits ranges from 0 to 1000, the initial transmission code length N={1024, 992}, and the initial transmission bit rate R={0.5, 0.75}. For example, CA24-SCL8 decoding is used for decoding of a CC-HARQ and an IR-HARQ, the decoding procedure in FIG. 11a is used for HARQ decoding provided in this embodiment of this application, and the maximum number of iterations is 12. For example, natural (nature, NAT) ordering+Puncture+Gaussian approximation (Gaussian approximation, GA) is used for online construction of the CC-HARQ and the IR-HARQ, and an online construction procedure provided in the foregoing embodiment may be used for online construction of the HARQ method provided in this embodiment of this application. For example, a 5G NR offline sequence is used for offline construction of the CC-HARQ, bit reversal (bit reversal, BIV)+Shorten+polarization weight (polarization weight, PW) is used for offline construction of the IR-HARQ, and an optimized offline sequence in Table 1 or Table 2 is used for offline construction of the HARQ method provided in this embodiment of this application. The demodulation mode is QPSK.

It may be understood that FIG. 12b shows performance comparison in online construction under a same initial transmission code length and different initial transmission bit rates. FIG. 12c shows performance comparison in online construction under different initial transmission code lengths and a same initial transmission bit rate. FIG. 12d shows performance comparison in offline construction under a same initial transmission code length and different initial transmission bit rates. FIG. 12e shows performance comparison in offline construction under different initial transmission code lengths and a same initial transmission bit rate.

It can be learned from FIG. 12b to FIG. 12e that the HARQ method provided in this embodiment of this application is better than the CC-HARQ method. In addition, there is a relatively small difference between performance of the HARQ method provided in this embodiment of this application and performance of the IR-HARQ, and in some retransmission scenarios, the performance of the HARQ method is even better than performance of long code. The HARQ method provided in this embodiment of this application not only has a large coding gain, but also has better performance than the IR-HARQ in SC or CA-SCL8 decoding.

FIG. 13 is a schematic diagram of an encoding method and a decoding method according to an embodiment of this application. As shown in FIG. 13, a transmit end may perform first channel encoding on K information bits such as $u_1$, ..., $u_K$, to obtain a first bit sequence, for example, $c_1$, $c_2$, ..., $c_N$, then obtain a sequence $d_1$, $d_2$, ..., $d_N$ (for example, obtained based on an internal interleaver sequence) through internal interleaving, perform second channel encoding on the sequence $d_1$, $d_2$, ..., $d_N$ to obtain a second bit sequence, for example, $x_1$, $x_2$, ..., $x_N$, $x_{N+1}$, ..., $x_{N+E}$, and then modulate the second bit sequence to obtain a transmit sequence, for example, $s_1$, $s_2$, ..., $s_T$. It may be understood that first channel encoding and second channel encoding shown in FIG. 13 may be implemented by using different encoders, or first channel encoding and second channel encoding may be implemented by using one encoder. This is not limited in embodiments of this application. For example, first channel encoding, internal interleaving, and second channel encoding shown in FIG. 13 may also be referred to as encoding, as shown in a dashed line part in FIG. 13.

As shown in FIG. 13, a receive end obtains a receive sequence $r_1$, $r_2$, ..., $r_T$ through a channel, where T is a length of the receive sequence. It may be understood that FIG. 13 shows an example in which a length of the transmit sequence is the same as the length of the receive sequence. In specific implementation, the lengths of the transmit sequence and the receive sequence may be different. The receive end demodulates the receive sequence to obtain a second to-be-decoded sequence $y_1$, $y_2$, ..., $y_{N+E}$, and then performs second channel decoding and first channel decoding on the second to-be-decoded sequence $y_1$, $y_2$, ..., $y_{N+E}$ to obtain K information bits. Alternatively, the receive end demodulates and decodes the receive sequence to obtain K information bits. It may be understood that first channel decoding and second channel decoding in this embodiment of this application may be implemented by using one decoder, or first channel decoding and second channel decoding may be implemented by using different decoders. This is not limited in embodiments of this application. Alternatively, both demodulation and decoding may be implemented by using a same device. This is not limited in embodiments of this application.

In this embodiment of this application, polar code is used to generate a to-be-retransmitted bit, therefore obtaining better error correction performance than that obtained when NR polar code is used. E to-be-retransmitted bits of a HARQ are generated based on an extended matrix, so that a code length can be extended more flexibly, and a soft value can be generated more easily. In addition, when an estimated value of an information bit can be generated through large iterative decoding, a corresponding soft value can also be generated. Therefore, large iterative decoding is more suitable for a scenario such as multi-user detection on a data channel. In addition, the decoding scheme provided in this application has a feature of early stopping, and can effectively reduce a decoding delay and decoding complexity.

The following describes communication apparatuses provided in embodiments of this application.

In this application, the communication apparatus is divided into functional modules based on the foregoing method embodiments. For example, each functional module may be divided to each corresponding function, or two or more functions may be integrated into one processing module. The integrated module may be implemented in a form of hardware, or may be implemented in a form of a software functional module. It should be noted that, in this application, module division is an example, and is merely a logical function division. In actual implementation, another division manner may be used. The following describes in detail communication apparatuses in embodiments of this application with reference to FIG. 14 to FIG. 16.

FIG. 14 is a schematic diagram of a structure of a communication apparatus according to an embodiment of this application. As shown in FIG. 14, the communication apparatus includes a processing unit 1401 and a transceiver unit 1402.

In some embodiments of this application, the communication apparatus may be the transmit end, the chip in the transmit end, or the like described above. In other words, the communication apparatus may be configured to perform a step or a function performed by the transmit end in the method embodiments.

The processing unit 1401 is configured to obtain a first bit sequence and a number E of to-be-retransmitted bits, perform second channel encoding based on the first bit sequence to obtain a second bit sequence, and perform retransmission based on the second bit sequence.

It may be understood that, that the processing unit 1401 obtains the first bit sequence may further include: The processing unit 1401 performs data processing on to-be-processed data input by the transceiver unit 1402 to obtain the first bit sequence, or the processing unit 1401 obtains the first bit sequence by using the transceiver unit 1402. This is not limited in embodiments of this application.

In a possible implementation, the processing unit 1401 is specifically configured to perform second channel encoding based on the second bit sequence and an extended matrix.

In a possible implementation, the processing unit 1401 is specifically configured to perform first channel encoding on K information bits based on an internal interleaver sequence.

In this embodiment of this application, for descriptions of the first bit sequence, the second bit sequence, first channel encoding, second channel encoding, the extended matrix, an extended base matrix, a first reliability sequence, a second reliability sequence, and the like, refer to the foregoing method embodiments. Details are not described herein again. For example, for descriptions of the extended matrix and the extended base matrix, refer to FIG. 6a to FIG. 6d. For the first reliability sequence and the second reliability sequence, refer to FIG. 7a to FIG. 7d and the like.

It may be understood that specific descriptions of the transceiver unit and the processing unit described in this embodiment of this application are merely examples. For specific functions, performed steps, or the like of the transceiver unit and the processing unit, refer to the foregoing method embodiments. Details are not described herein again. For example, the processing unit 1401 may be further configured to perform steps, functions, or the like of generating the extended base matrix shown in FIG. 6c and FIG. 6d.

FIG. 14 is reused. In some other embodiments of this application, the communication apparatus may be the receive end, the chip in the receive end, or the like described above. In other words, the communication apparatus may be configured to perform a step or a function performed by the receive end in the method embodiments.

The processing unit 1401 is configured to: obtain a second to-be-decoded sequence, perform second channel decoding on the second to-be-decoded sequence based on an extended matrix to obtain a first to-be-decoded sequence, and perform first channel decoding on the first to-be-decoded sequence based on a first reliability sequence to obtain K information bits.

It may be understood that, that the processing unit 1401 is configured to obtain the second to-be-decoded sequence may be further understood as: The transceiver unit 1402 is configured to input to-be-processed data (for example, a receive sequence), and a logic circuit is configured to process the to-be-processed data to obtain the second to-be-decoded sequence; or the processing unit 1401 obtains the second to-be-decoded sequence from another apparatus, a component, or the like by using the transceiver unit 1402.

In a possible implementation, the processing unit 1401 is specifically configured to perform first channel decoding on the first to-be-decoded sequence based on the first reliability sequence and an internal interleaver sequence.

In this embodiment of this application, for descriptions of the first to-be-decoded sequence, the second to-be-decoded sequence, first channel encoding, second channel encoding, the extended matrix, the extended base matrix, the first reliability sequence, the second reliability sequence, and the like, refer to the foregoing method embodiments. Details are not described herein again. For example, for descriptions of the extended matrix and the extended base matrix, refer to FIG. 6a to FIG. 6d. For the first reliability sequence and the second reliability sequence, refer to FIG. 7a to FIG. 7d and the like.

It may be understood that specific descriptions of the transceiver unit and the processing unit described in this embodiment of this application are merely examples. For specific functions, performed steps, or the like of the transceiver unit and the processing unit, refer to the foregoing method embodiments. Details are not described herein again. For example, the processing unit 1401 may be further configured to perform steps, functions, or the like of the decoding methods shown in FIG. 11a and FIG. 11b.

The foregoing describes the transmit end and the receive end in embodiments of this application. The following describes possible product forms of the transmit end and the receive end. It should be understood that a product in any form that has the functions of the transmit end in FIG. 14 and a product in any form that has the functions of the receive end in FIG. 14 fall within the protection scope of embodiments of this application. It should further be understood that the following descriptions are merely examples, and do not limit product forms of the transmit end and the receive end in embodiments of this application.

In a possible implementation, in the communication apparatus shown in FIG. 14, the processing unit 1401 may be one or more processors. The transceiver unit 1402 may be a transceiver, or the transceiver unit 1402 may be a sending unit and a receiving unit. The sending unit may be a transmitter, and the receiving unit may be a receiver. The sending unit and the receiving unit are integrated into one device, for example, a transceiver. In this embodiment of this application, the processor and the transceiver may be coupled, or the like. A manner of connection between the processor and the transceiver is not limited in embodiments of this application.

As shown in FIG. 15, a communication apparatus 150 includes one or more processors 1520 and a transceiver 1510.

For example, when the communication apparatus is configured to perform the foregoing step, method, or function performed by the transmit end, the processor 1520 is configured to obtain a first bit sequence and a number E of to-be-retransmitted bits, perform second channel encoding on the first bit sequence to obtain a second bit sequence, and perform retransmission based on the second bit sequence.

For example, when the communication apparatus is configured to perform the foregoing step, method, or function performed by the receive end, the processor 1520 is configured to obtain a second to-be-decoded sequence, perform second channel decoding on the second to-be-decoded sequence based on an extended matrix to obtain a first to-be-decoded sequence, and perform first channel decoding on the first to-be-decoded sequence based on a first reliability sequence to obtain K information bits.

In this embodiment of this application, for descriptions of the first to-be-decoded sequence, the second to-be-decoded sequence, first channel encoding, second channel encoding, the extended matrix, an extended base matrix, the first reliability sequence, a second reliability sequence, and the like, refer to the foregoing method embodiments. Details are not described herein again.

It may be understood that, for specific descriptions of the processor and the transceiver, refer to the descriptions of the processing unit and the transceiver unit shown in FIG. 14. Details are not described herein again.

In each implementation of the communication apparatus shown in FIG. 15, the transceiver may include a receiver and a transmitter. The receiver is configured to perform a receiving function (or operation), and the transmitter is configured to perform a transmitting function (or operation). The transceiver is configured to communicate with another device/apparatus through a transmission medium.

Optionally, the communication apparatus 150 may further include one or more memories 1530, configured to store program instructions and/or data. The memory 1530 is coupled to the processor 1520. Coupling in this embodiment of this application may be indirect coupling or a communication connection between apparatuses, units, or modules, may be in an electrical form, a mechanical form, or another form, and is used for information exchange between the apparatuses, the units, or the modules. The processor 1520 may cooperate with the memory 1530. The processor 1520 may execute the program instructions stored in the memory 1530. Optionally, at least one of the one or more memories may be included in the processor. In this embodiment of this application, the memory 1530 may store any one or more of the extended base matrix, the second reliability sequence, or the like. For example, the memory shown in FIG. 15 shows only an example of the extended base matrix, the second reliability sequence, and the like. It may be understood that, in FIG. 15, dashed lines indicate that the memory stores the extended base matrix and the second reliability sequence because the memory may store the extended base matrix and the second reliability sequence, may store only the extended base matrix, or may not store the extended base matrix and the second reliability sequence.

A specific connection medium between the transceiver 1510, the processor 1520, and the memory 1530 is not limited in embodiments of this application. In this embodiment of this application, in FIG. 15, the memory 1530, the processor 1520, and the transceiver 1510 are connected to each other through a bus 1540. The bus is indicated by a thick line in FIG. 15. A manner of connection between other components is merely described as an example, but is not limited thereto. The bus may be classified into an address bus, a data bus, a control bus, and the like. For ease of representation, only one thick line indicates the bus in FIG. 15, but this does not mean that there is only one bus or only one type of bus.

In this embodiment of this application, the processor may be a general-purpose processor, a digital signal processor, an application-specific integrated circuit, a field-programmable gate array or another programmable logic device, a discrete gate or transistor logic device, a discrete hardware component, or the like. The processor can implement or execute the methods, the steps, and the logical block diagrams disclosed in embodiments of this application. The general-purpose processor may be a microprocessor, any conventional processor or the like. The steps of the methods disclosed with reference to embodiments of this application may be directly performed and accomplished by a hardware processor, or may be performed and accomplished by using a combination of hardware and software modules in the processor.

In this embodiment of this application, the memory may include but is not limited to a nonvolatile memory, for example, a hard disk drive (hard disk drive, HDD) or a solid-state drive (solid-state drive, SSD), a random access memory (Random Access Memory, RAM), an erasable programmable read-only memory (Erasable Programmable ROM, EPROM), a read-only memory (Read-Only Memory, ROM), or a compact disc read-only memory (Compact Disc Read-Only Memory, CD-ROM). The memory is any storage medium that can be used to carry or store program code in a form of an instruction or a data structure and that can be read and/or written by a computer (for example, the communication apparatus described in this application), but is not limited thereto. The memory in embodiments of this application may alternatively be a circuit or any other apparatus that can implement a storage function, and is configured to store the program instructions and/or the data.

The processor 1520 is mainly configured to process a communication protocol and communication data, control the entire communication apparatus, execute a software program, and process data of the software program. The memory 1530 is mainly configured to store the software program and data. The transceiver 1510 may include a control circuit and an antenna. The control circuit is mainly configured to: perform conversion between a baseband signal and a radio frequency signal, and process the radio frequency signal. The antenna is mainly configured to receive and send the radio frequency signal in a form of an electromagnetic wave. The input/output apparatus, for example, a touchscreen, a display, or a keyboard, is mainly configured to: receive data input by a user and output data to the user.

After the communication apparatus is powered on, the processor 1520 may read the software program in the memory 1530, interpret and execute instructions of the software program, and process data of the software program. When data needs to be sent wirelessly, the processor 1520 performs baseband processing on the to-be-sent data, and then outputs a baseband signal to a radio frequency circuit. The radio frequency circuit performs radio frequency processing on the baseband signal, and then sends a radio frequency signal in a form of an electromagnetic wave through the antenna. When data is sent to the communication apparatus, the radio frequency circuit receives the radio frequency signal through the antenna, converts the radio frequency signal into a baseband signal, and outputs the baseband signal to the processor 1520. The processor 1520 converts the baseband signal into data and processes the data.

In another implementation, the radio frequency circuit and the antenna may be disposed independently of the processor that performs baseband processing. For example, in a distributed scenario, the radio frequency circuit and the antenna may be disposed remotely and independently of the communication apparatus.

It may be understood that the communication apparatus described in this embodiment of this application may further include more components or the like than those shown in FIG. 15. This is not limited in embodiments of this application. The foregoing methods performed by the processor and the transceiver are merely examples. For specific steps performed by the processor and the transceiver, refer to the methods described above.

In another possible implementation, in the communication apparatus shown in FIG. 14, the processing unit 1401 may be one or more logic circuits, and the transceiver unit 1402 may be an input/output interface, which is also referred to as a communication interface, an interface circuit, an interface, or the like. Alternatively, the transceiver unit 1402 may be a sending unit and a receiving unit. The sending unit may be an output interface, and the receiving unit may be an input interface. The sending unit and the receiving unit are integrated into one unit, for example, an input/output interface. As shown in FIG. 16, a communication apparatus shown in FIG. 16 includes a logic circuit 1601 and an interface 1602. In other words, the processing unit 1401 may be implemented by the logic circuit 1601, and the transceiver unit 1402 may be implemented through the interface 1602. The logic circuit 1601 may be a chip, a processing circuit, an integrated circuit, a system on chip (system on chip, SoC), or the like. The interface 1602 may be a communication interface, an input/output interface, a pin, or the like. For example, FIG. 16 is an example in which the communication apparatus is a chip. The chip includes the logic circuit 1601 and the interface 1602.

In this embodiment of this application, the logic circuit and the interface may be further coupled to each other. A specific manner of connection between the logical circuit and the interface is not limited in embodiments of this application.

For example, when the communication apparatus is configured to perform the foregoing method, function, or step performed by the transmit end, the logic circuit 1601 is configured to obtain a first bit sequence and a number E of to-be-retransmitted bits, and the logic circuit 1601 is further configured to perform second channel encoding on the first bit sequence to obtain a second bit sequence, and perform retransmission based on the second bit sequence.

It may be understood that the logic circuit 1601 described above is configured to obtain the first bit sequence. It may be further understood that the logic circuit 1601 is configured to input to-be-processed data through the interface 1602, and process the to-be-processed data to obtain the first bit sequence. The first bit sequence may be input into the logic circuit from another apparatus or component through the interface, or may be obtained after the logic circuit processes other data input through the interface. This is not limited in embodiments of this application. It may be understood that the interface described above is further configured to output a sequence obtained by processing the second bit sequence, and the like.

For example, when the communication apparatus is configured to perform the foregoing method, function, or step performed by the receive end, the logic circuit 1601 is configured to obtain a second to-be-decoded sequence, perform second channel decoding on the second to-be-decoded sequence based on an extended matrix to obtain a first to-be-decoded sequence, and perform first channel decoding on the first to-be-decoded sequence based on the first reliability sequence to obtain K information bits.

It may be understood that the logic circuit 1601 described above is configured to obtain the second to-be-decoded sequence. It may be further understood that the interface 1602 is configured to input to-be-processed data (for example, a receive sequence obtained through a channel), and the logic circuit 1601 is configured to process the to-be-processed data input through the interface 1602, to obtain the second to-be-decoded sequence; or the logic circuit 1601 is configured to input the second to-be-decoded sequence or the like through the interface 1602.

Optionally, the communication apparatus further includes a memory 1603, and the memory 1603 may be configured to store one or more of an extended base matrix or a second reliability sequence.

It may be understood that the communication apparatus described in this embodiment of this application may implement the method provided in embodiments of this application in a form of hardware or in a form of software. This is not limited in embodiments of this application.

For descriptions of the first to-be-decoded sequence, the second to-be-decoded sequence, first channel encoding, second channel encoding, the extended matrix, the extended base matrix, the first reliability sequence, the second reliability sequence, and the like, refer to the foregoing method embodiments. Details are not described herein again.

For specific implementations of embodiments shown in FIG. 16, refer to the foregoing embodiments. Details are not described herein again.

An embodiment of this application further provides a wireless communication system. The wireless communication system includes a transmit end and a receive end. The transmit end and the receive end may be configured to perform the method in any of the foregoing embodiments.

In addition, this application further provides a computer program. The computer program is used to implement an operation and/or processing performed by the transmit end in the method provided in this application.

This application further provides a computer program. The computer program is used to implement an operation and/or processing performed by the receive end in the method provided in this application.

This application further provides a computer-readable storage medium. The computer-readable storage medium stores computer code. When the computer code is run on a computer, the computer is enabled to perform an operation and/or processing performed by the transmit end in the method provided in this application.

This application further provides a computer-readable storage medium. The computer-readable storage medium stores computer code. When the computer code is run on a computer, the computer is enabled to perform an operation and/or processing performed by the receive end in the method provided in this application.

This application further provides a computer program product. The computer program product includes computer code or a computer program. When the computer code or the computer program is run on a computer, an operation and/or processing performed by the transmit end in the method provided in this application are/is performed.

This application further provides a computer program product. The computer program product includes computer code or a computer program. When the computer code or the computer program is run on a computer, an operation and/or processing performed by the receive end in the method provided in this application are/is performed.

In the several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces, indirect couplings or communication connections between the apparatuses or units, or electrical connections, mechanical connections, or connections in other forms.

The units described as separate parts may or may not be physically separate, and parts displayed as units may or may not be physical units, may be located at one location, or may be distributed on a plurality of network units. Some or all of the units may be selected based on an actual requirement to implement the technical effects of the solutions provided in embodiments of this application.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technologies, or all or some of the technical solutions may be implemented in a form of a software product. The computer software product is stored in a readable storage medium and includes a plurality of instructions for instructing a computer device (which may be a personal computer, a server, or a network device) to perform all or some of the steps of the methods described in embodiments of this application. The readable storage medium includes any medium that can store program code, such as a USB flash drive, a removable hard disk drive, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

**1.** A retransmission method, wherein the method comprises:

obtaining a first bit sequence and a number E of to-be-retransmitted bits, wherein the first bit sequence is obtained by performing first channel encoding based on K information bits, a length of the first bit sequence is N, and N, E, and K are all integers greater than or equal to 1;
performing second channel encoding based on the first bit sequence to obtain a second bit sequence, wherein the second bit sequence comprises the E to-be-retransmitted bits; and
performing retransmission based on the second bit sequence.

**2.** The method according to claim 1, wherein the performing second channel encoding based on the first bit sequence comprises:
performing second channel encoding based on the first bit sequence and an extended matrix, wherein the extended matrix comprises E rows and N columns, the extended matrix is obtained based on an extended base matrix, the extended base matrix comprises $E_0$ rows and $N_0$ columns, and both $E_0$ and $N_0$ are integers greater than or equal to 1.

**3.** The method according to claim 2, wherein a lifting size Z of the extended base matrix is a prime number; or $Z=2^n$, Z is a lifting size of the extended base matrix, and n is an integer greater than or equal to 0.

**4.** The method according to claim 2 or 3, wherein $Z=N/N_0$, and Z is the lifting size of the extended base matrix.

**5.** The method according to claim 3 or 4, wherein Z=16.

**6.** The method according to any one of claims 2 to 5, wherein the E rows of the extended matrix are the first E rows of a first matrix, and the first matrix is a matrix obtained by extending the extended base matrix based on a lifting size; or the E rows of the extended matrix are E adjacent rows of a first matrix, the E adjacent rows of the first matrix are determined based on a bit rate of first channel encoding, and the first matrix is a matrix obtained by extending the extended base matrix based on a lifting size.

**7.** The method according to any one of claims 2 to 6, wherein a row weight of a row of the extended matrix is related to N, K, and E.

**8.** The method according to claim 7, wherein the row weight of the row of the extended matrix meets any one or more of the following relationships:
the row weight is negatively correlated with E, the row weight is positively correlated with K, the row weight is negatively correlated with N, and the row weight is positively correlated with K/N.

**9.** The method according to any one of claims 1 to 8, wherein locations of the K information bits are determined based on a first reliability sequence, a length of the first reliability sequence is N, the first reliability sequence is a subsequence of a second reliability sequence, a length of the second reliability sequence is $N_{max}$, and $N_{max}$ is greater than or equal to N.

**10.** The method according to claim 9, wherein the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N_{max}}$ indicates a reliability sequence, an element is a sequence number of a subchannel, $W(Q_i^{N_{max}})$ indicates reliability corresponding to the reliability sequence, and i is an integer greater than or equal to 1 and less than or equal to $N_{max}$.

**11.** The method according to any one of claims 2 to 10, wherein that the first bit sequence is obtained by performing first channel encoding based on the K information bits comprises:
the first bit sequence is obtained by performing first channel encoding based on the K information bits and an internal interleaver sequence, wherein a size of a block of the internal interleaver sequence is equal to the lifting size of the extended matrix.

**12.** The method according to any one of claims 1 to 11, wherein the performing retransmission based on the second bit sequence comprises:

determining an initial transmission start point of a cyclic buffer based on N and K;
determining a retransmission start point of the cyclic buffer based on the initial transmission start point and N, or determining a retransmission start point of the cyclic buffer based on the initial transmission start point and E; and
performing retransmission based on the second bit sequence and the retransmission start point.

**13.** A retransmission method, wherein the method comprises:

obtaining a second to-be-decoded sequence, wherein the second to-be-decoded sequence comprises information about E retransmitted bits, and E is an integer greater than or equal to 1;
performing second channel decoding on the second to-be-decoded sequence based on an extended matrix to obtain a first to-be-decoded sequence, wherein the extended matrix comprises E rows and N columns, the extended matrix is obtained based on an extended base matrix, the extended base matrix comprises $E_0$ rows and $N_0$ columns, the first to-be-decoded sequence comprises information about N bits, and both $E_0$ and $N_0$ are integers greater than or equal to 1; and
performing first channel decoding on the first to-be-decoded sequence based on a first reliability sequence to obtain K information bits, wherein a length of the first reliability sequence is N, the first reliability sequence is a subsequence of a second reliability sequence, a length of the second reliability sequence is $N_{max}$, $N_{max}$ is greater than or equal to N, and K is an integer greater than or equal to 1.

**14.** The method according to claim 13, wherein a lifting size Z of the extended base matrix is a prime number; or $Z=2^n$, Z is a lifting size of the extended base matrix, and n is an integer greater than or equal to 0.

**15.** The method according to claim 13 or 14, wherein $Z=N/N_0$, and Z is the lifting size of the extended base matrix.

**16.** The method according to claim 14 or 15, wherein Z=16.

**17.** The method according to any one of claims 13 to 16, wherein the E rows of the extended matrix are the first E rows of a first matrix, and the first matrix is a matrix obtained by extending the extended base matrix based on a lifting size; or the E rows of the extended matrix are E adjacent rows of a first matrix, the E adjacent rows of the first matrix are determined based on a bit rate of first channel encoding, and the first matrix is a matrix obtained by extending the extended base matrix based on a lifting size.

**18.** The method according to any one of claims 13 to 17, wherein a row weight of a row of the extended matrix is related to N, K, and E.

**19.** The method according to claim 18, wherein the row weight of the row of the extended matrix meets any one or more of the following relationships:
the row weight is negatively correlated with E, the row weight is positively correlated with K, the row weight is negatively correlated with N, and the row weight is positively correlated with K/N.

**20.** The method according to any one of claims 13 to 19, wherein the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N_{max}}$ indicates a reliability sequence, an element is a sequence number of a subchannel, $W(Q_i^{N_{max}})$ indicates reliability corresponding to the reliability sequence, and i is an integer greater than or equal to 1 and less than or equal to $N_{max}$.

**21.** The method according to any one of claims 13 to 20, wherein the performing first channel decoding on the first to-be-decoded sequence based on a first reliability sequence comprises: performing first channel decoding on the first to-be-decoded sequence based on the first reliability sequence and an internal interleaver sequence, wherein the internal interleaver sequence is determined based on the extended matrix, and a size of a block of the internal interleaver sequence is equal to the lifting size of the extended matrix.

**22.** A communication apparatus, comprising:

a processing unit, configured to obtain a first bit sequence and a number E of to-be-retransmitted bits, wherein the first bit sequence is obtained by performing first channel encoding based on K information bits, a length of the first bit sequence is N, and N, E, and K are all integers greater than or equal to 1;
the processing unit is further configured to perform second channel encoding based on the first bit sequence to obtain a second bit sequence, wherein the second bit sequence comprises the E to-be-retransmitted bits; and the processing unit is further configured to perform retransmission based on the second bit sequence.

**23.** The apparatus according to claim 22, wherein performing second channel encoding based on the first bit sequence comprises: performing second channel encoding based on the first bit sequence and an extended matrix, wherein the extended matrix comprises E rows and N columns, the extended matrix is obtained based on an extended base matrix, the extended base matrix comprises $E_0$ rows and $N_0$ columns, and both $E_0$ and $N_0$ are integers greater than or equal to 1.

**24.** The apparatus according to claim 23, wherein a lifting size Z of the extended base matrix is a prime number; or $Z=2^n$, Z is a lifting size of the extended base matrix, and n is an integer greater than or equal to 0.

**25.** The apparatus according to claim 23 or 24, wherein $Z=N/N_0$, and Z is the lifting size of the extended base matrix.

**26.** The apparatus according to claim 24 or 25, wherein Z=16.

**27.** The apparatus according to any one of claims 23 to 26, wherein the E rows of the extended matrix are the first E rows of a first matrix, and the first matrix is a matrix obtained by extending the extended base matrix based on a lifting size; or
the E rows of the extended matrix are E adjacent rows of a first matrix, the E adjacent rows of the first matrix are determined based on a bit rate of first channel encoding, and the first matrix is a matrix obtained by extending the extended base matrix based on a lifting size.

**28.** The apparatus according to any one of claims 23 to 27, wherein a row weight of a row of the extended matrix is related to N, K, and E.

**29.** The apparatus according to claim 28, wherein the row weight of the row of the extended matrix meets any one or more of the following relationships:
the row weight is negatively correlated with E, the row weight is positively correlated with K, the row weight is negatively correlated with N, and the row weight is positively correlated with K/N.

**30.** The apparatus according to any one of claims 22 to 29, wherein locations of the K information bits are determined based on a first reliability sequence, a length of the first reliability sequence is N, the first reliability sequence is a subsequence of a second reliability sequence, a length of the second reliability sequence is $N_{max}$, and $N_{max}$ is greater than or equal to N.

**31.** The apparatus according to claim 30, wherein the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N_{max}}$ indicates a reliability sequence, an element is a sequence number of a subchannel, $W(Q_i^{N_{max}})$ indicates reliability corresponding to the reliability sequence, and i is an integer greater than or equal to 1 and less than or equal to $N_{max}$.

**32.** The apparatus according to any one of claims 23 to 31, wherein that the first bit sequence is obtained by performing first channel encoding based on the K information bits comprises:
the first bit sequence is obtained by performing first channel encoding based on the K information bits and an internal interleaver sequence, wherein a size of a block of the internal interleaver sequence is equal to the lifting size of the extended matrix.

**33.** The apparatus according to any one of claims 22 to 32, wherein the processing unit is specifically configured to determine an initial transmission start point of a cyclic buffer based on N and K;

determining a retransmission start point of the cyclic buffer based on the initial transmission start point and N, or determining a retransmission start point of the cyclic buffer based on the initial transmission start point and E; and
performing retransmission based on the second bit sequence and the retransmission start point.

**34.** A communication apparatus, comprising:

a processing unit, configured to obtain a second to-be-decoded sequence, wherein the second to-be-decoded sequence comprises information about E retransmitted bits, and E is an integer greater than or equal to 1;
the processing unit is further configured to perform second channel decoding on the second to-be-decoded sequence based on an extended matrix to obtain a first to-be-decoded sequence, wherein the extended matrix comprises E rows and N columns, the extended matrix is obtained based on an extended base matrix, the extended base matrix comprises $E_0$ rows and $N_0$ columns, the first to-be-decoded sequence comprises information about N bits, and both $E_0$ and $N_0$ are integers greater than or equal to 1; and
the processing unit is further configured to perform first channel decoding on the first to-be-decoded sequence based on a first reliability sequence to obtain K information bits, wherein a length of the first reliability sequence is N, the first reliability sequence is a subsequence of a second reliability sequence, a length of the second reliability sequence is $N_{max}$, $N_{max}$ is greater than or equal to N, and K is an integer greater than or equal to 1.

**35.** The apparatus according to claim 34, wherein a lifting size Z of the extended base matrix is a prime number; or $Z=2^n$, Z is a lifting size of the extended base matrix, and n is an integer greater than or equal to 0.

**36.** The apparatus according to claim 34 or 35, wherein $Z=N/N_0$, and Z is the lifting size of the extended base matrix.

**37.** The apparatus according to claim 35 or 36, wherein Z=16.

**38.** The apparatus according to any one of claims 34 to 37, wherein the E rows of the extended matrix are the first E rows of a first matrix, and the first matrix is a matrix obtained by extending the extended base matrix based on a lifting size; or
the E rows of the extended matrix are E adjacent rows of a first matrix, the E adjacent rows of the first matrix are determined based on a bit rate of first channel encoding, and the first matrix is a matrix obtained by extending the extended base matrix based on a lifting size.

**39.** The apparatus according to any one of claims 34 to 38, wherein a row weight of a row of the extended matrix is related to N, K, and E.

**40.** The apparatus according to claim 39, wherein the row weight of the row of the extended matrix meets any one or more of the following relationships:
the row weight is negatively correlated with E, the row weight is positively correlated with K, the row weight is negatively correlated with N, and the row weight is positively correlated with K/N.

**41.** The apparatus according to any one of claims 34 to 40, wherein the second reliability sequence meets the following relationship:

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 1 | 1 | 129 | 59 | 257 | 326 | 385 | 214 | 513 | 316 | 641 | 374 | 769 | 695 | 897 | 862 |
| 2 | 2 | 130 | 86 | 258 | 581 | 386 | 309 | 514 | 789 | 642 | 722 | 770 | 792 | 898 | 863 |
| 3 | 3 | 131 | 136 | 259 | 111 | 387 | 188 | 515 | 128 | 643 | 794 | 771 | 505 | 899 | 864 |
| 4 | 4 | 132 | 545 | 260 | 353 | 388 | 449 | 516 | 423 | 644 | 717 | 772 | 698 | 900 | 868 |
| 5 | 5 | 133 | 277 | 261 | 534 | 389 | 217 | 517 | 413 | 645 | 415 | 773 | 416 | 901 | 870 |
| 6 | 6 | 134 | 87 | 262 | 272 | 390 | 408 | 518 | 236 | 646 | 375 | 774 | 718 | 902 | 871 |
| 7 | 7 | 135 | 140 | 263 | 642 | 391 | 609 | 519 | 452 | 647 | 723 | 775 | 699 | 903 | 872 |
| 8 | 8 | 136 | 516 | 264 | 172 | 392 | 596 | 520 | 803 | 648 | 795 | 776 | 719 | 904 | 874 |
| 9 | 9 | 137 | 197 | 265 | 306 | 393 | 551 | 521 | 599 | 649 | 806 | 777 | 376 | 905 | 875 |
| 10 | 10 | 138 | 61 | 266 | 561 | 394 | 650 | 522 | 373 | 650 | 378 | 778 | 701 | 906 | 876 |
| 11 | 11 | 139 | 385 | 267 | 118 | 395 | 229 | 523 | 721 | 651 | 738 | 779 | 724 | 907 | 877 |
| 12 | 12 | 140 | 290 | 268 | 159 | 396 | 159 | 524 | 612 | 652 | 725 | 780 | 796 | 908 | 878 |
| 13 | 13 | 141 | 100 | 269 | 226 | 397 | 420 | 525 | 793 | 653 | 797 | 781 | 380 | 909 | 879 |
| 14 | 17 | 142 | 90 | 270 | 327 | 398 | 310 | 526 | 426 | 654 | 428 | 782 | 726 | 910 | 880 |
| 15 | 18 | 143 | 142 | 271 | 301 | 399 | 541 | 527 | 654 | 655 | 807 | 783 | 727 | 911 | 882 |
| 16 | 19 | 144 | 518 | 272 | 213 | 400 | 773 | 528 | 602 | 656 | 379 | 784 | 798 | 912 | 883 |
| 17 | 21 | 145 | 177 | 273 | 535 | 401 | 610 | 529 | 318 | 657 | 656 | 785 | 799 | 913 | 884 |
| 18 | 25 | 146 | 291 | 274 | 401 | 402 | 657 | 530 | 834 | 658 | 604 | 786 | 808 | 914 | 885 |
| 19 | 33 | 147 | 102 | 275 | 548 | 403 | 333 | 531 | 805 | 659 | 739 | 787 | 256 | 915 | 886 |
| 20 | 34 | 148 | 91 | 276 | 330 | 404 | 119 | 532 | 377 | 660 | 320 | 788 | 382 | 916 | 887 |
| 21 | 35 | 149 | 148 | 277 | 643 | 405 | 600 | 533 | 737 | 661 | 729 | 789 | 383 | 917 | 888 |
| 22 | 37 | 150 | 143 | 278 | 585 | 406 | 339 | 534 | 427 | 662 | 836 | 790 | 384 | 918 | 889 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 23 | 41 | 151 | 519 | 279 | 307 | 407 | 218 | 535 | 238 | 663 | 810 | 791 | 432 | 919 | 890 |
| 24 | 49 | 152 | 281 | 280 | 280 | 408 | 368 | 536 | 344 | 664 | 381 | 792 | 440 | 920 | 891 |
| 25 | 65 | 153 | 201 | 281 | 174 | 409 | 652 | 537 | 454 | 665 | 741 | 793 | 444 | 921 | 892 |
| 26 | 66 | 154 | 103 | 282 | 119 | 410 | 230 | 538 | 655 | 666 | 430 | 794 | 446 | 922 | 893 |
| 27 | 67 | 155 | 522 | 283 | 538 | 411 | 391 | 539 | 603 | 667 | 240 | 795 | 447 | 923 | 894 |
| 28 | 69 | 156 | 150 | 284 | 200 | 412 | 313 | 540 | 660 | 668 | 811 | 796 | 448 | 924 | 895 |
| 29 | 73 | 157 | 293 | 285 | 64 | 413 | 450 | 541 | 319 | 669 | 456 | 797 | 464 | 925 | 896 |
| 30 | 81 | 158 | 106 | 286 | 388 | 414 | 542 | 542 | 614 | 670 | 606 | 798 | 472 | 926 | 904 |
| 31 | 97 | 159 | 93 | 287 | 227 | 415 | 334 | 543 | 835 | 671 | 616 | 799 | 476 | 927 | 908 |
| 32 | 129 | 160 | 523 | 288 | 122 | 416 | 233 | 544 | 809 | 672 | 745 | 800 | 478 | 928 | 910 |
| 33 | 130 | 161 | 151 | 289 | 180 | 417 | 555 | 545 | 434 | 673 | 838 | 801 | 479 | 929 | 911 |
| 34 | 131 | 162 | 577 | 290 | 550 | 418 | 774 | 546 | 429 | 674 | 431 | 802 | 480 | 930 | 912 |
| 35 | 133 | 163 | 32 | 291 | 331 | 419 | 175 | 547 | 239 | 675 | 818 | 803 | 488 | 931 | 916 |
| 36 | 137 | 164 | 164 | 292 | 217 | 420 | 123 | 548 | 244 | 676 | 813 | 804 | 492 | 932 | 918 |
| 37 | 257 | 165 | 264 | 293 | 175 | 421 | 658 | 549 | 455 | 677 | 436 | 805 | 494 | 933 | 919 |
| 38 | 513 | 166 | 107 | 294 | 539 | 422 | 612 | 550 | 560 | 678 | 607 | 806 | 495 | 934 | 920 |
| 39 | 145 | 167 | 154 | 295 | 645 | 423 | 341 | 551 | 605 | 679 | 753 | 807 | 496 | 935 | 922 |
| 40 | 14 | 168 | 322 | 296 | 284 | 424 | 777 | 552 | 898 | 680 | 839 | 808 | 500 | 936 | 923 |
| 41 | 15 | 169 | 530 | 297 | 309 | 425 | 220 | 553 | 615 | 681 | 819 | 809 | 502 | 937 | 924 |
| 42 | 20 | 170 | 48 | 298 | 390 | 426 | 314 | 554 | 837 | 682 | 900 | 810 | 503 | 938 | 925 |
| 43 | 22 | 171 | 166 | 299 | 204 | 427 | 424 | 555 | 817 | 683 | 842 | 811 | 504 | 939 | 926 |
| 44 | 23 | 172 | 525 | 300 | 417 | 428 | 395 | 556 | 435 | 684 | 821 | 812 | 506 | 940 | 927 |
| 45 | 26 | 173 | 268 | 301 | 123 | 429 | 673 | 557 | 458 | 685 | 438 | 813 | 507 | 941 | 928 |
| 46 | 27 | 174 | 297 | 302 | 593 | 430 | 583 | 558 | 662 | 686 | 460 | 814 | 508 | 942 | 932 |
| 47 | 36 | 175 | 209 | 303 | 229 | 431 | 355 | 559 | 618 | 687 | 664 | 815 | 509 | 943 | 934 |
| 48 | 258 | 176 | 155 | 304 | 338 | 432 | 287 | 560 | 899 | 688 | 843 | 816 | 510 | 944 | 935 |
| 49 | 38 | 177 | 114 | 305 | 182 | 433 | 183 | 561 | 400 | 689 | 620 | 817 | 511 | 945 | 936 |
| 50 | 259 | 178 | 323 | 306 | 551 | 434 | 234 | 562 | 841 | 690 | 825 | 818 | 512 | 946 | 938 |
| 51 | 39 | 179 | 109 | 307 | 296 | 435 | 125 | 563 | 776 | 691 | 439 | 819 | 608 | 947 | 939 |
| 52 | 29 | 180 | 531 | 308 | 96 | 436 | 557 | 564 | 348 | 692 | 902 | 820 | 624 | 948 | 940 |
| 53 | 161 | 181 | 56 | 309 | 333 | 437 | 660 | 565 | 437 | 693 | 850 | 821 | 632 | 949 | 941 |
| 54 | 42 | 182 | 167 | 310 | 580 | 438 | 616 | 566 | 246 | 694 | 845 | 822 | 636 | 950 | 942 |
| 55 | 261 | 183 | 270 | 311 | 554 | 439 | 342 | 567 | 459 | 695 | 442 | 823 | 638 | 951 | 943 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 56 | 43 | 184 | 115 | 312 | 541 | 440 | 316 | 568 | 663 | 696 | 248 | 824 | 639 | 952 | 944 |
| 57 | 45 | 185 | 170 | 313 | 286 | 441 | 241 | 569 | 619 | 697 | 903 | 825 | 640 | 953 | 946 |
| 58 | 68 | 186 | 157 | 314 | 391 | 442 | 778 | 570 | 192 | 698 | 462 | 826 | 672 | 954 | 947 |
| 59 | 50 | 187 | 80 | 315 | 206 | 443 | 563 | 571 | 676 | 699 | 851 | 827 | 688 | 955 | 948 |
| 60 | 265 | 188 | 276 | 316 | 649 | 444 | 345 | 572 | 901 | 700 | 622 | 828 | 696 | 956 | 949 |
| 61 | 70 | 189 | 325 | 317 | 313 | 445 | 452 | 573 | 849 | 701 | 443 | 829 | 700 | 957 | 950 |
| 62 | 51 | 190 | 196 | 318 | 339 | 446 | 397 | 574 | 441 | 702 | 906 | 830 | 702 | 958 | 951 |
| 63 | 71 | 191 | 60 | 319 | 183 | 447 | 403 | 575 | 247 | 703 | 463 | 831 | 703 | 959 | 952 |
| 64 | 74 | 192 | 533 | 320 | 125 | 448 | 207 | 576 | 466 | 704 | 866 | 832 | 704 | 960 | 953 |
| 65 | 53 | 193 | 271 | 321 | 394 | 449 | 674 | 577 | 666 | 705 | 853 | 833 | 720 | 961 | 954 |
| 66 | 75 | 194 | 546 | 322 | 770 | 450 | 558 | 578 | 626 | 706 | 623 | 834 | 728 | 962 | 955 |
| 67 | 77 | 195 | 641 | 323 | 233 | 451 | 785 | 579 | 461 | 707 | 468 | 835 | 730 | 963 | 956 |
| 68 | 273 | 196 | 171 | 324 | 528 | 452 | 432 | 580 | 360 | 708 | 668 | 836 | 731 | 964 | 957 |
| 69 | 82 | 197 | 305 | 325 | 300 | 453 | 357 | 581 | 621 | 709 | 445 | 837 | 732 | 965 | 958 |
| 70 | 193 | 198 | 117 | 326 | 449 | 454 | 187 | 582 | 350 | 710 | 907 | 838 | 733 | 966 | 959 |
| 71 | 57 | 199 | 278 | 327 | 212 | 455 | 236 | 583 | 905 | 711 | 628 | 839 | 734 | 967 | 960 |
| 72 | 83 | 200 | 88 | 328 | 186 | 456 | 664 | 584 | 250 | 712 | 867 | 840 | 735 | 968 | 964 |
| 73 | 132 | 201 | 225 | 329 | 609 | 457 | 624 | 585 | 865 | 713 | 857 | 841 | 736 | 969 | 966 |
| 74 | 134 | 202 | 198 | 330 | 555 | 458 | 587 | 586 | 467 | 714 | 352 | 842 | 740 | 970 | 967 |
| 75 | 85 | 203 | 62 | 331 | 287 | 459 | 780 | 587 | 667 | 715 | 914 | 843 | 742 | 971 | 968 |
| 76 | 135 | 204 | 386 | 332 | 582 | 460 | 705 | 588 | 627 | 716 | 909 | 844 | 743 | 972 | 970 |
| 77 | 138 | 205 | 547 | 333 | 112 | 461 | 126 | 589 | 678 | 717 | 252 | 845 | 744 | 973 | 971 |
| 78 | 514 | 206 | 178 | 334 | 207 | 462 | 242 | 590 | 568 | 718 | 869 | 846 | 746 | 974 | 972 |
| 79 | 139 | 207 | 329 | 335 | 354 | 463 | 565 | 591 | 351 | 719 | 470 | 847 | 747 | 975 | 973 |
| 80 | 515 | 208 | 279 | 336 | 341 | 464 | 398 | 592 | 780 | 720 | 670 | 848 | 748 | 976 | 974 |
| 81 | 98 | 209 | 173 | 337 | 395 | 465 | 346 | 593 | 913 | 721 | 915 | 849 | 749 | 977 | 975 |
| 82 | 289 | 210 | 292 | 338 | 771 | 466 | 456 | 594 | 251 | 722 | 630 | 850 | 750 | 978 | 976 |
| 83 | 99 | 211 | 537 | 339 | 657 | 467 | 358 | 595 | 482 | 723 | 680 | 851 | 751 | 979 | 978 |
| 84 | 89 | 212 | 92 | 340 | 562 | 468 | 405 | 596 | 469 | 724 | 873 | 852 | 752 | 980 | 979 |
| 85 | 141 | 213 | 199 | 341 | 187 | 469 | 303 | 597 | 669 | 725 | 471 | 853 | 754 | 981 | 980 |
| 86 | 517 | 214 | 63 | 342 | 160 | 470 | 569 | 598 | 629 | 726 | 671 | 854 | 755 | 982 | 981 |
| 87 | 146 | 215 | 387 | 343 | 328 | 471 | 244 | 599 | 679 | 727 | 930 | 855 | 756 | 983 | 982 |
| 88 | 101 | 216 | 144 | 344 | 302 | 472 | 595 | 600 | 408 | 728 | 917 | 856 | 757 | 984 | 983 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 89 | 147 | 217 | 520 | 345 | 214 | 473 | 189 | 601 | 929 | 729 | 631 | 857 | 758 | 985 | 984 |
| 90 | 16 | 218 | 282 | 346 | 241 | 474 | 566 | 602 | 708 | 730 | 254 | 858 | 759 | 986 | 985 |
| 91 | 24 | 219 | 121 | 347 | 583 | 475 | 676 | 603 | 253 | 731 | 484 | 859 | 760 | 987 | 986 |
| 92 | 521 | 220 | 202 | 348 | 557 | 476 | 361 | 604 | 483 | 732 | 474 | 860 | 761 | 988 | 987 |
| 93 | 149 | 221 | 179 | 349 | 536 | 477 | 706 | 605 | 473 | 733 | 881 | 861 | 762 | 989 | 988 |
| 94 | 28 | 222 | 104 | 350 | 402 | 478 | 589 | 606 | 682 | 734 | 634 | 862 | 763 | 990 | 989 |
| 95 | 260 | 223 | 549 | 351 | 355 | 479 | 215 | 607 | 633 | 735 | 931 | 863 | 764 | 991 | 990 |
| 96 | 105 | 224 | 294 | 352 | 644 | 480 | 786 | 608 | 364 | 736 | 921 | 864 | 765 | 992 | 991 |
| 97 | 40 | 225 | 94 | 353 | 586 | 481 | 647 | 609 | 782 | 737 | 255 | 865 | 766 | 993 | 992 |
| 98 | 30 | 226 | 283 | 354 | 308 | 482 | 348 | 610 | 592 | 738 | 475 | 866 | 767 | 994 | 994 |
| 99 | 162 | 227 | 524 | 355 | 120 | 483 | 419 | 611 | 485 | 739 | 635 | 867 | 768 | 995 | 995 |
| 100 | 262 | 228 | 152 | 356 | 397 | 484 | 406 | 612 | 961 | 740 | 933 | 868 | 800 | 996 | 996 |
| 101 | 44 | 229 | 389 | 357 | 563 | 485 | 464 | 613 | 683 | 741 | 486 | 869 | 812 | 997 | 997 |
| 102 | 31 | 230 | 578 | 358 | 773 | 486 | 680 | 614 | 572 | 742 | 962 | 870 | 814 | 998 | 998 |
| 103 | 163 | 231 | 203 | 359 | 345 | 487 | 801 | 615 | 783 | 743 | 684 | 871 | 815 | 999 | 999 |
| 104 | 263 | 232 | 108 | 360 | 228 | 488 | 362 | 616 | 710 | 744 | 477 | 872 | 816 | 1000 | 1000 |
| 105 | 153 | 233 | 337 | 361 | 189 | 489 | 590 | 617 | 788 | 745 | 637 | 873 | 820 | 1001 | 1001 |
| 106 | 46 | 234 | 181 | 362 | 303 | 490 | 409 | 618 | 489 | 746 | 937 | 874 | 822 | 1002 | 1002 |
| 107 | 321 | 235 | 295 | 363 | 215 | 491 | 570 | 619 | 690 | 747 | 487 | 875 | 823 | 1003 | 1003 |
| 108 | 266 | 236 | 95 | 364 | 673 | 492 | 788 | 620 | 366 | 748 | 784 | 876 | 824 | 1004 | 1004 |
| 109 | 529 | 237 | 579 | 365 | 403 | 493 | 597 | 621 | 685 | 749 | 963 | 877 | 826 | 1005 | 1005 |
| 110 | 52 | 238 | 526 | 366 | 357 | 494 | 572 | 622 | 711 | 750 | 490 | 878 | 827 | 1006 | 1006 |
| 111 | 47 | 239 | 298 | 367 | 332 | 495 | 219 | 623 | 412 | 751 | 945 | 879 | 828 | 1007 | 1007 |
| 112 | 165 | 240 | 210 | 368 | 218 | 496 | 311 | 624 | 497 | 752 | 686 | 880 | 829 | 1008 | 1008 |
| 113 | 72 | 241 | 553 | 369 | 587 | 497 | 708 | 625 | 691 | 753 | 965 | 881 | 830 | 1009 | 1009 |
| 114 | 267 | 242 | 156 | 370 | 176 | 498 | 598 | 626 | 224 | 754 | 491 | 882 | 831 | 1010 | 1010 |
| 115 | 113 | 243 | 285 | 371 | 540 | 499 | 601 | 627 | 367 | 755 | 712 | 883 | 832 | 1011 | 1011 |
| 116 | 54 | 244 | 324 | 372 | 646 | 500 | 651 | 628 | 574 | 756 | 687 | 884 | 840 | 1012 | 1012 |
| 117 | 76 | 245 | 205 | 373 | 565 | 501 | 421 | 629 | 372 | 757 | 969 | 885 | 844 | 1013 | 1013 |
| 118 | 55 | 246 | 110 | 374 | 310 | 502 | 792 | 630 | 714 | 758 | 498 | 886 | 846 | 1014 | 1014 |
| 119 | 269 | 247 | 532 | 375 | 777 | 503 | 802 | 631 | 790 | 759 | 692 | 887 | 847 | 1015 | 1015 |
| 120 | 78 | 248 | 168 | 376 | 418 | 504 | 611 | 632 | 693 | 760 | 493 | 888 | 848 | 1016 | 1016 |
| 121 | 274 | 249 | 393 | 377 | 124 | 505 | 602 | 633 | 575 | 761 | 368 | 889 | 852 | 1017 | 1017 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 122 | 194 | 250 | 769 | 378 | 594 | 506 | 410 | 634 | 715 | 762 | 977 | 890 | 854 | 1018 | 1018 |
| 123 | 58 | 251 | 116 | 379 | 230 | 507 | 231 | 635 | 424 | 763 | 499 | 891 | 855 | 1019 | 1019 |
| 124 | 169 | 252 | 527 | 380 | 405 | 508 | 688 | 636 | 414 | 764 | 694 | 892 | 856 | 1020 | 1020 |
| 125 | 84 | 253 | 299 | 381 | 705 | 509 | 653 | 637 | 791 | 765 | 501 | 893 | 858 | 1021 | 1021 |
| 126 | 79 | 254 | 211 | 382 | 552 | 510 | 248 | 638 | 804 | 766 | 576 | 894 | 859 | 1022 | 1022 |
| 127 | 275 | 255 | 185 | 383 | 219 | 511 | 369 | 639 | 697 | 767 | 993 | 895 | 860 | 1023 | 1023 |
| 128 | 195 | 256 | 158 | 384 | 361 | 512 | 190 | 640 | 600 | 768 | 716 | 896 | 861 | 1024 | 1024 |

$Q_i^{N_{max}}$ indicates a reliability sequence, an element is a sequence number of a subchannel, $W(Q_i^{N_{max}})$ indicates reliability corresponding to the reliability sequence, and i is an integer greater than or equal to 1 and less than or equal to $N_{max}$.

**42.** The apparatus according to any one of claims 34 to 41, wherein the processing unit is specifically configured to perform first channel decoding on the first to-be-decoded sequence based on the first reliability sequence and an internal interleaver sequence, wherein the internal interleaver sequence is determined based on the extended matrix, and a size of a block of the internal interleaver sequence is equal to the lifting size of the extended matrix.

**43.** A communication apparatus, comprising a processor and a memory, wherein

the memory is configured to store instructions; and
the processor is configured to execute the instructions, to perform the method according to any one of claims 1 to 21.

**44.** A communication apparatus, comprising a logic circuit and an input/output interface, wherein the logic circuit is coupled to the input/output interface; and
the input/output interface is configured to input to-be-processed data, the logic circuit processes the to-be-processed data according to the method according to any one of claims 1 to 21, to obtain processed data, and the input/output interface is configured to output the processed data.

**45.** A computer-readable storage medium, wherein the computer-readable storage medium is configured to store a computer program, and when the computer program is executed, the method according to any one of claims 1 to 21 is performed.

**46.** A computer program product comprising instructions, wherein when the instructions are run on a computer, the method according to any one of claims 1 to 21 is performed.

**47.** A communication system, wherein the system comprises a transmit end and a receive end, wherein the transmit end is configured to perform the method according to any one of claims 1 to 12; and the receive end is configured to perform the method according to any one of claims 13 to 21.

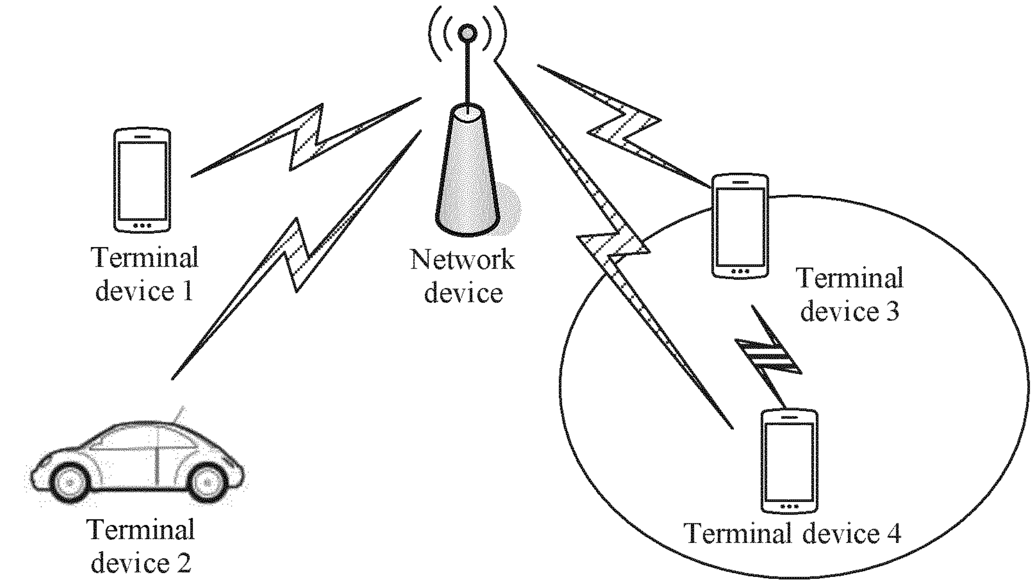
Terminal device 1
Network device
Terminal device 3
Terminal device 2
Terminal device 4

FIG. 1

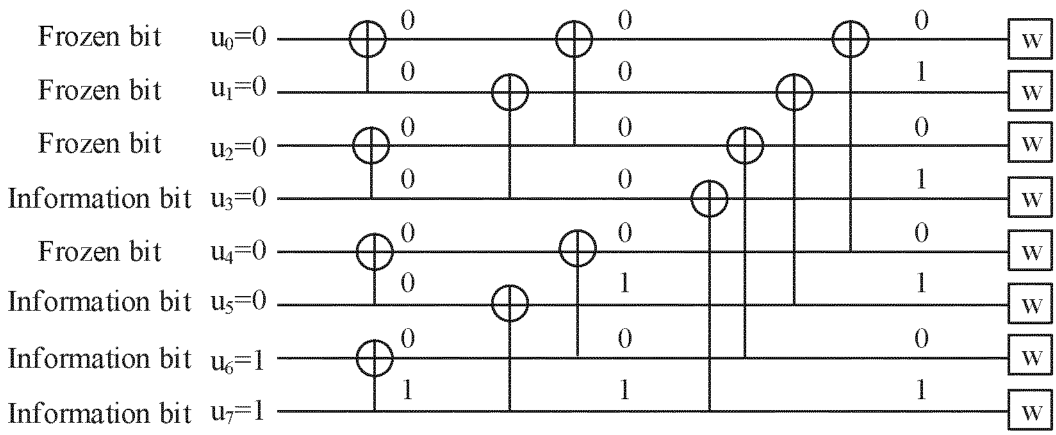
Frozen bit $u_0=0$
Frozen bit $u_1=0$
Frozen bit $u_2=0$
Information bit $u_3=0$
Frozen bit $u_4=0$
Information bit $u_5=0$
Information bit $u_6=1$
Information bit $u_7=1$
W

FIG. 2

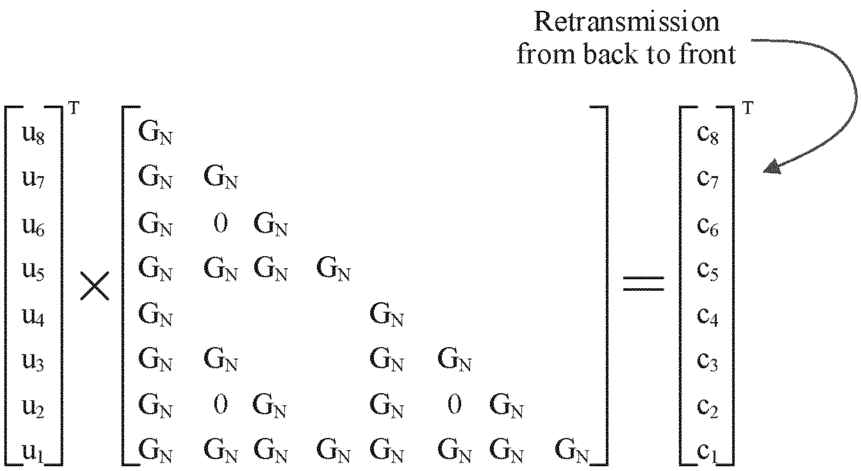
Retransmission from back to front
u8
u7
u6
u5
u4
u3
u2
u1
T
GN
0
c8
c7
c6
c5
c4
c3
c2
c1

FIG. 3a

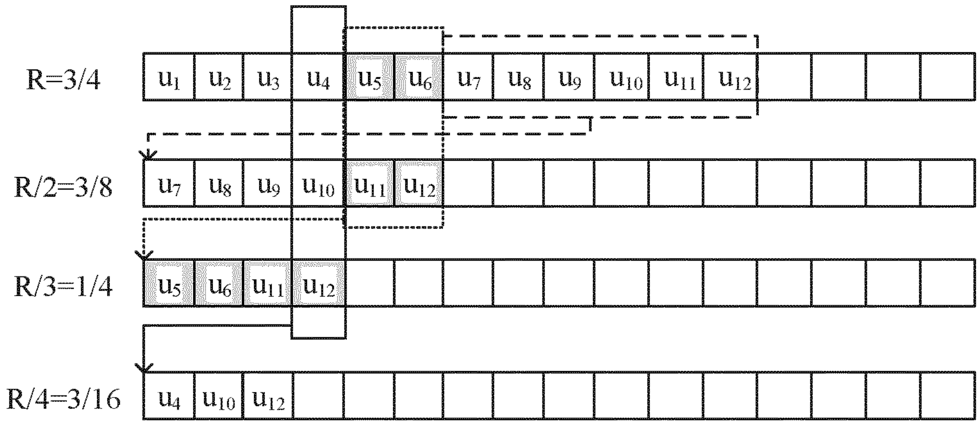
R=3/4
u1 u2 u3 u4 u5 u6 u7 u8 u9 u10 u11 u12
R/2=3/8
u7 u8 u9 u10 u11 u12
R/3=1/4
u5 u6 u11 u12
R/4=3/16
u4 u10 u12

FIG. 3b

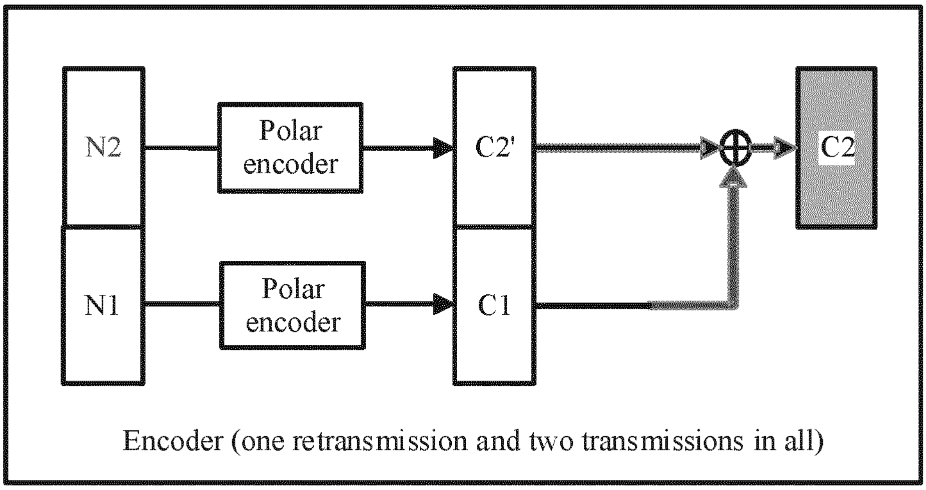
N2
Polar encoder
C2'
C2
N1
Polar encoder
C1
Encoder (one retransmission and two transmissions in all)

FIG. 3c

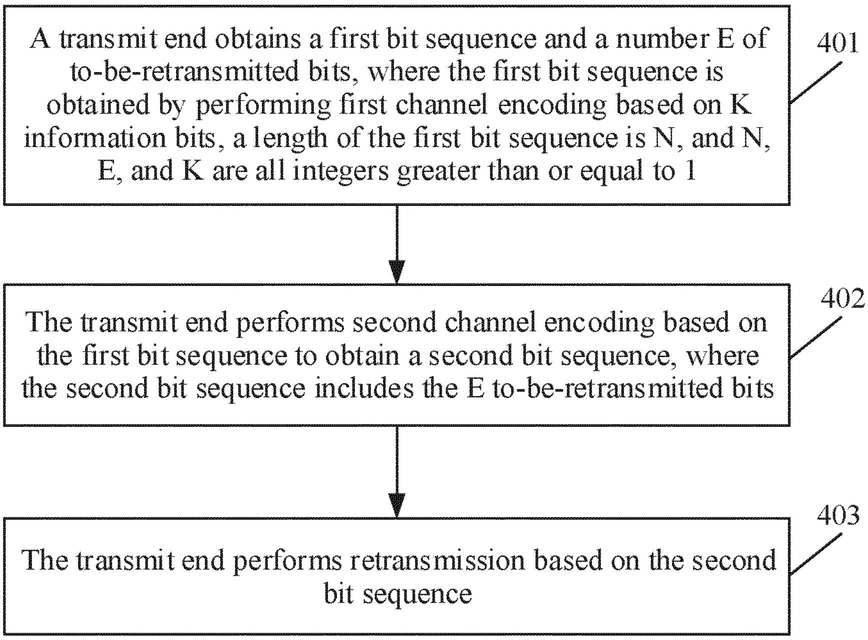
A transmit end obtains a first bit sequence and a number E of to-be-retransmitted bits, where the first bit sequence is obtained by performing first channel encoding based on K information bits, a length of the first bit sequence is N, and N, E, and K are all integers greater than or equal to 1
401
The transmit end performs second channel encoding based on the first bit sequence to obtain a second bit sequence, where the second bit sequence includes the E to-be-retransmitted bits
402
The transmit end performs retransmission based on the second bit sequence
403

FIG. 4

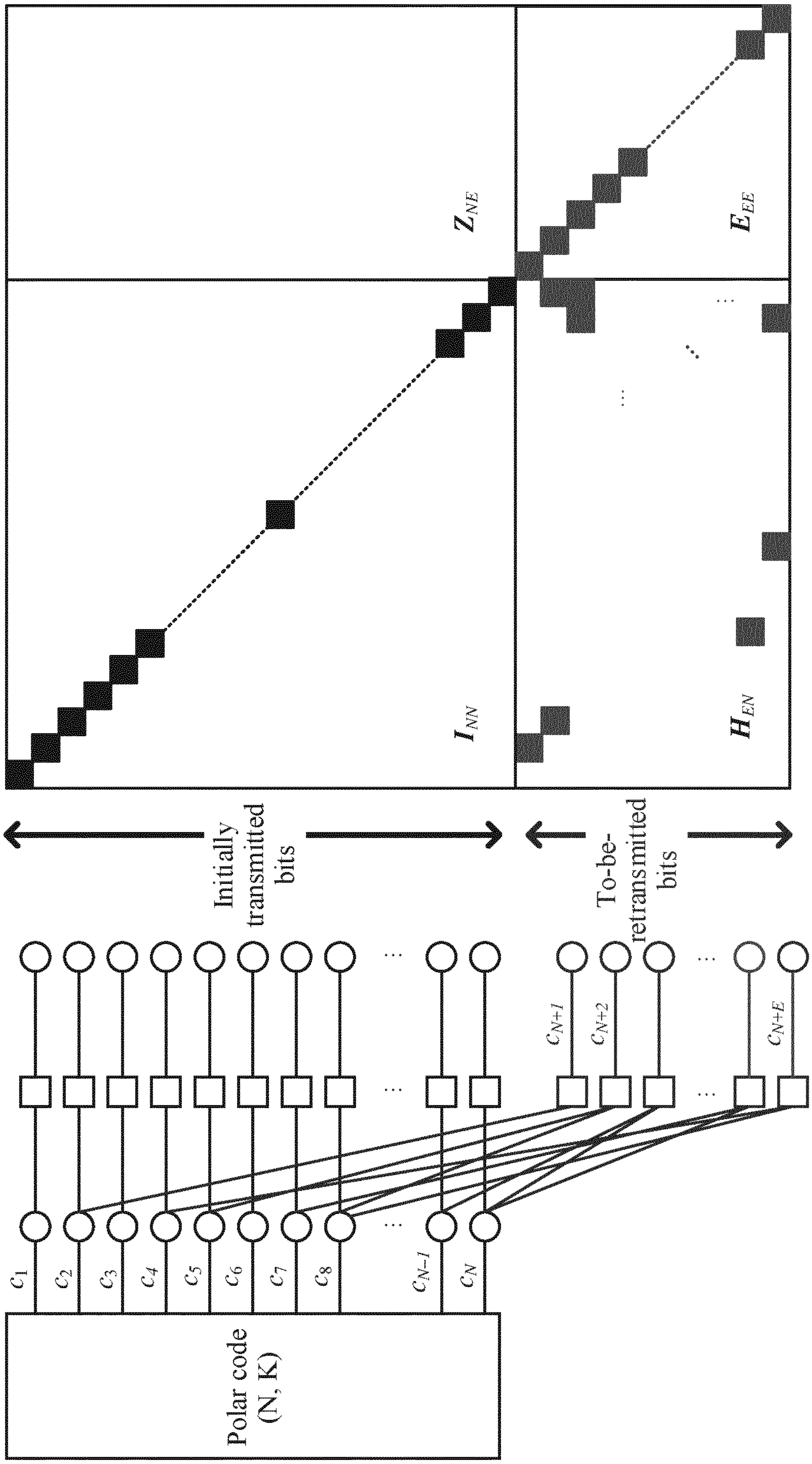
Polar code
(N, K)
$c_1$ $c_2$ $c_3$ $c_4$ $c_5$ $c_6$ $c_7$ $c_8$ $c_{N-1}$ $c_N$
$c_{N+1}$ $c_{N+2}$ $c_{N+E}$
Initially transmitted bits
To-be-retransmitted bits
$I_{NN}$
$Z_{NE}$
$H_{EN}$
$E_{EE}$

FIG. 5a

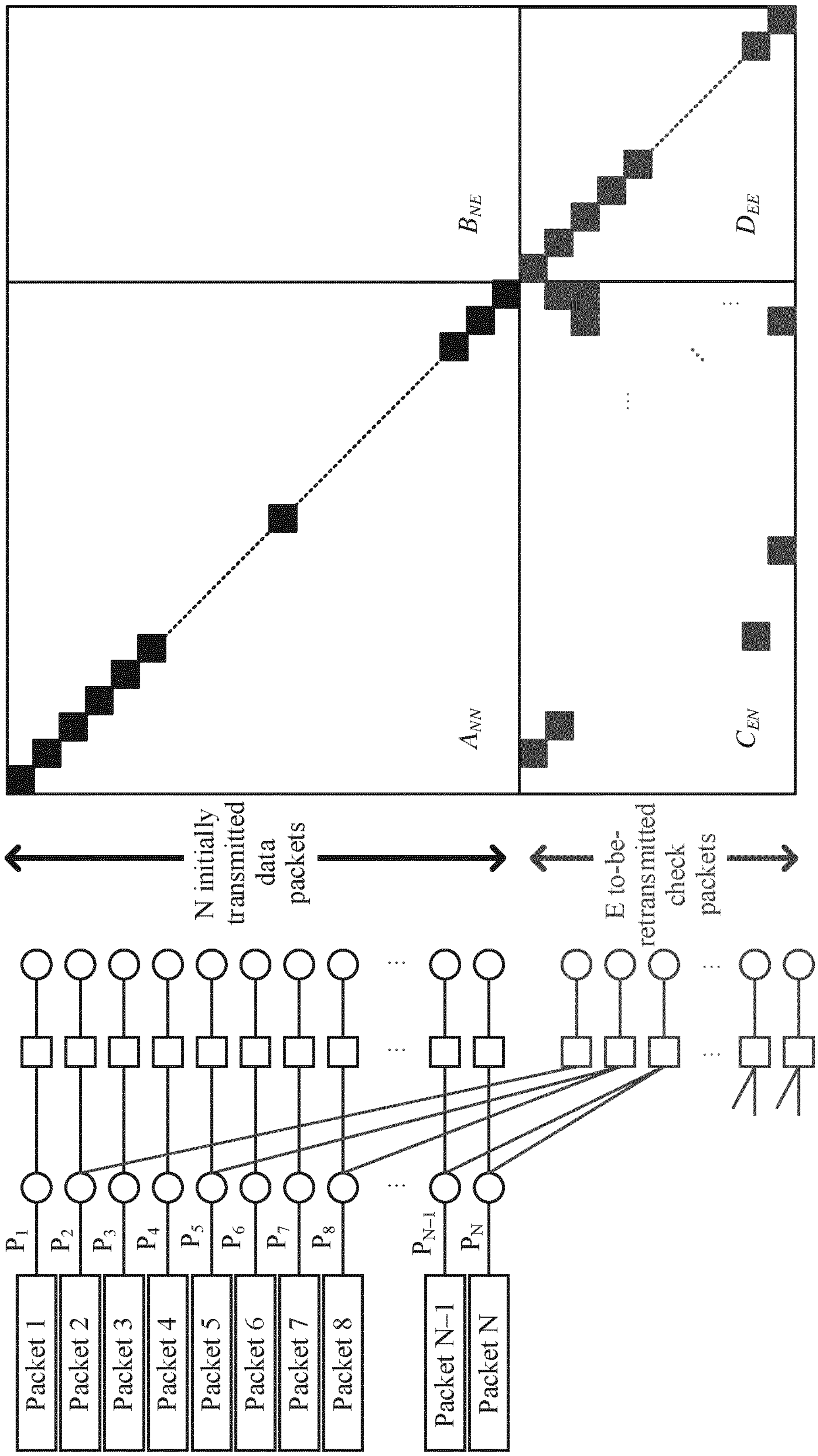

Packet 1
Packet 2
Packet 3
Packet 4
Packet 5
Packet 6
Packet 7
Packet 8
Packet N−1
Packet N
$P_1$
$P_2$
$P_3$
$P_4$
$P_5$
$P_6$
$P_7$
$P_8$
$P_{N-1}$
$P_N$
N initially transmitted data packets
E to-be-retransmitted check packets
$A_{NN}$
$B_{NE}$
$C_{EN}$
$D_{EE}$


FIG. 5b

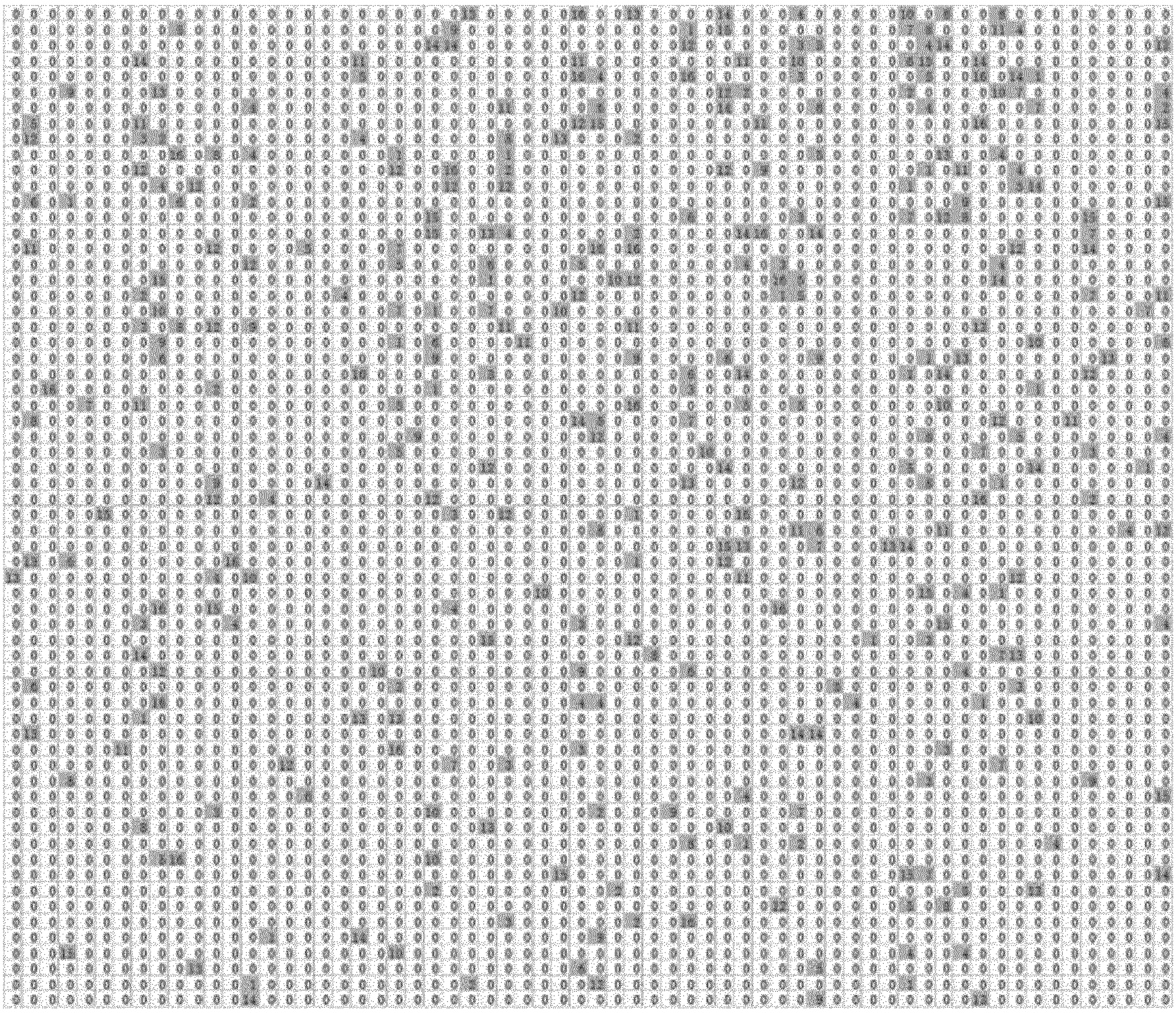

FIG. 6a

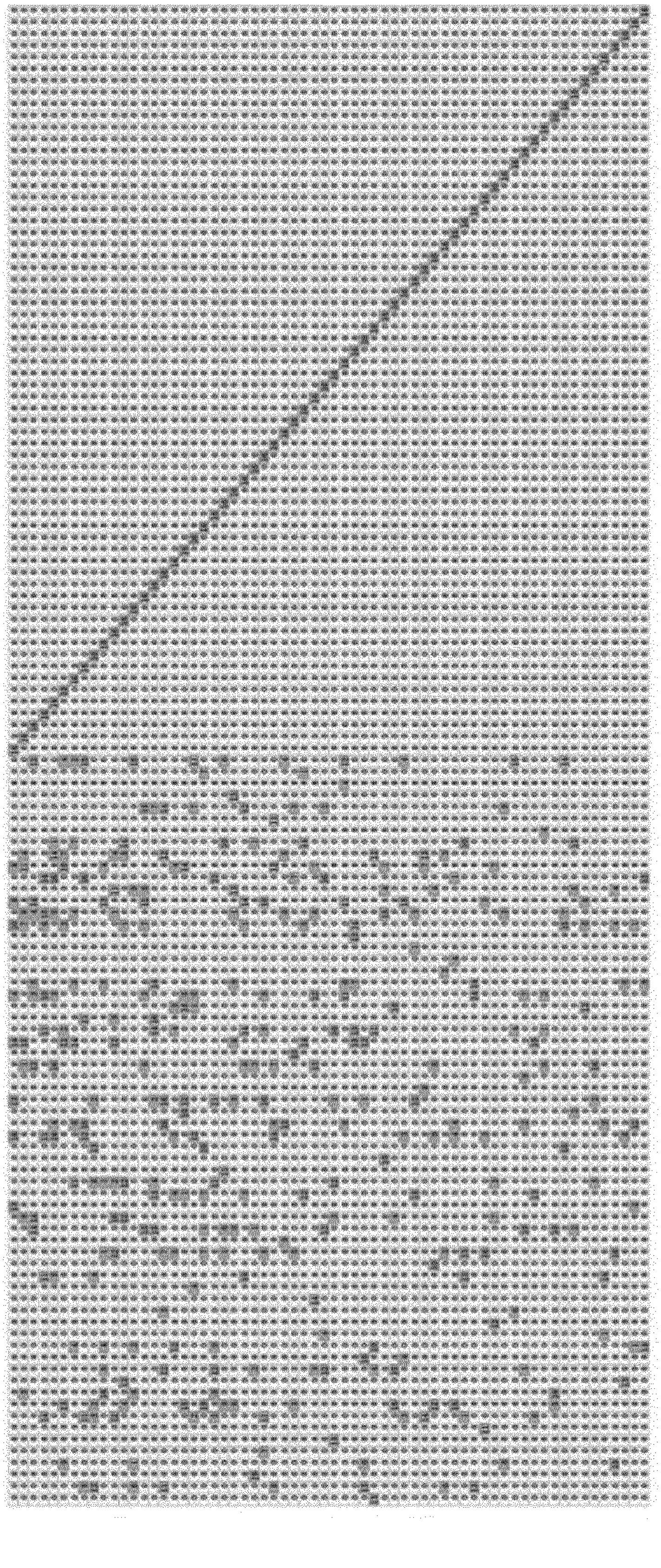

FIG. 6b

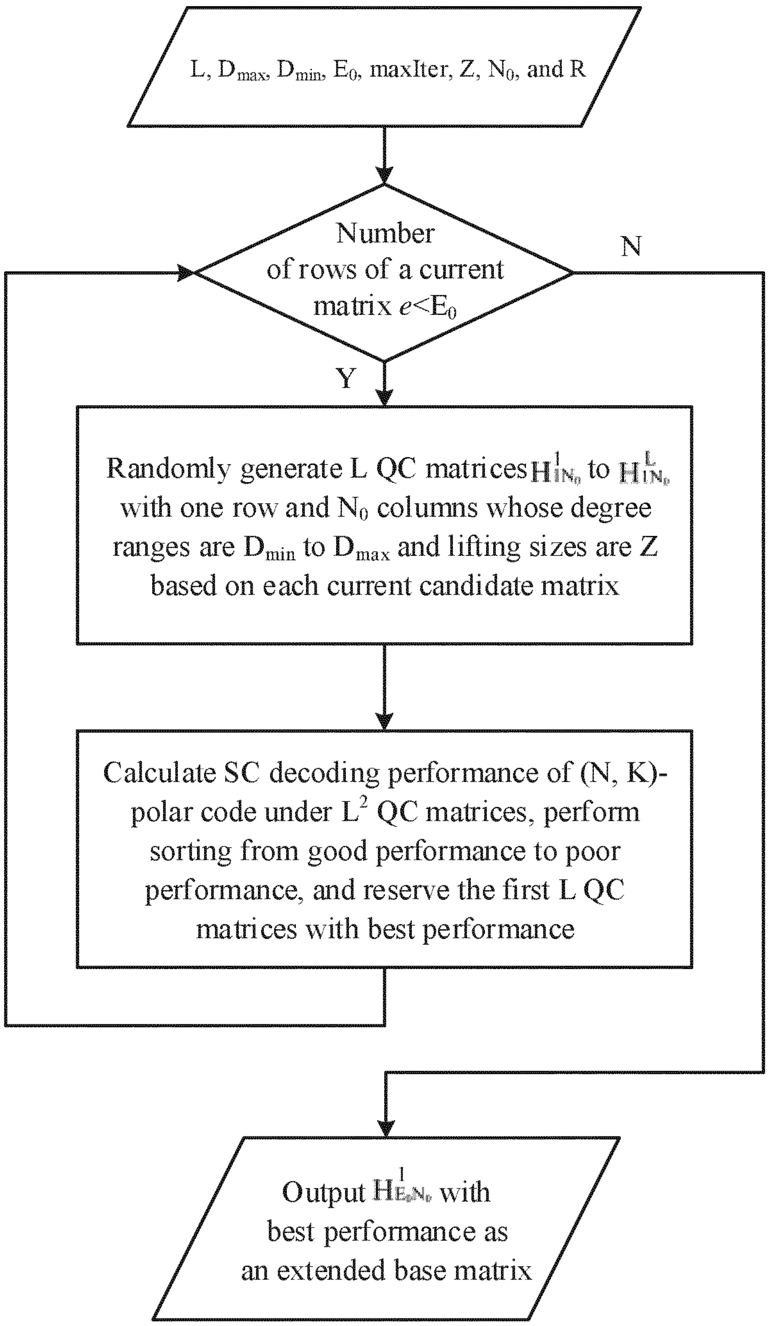
L, $D_{max}$, $D_{min}$, $E_0$, maxIter, Z, $N_0$, and R
Number of rows of a current matrix $e<E_0$
N
Y
Randomly generate L QC matrices $H_{1N_0}^1$ to $H_{1N_0}^L$ with one row and $N_0$ columns whose degree ranges are $D_{min}$ to $D_{max}$ and lifting sizes are Z based on each current candidate matrix
Calculate SC decoding performance of (N, K)-polar code under $L^2$ QC matrices, perform sorting from good performance to poor performance, and reserve the first L QC matrices with best performance
Output $H_{E_0N_0}^1$ with best performance as an extended base matrix

FIG. 6c

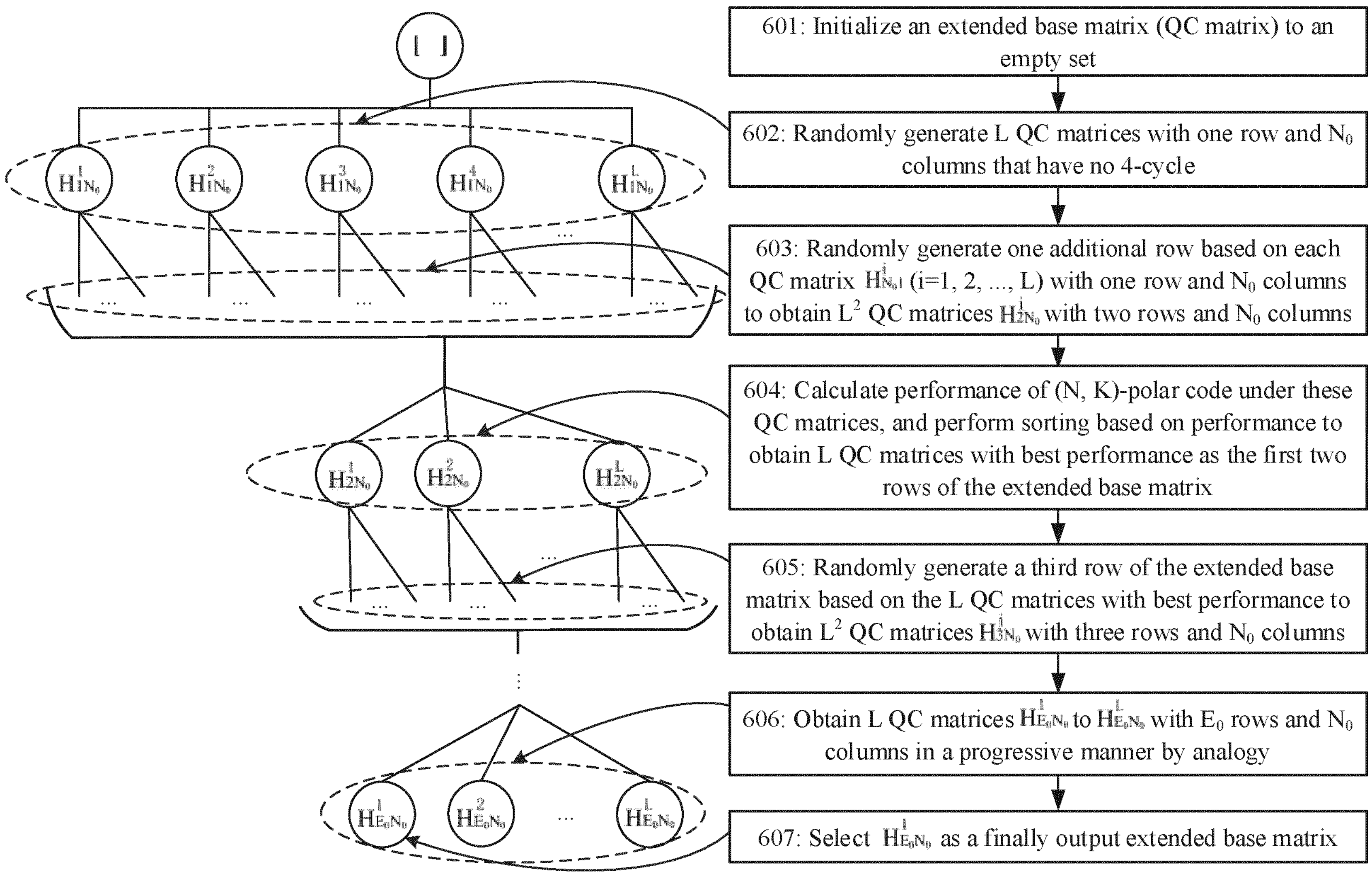
[ ]
$H^{1}_{1N_0}$
$H^{2}_{1N_0}$
$H^{3}_{1N_0}$
$H^{4}_{1N_0}$
$H^{L}_{1N_0}$
$H^{1}_{2N_0}$
$H^{2}_{2N_0}$
$H^{L}_{2N_0}$
$H^{1}_{E_0N_0}$
$H^{2}_{E_0N_0}$
$H^{L}_{E_0N_0}$
601: Initialize an extended base matrix (QC matrix) to an empty set
602: Randomly generate L QC matrices with one row and $N_0$ columns that have no 4-cycle
603: Randomly generate one additional row based on each QC matrix $H^{i}_{N_0 1}$ (i=1, 2, ..., L) with one row and $N_0$ columns to obtain $L^2$ QC matrices $H^{i}_{2N_0}$ with two rows and $N_0$ columns
604: Calculate performance of (N, K)-polar code under these QC matrices, and perform sorting based on performance to obtain L QC matrices with best performance as the first two rows of the extended base matrix
605: Randomly generate a third row of the extended base matrix based on the L QC matrices with best performance to obtain $L^2$ QC matrices $H^{i}_{3N_0}$ with three rows and $N_0$ columns
606: Obtain L QC matrices $H^{1}_{E_0N_0}$ to $H^{L}_{E_0N_0}$ with $E_0$ rows and $N_0$ columns in a progressive manner by analogy
607: Select $H^{1}_{E_0N_0}$ as a finally output extended base matrix

FIG. 6d

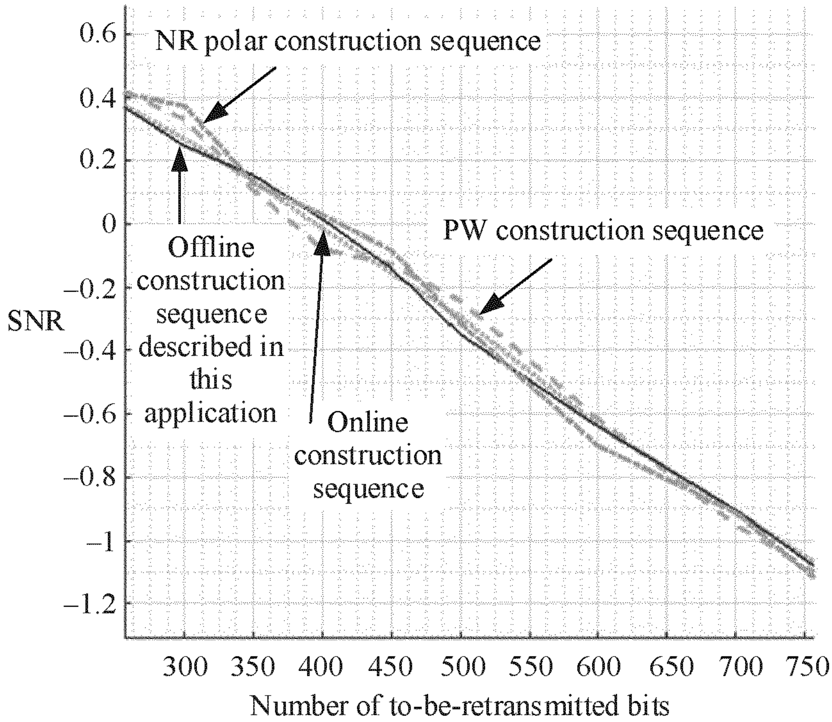
0.6
0.4
0.2
0
−0.2
−0.4
−0.6
−0.8
−1
−1.2
SNR
NR polar construction sequence
Offline construction sequence described in this application
Online construction sequence
PW construction sequence
300 350 400 450 500 550 600 650 700 750
Number of to-be-retransmitted bits

FIG. 7a

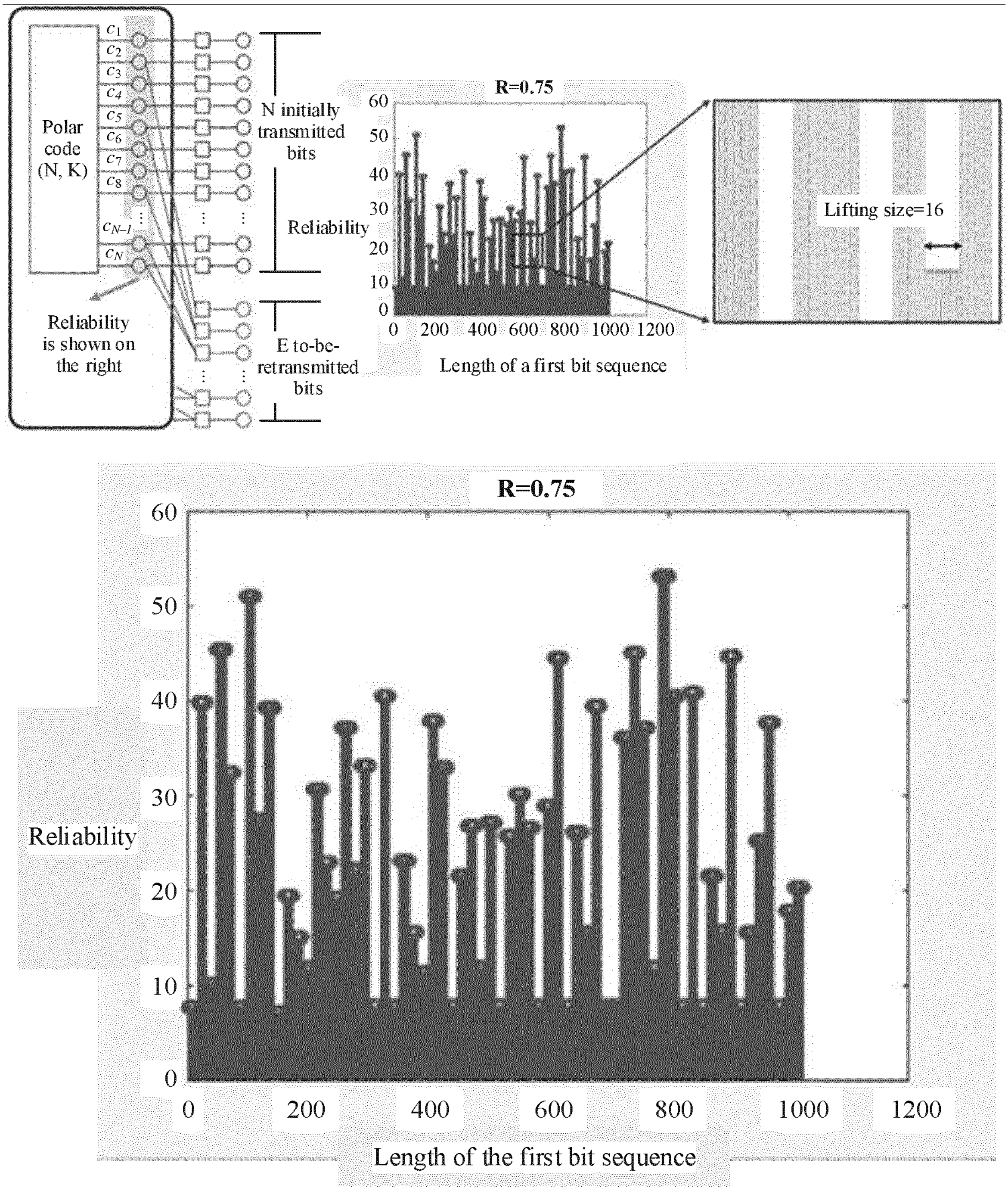
Polar code (N, K)
$c_1$
$c_2$
$c_3$
$c_4$
$c_5$
$c_6$
$c_7$
$c_8$
$c_{N-1}$
$c_N$
Reliability is shown on the right
N initially transmitted bits
E to-be-retransmitted bits
R=0.75
Reliability
Length of a first bit sequence
0 200 400 600 800 1000 1200
0 10 20 30 40 50 60
Lifting size=16
R=0.75
Reliability
Length of the first bit sequence

FIG. 7b

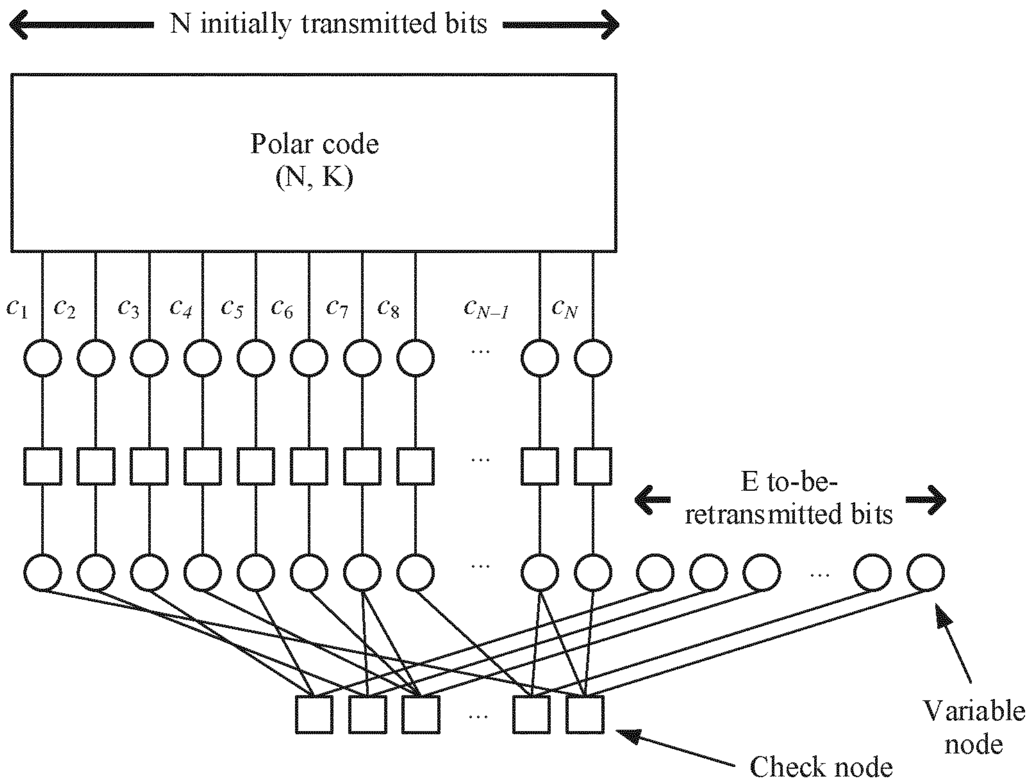
N initially transmitted bits
Polar code
(N, K)
$c_1$ $c_2$ $c_3$ $c_4$ $c_5$ $c_6$ $c_7$ $c_8$ $c_{N-1}$ $c_N$
E to-be-retransmitted bits
Variable node
Check node

FIG. 7c

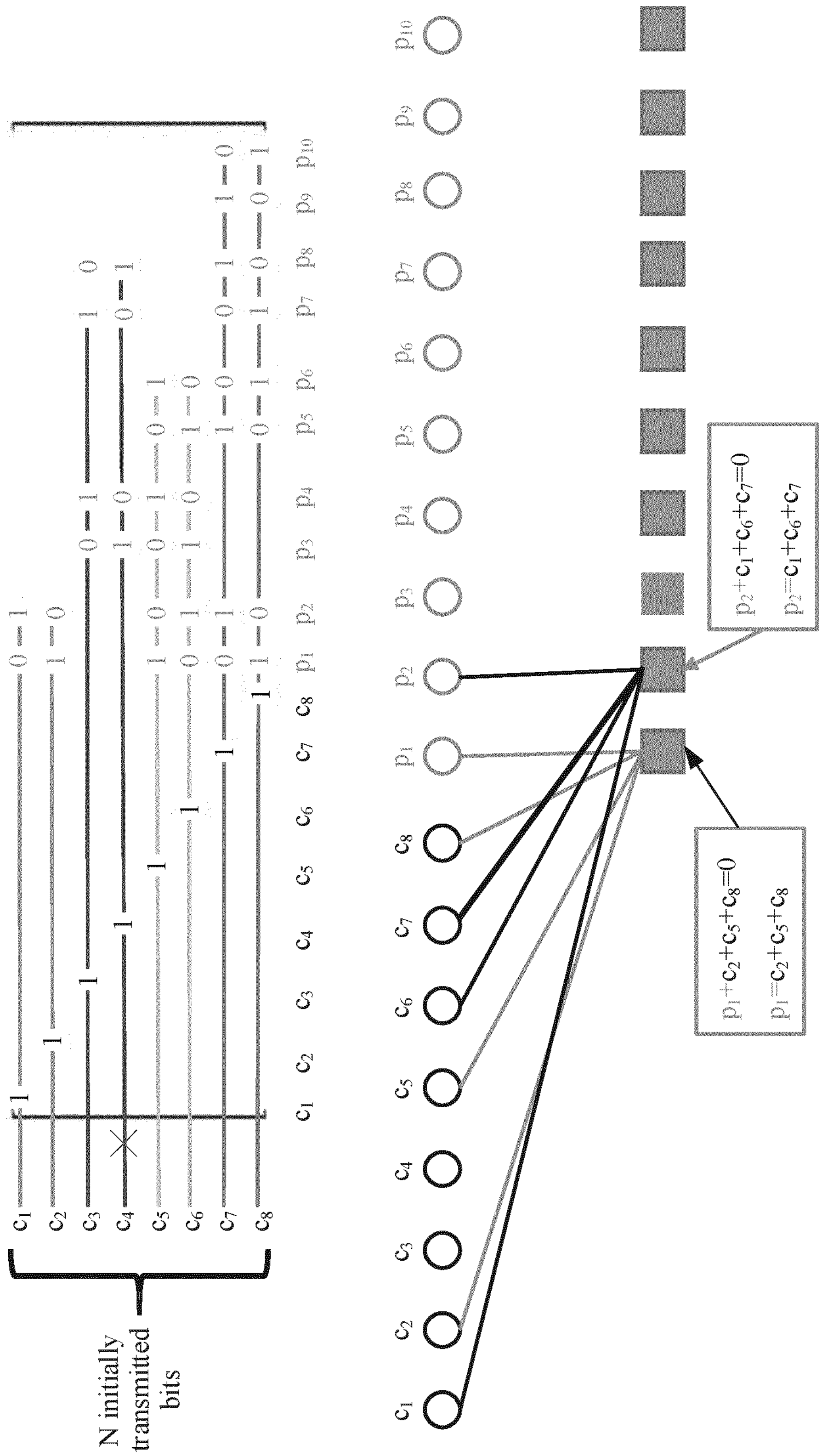
N initially transmitted bits
$p_1+c_2+c_5+c_8=0$
$p_1=c_2+c_5+c_8$
$p_2+c_1+c_6+c_7=0$
$p_2=c_1+c_6+c_7$

FIG. 7d

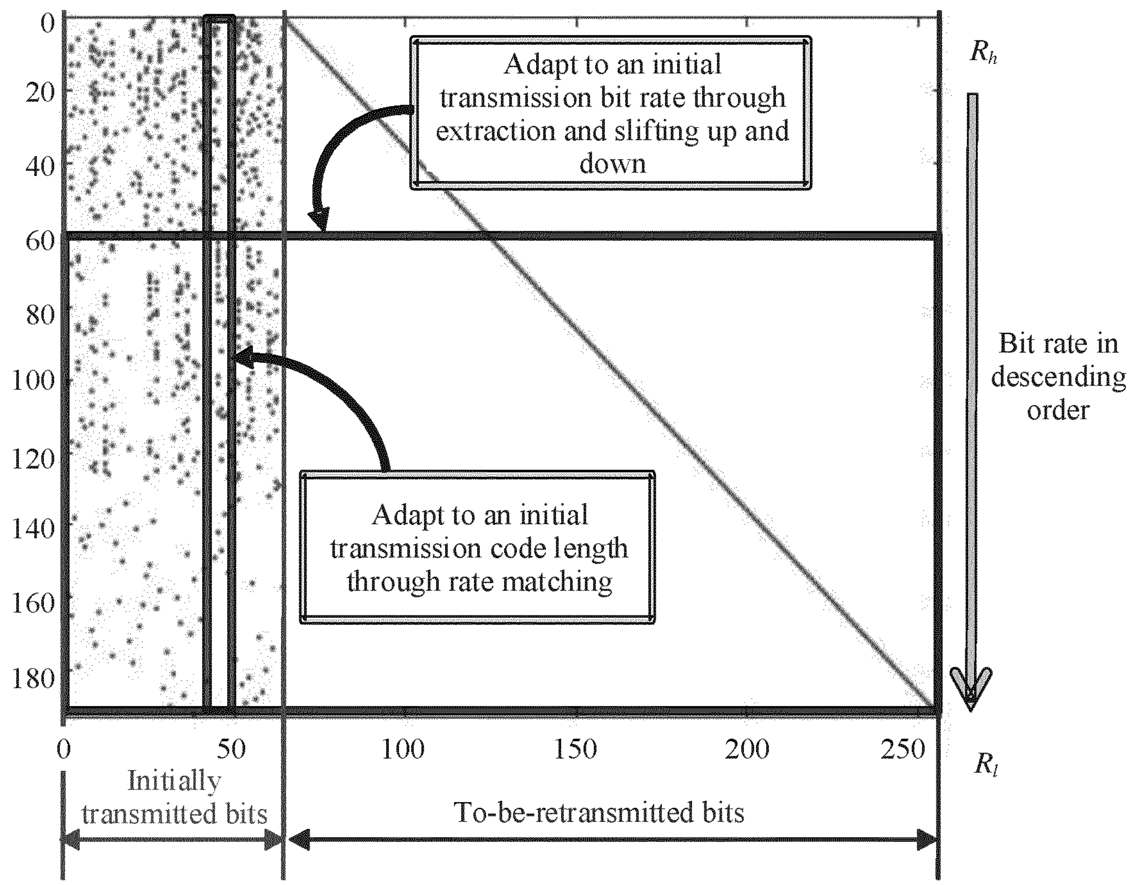
Adapt to an initial transmission bit rate through extraction and slifting up and down
Adapt to an initial transmission code length through rate matching
$R_h$
Bit rate in descending order
$R_l$
0
20
40
60
80
100
120
140
160
180
0
50
100
150
200
250
Initially transmitted bits
To-be-retransmitted bits

FIG. 8a

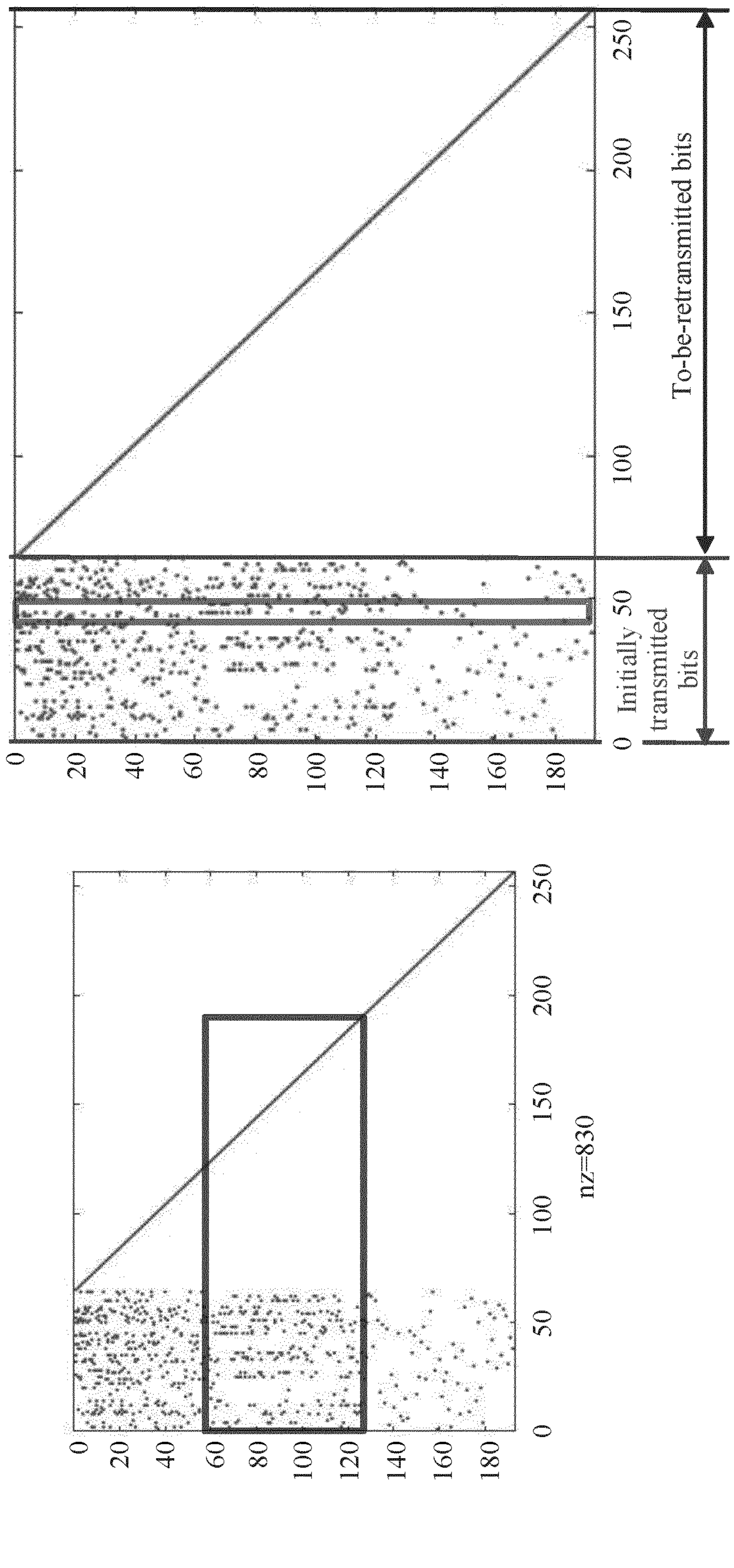

To-be-retransmitted bits
Initially 50 transmitted bits
nz=830


FIG. 8b

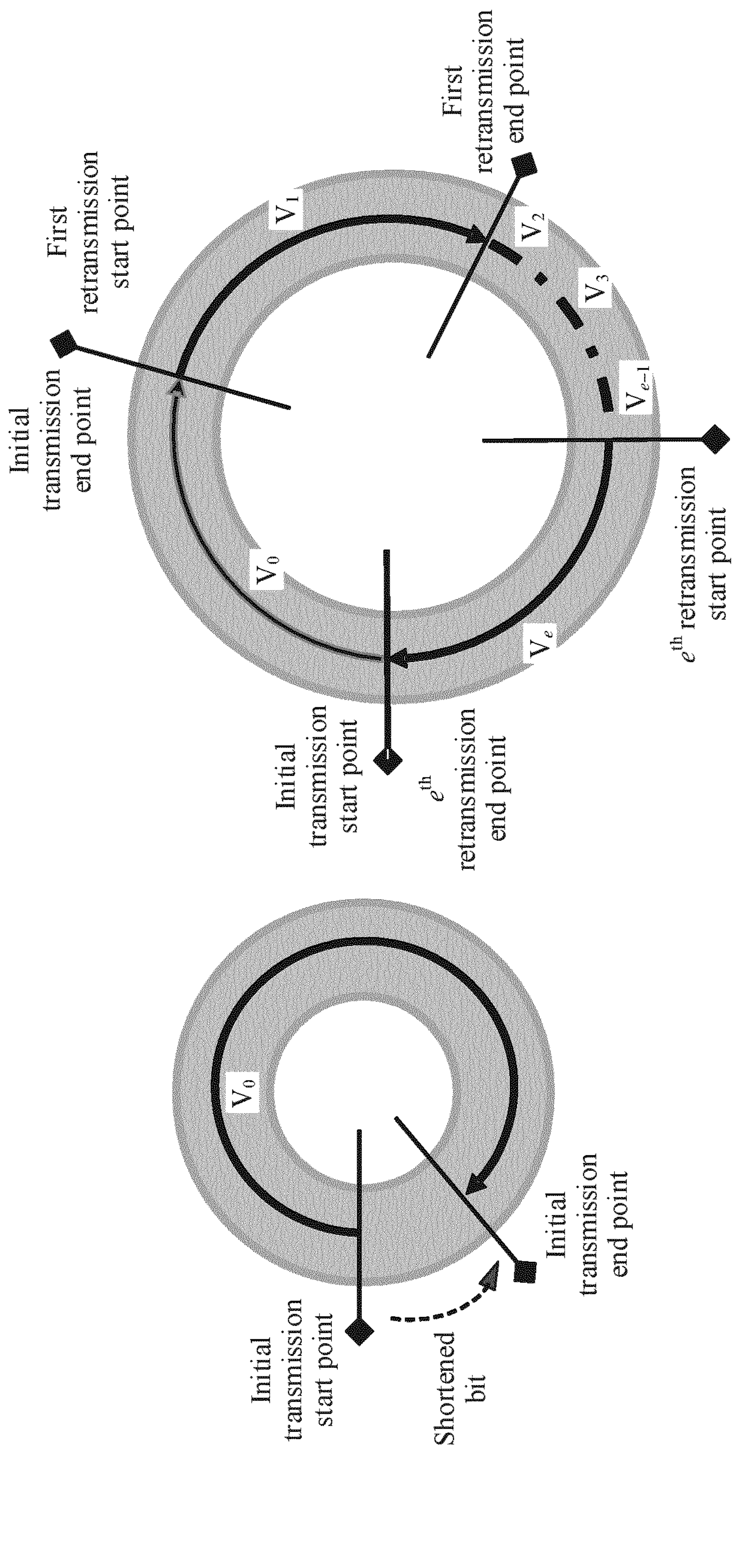
Initial transmission start point
Shortened bit
Initial transmission end point
$V_0$
Initial transmission start point
$e^{th}$ retransmission end point
Initial transmission end point
First retransmission start point
First retransmission end point
$V_1$
$V_2$
$V_3$
$V_{e-1}$
$V_e$
$e^{th}$ retransmission start point

FIG. 9a

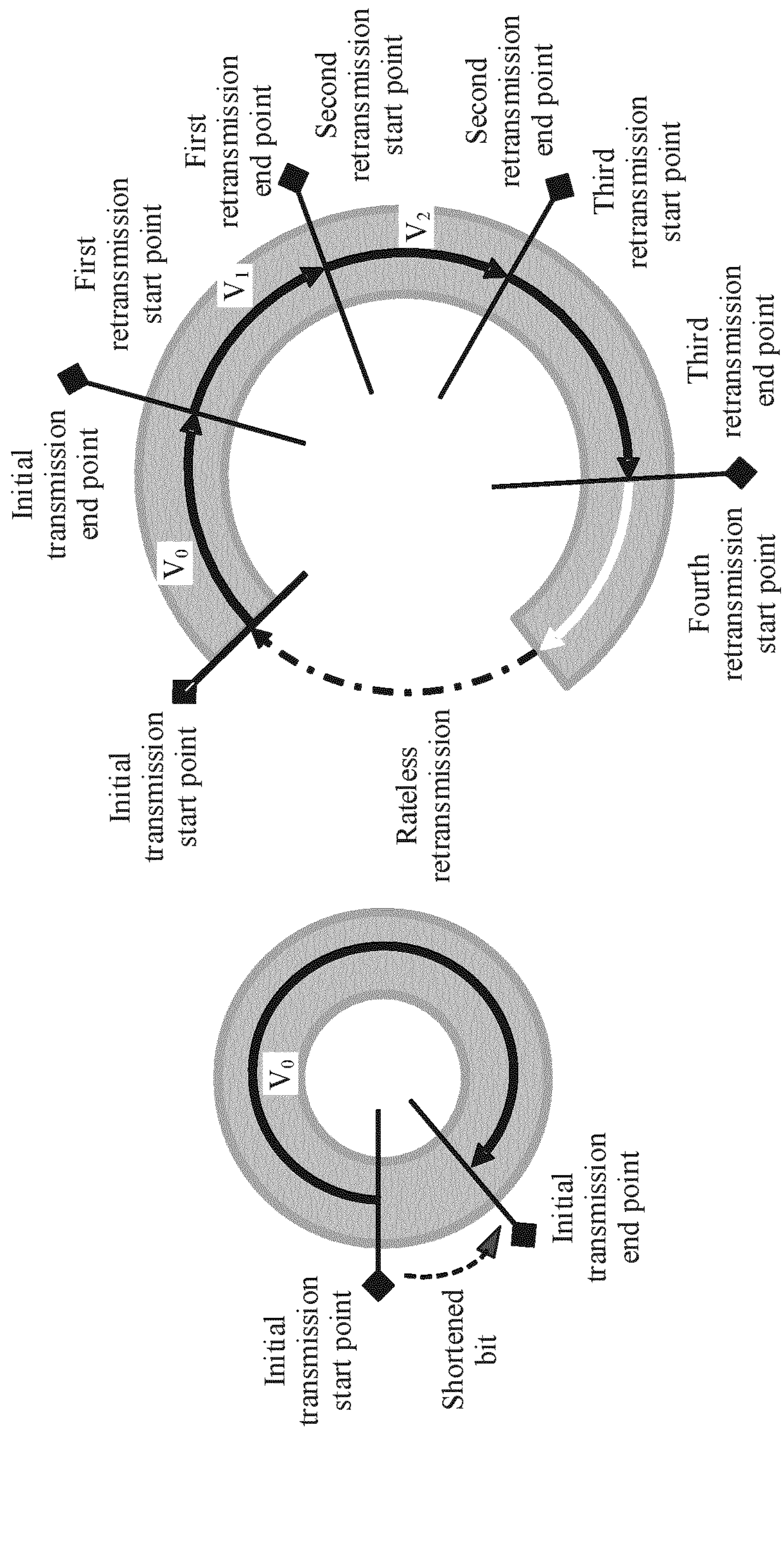
Initial transmission start point
Initial transmission end point
Shortened bit
$V_0$
Initial transmission start point
Initial transmission end point
First retransmission start point
First retransmission end point
Second retransmission start point
Second retransmission end point
Third retransmission start point
Third retransmission end point
Fourth retransmission start point
Rateless retransmission
$V_0$
$V_1$
$V_2$

FIG. 9b

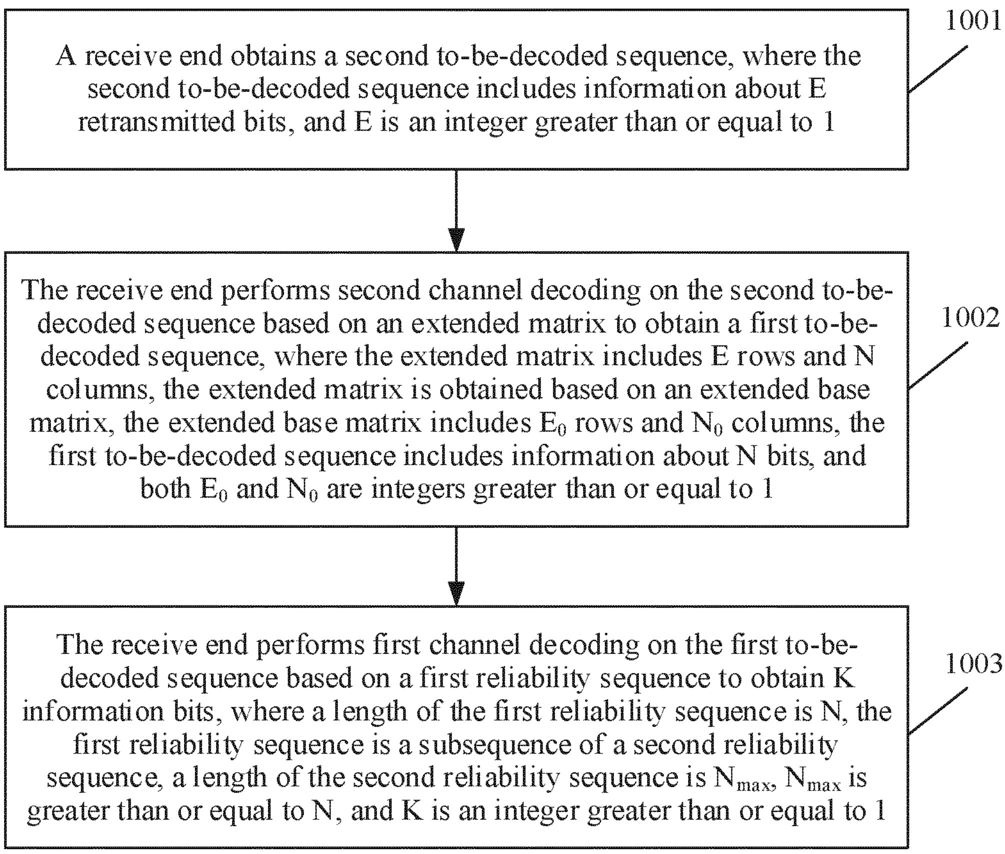
A receive end obtains a second to-be-decoded sequence, where the second to-be-decoded sequence includes information about E retransmitted bits, and E is an integer greater than or equal to 1
1001
The receive end performs second channel decoding on the second to-be-decoded sequence based on an extended matrix to obtain a first to-be-decoded sequence, where the extended matrix includes E rows and N columns, the extended matrix is obtained based on an extended base matrix, the extended base matrix includes $E_0$ rows and $N_0$ columns, the first to-be-decoded sequence includes information about N bits, and both $E_0$ and $N_0$ are integers greater than or equal to 1
1002
The receive end performs first channel decoding on the first to-be-decoded sequence based on a first reliability sequence to obtain K information bits, where a length of the first reliability sequence is N, the first reliability sequence is a subsequence of a second reliability sequence, a length of the second reliability sequence is $N_{max}$, $N_{max}$ is greater than or equal to N, and K is an integer greater than or equal to 1
1003

FIG. 10

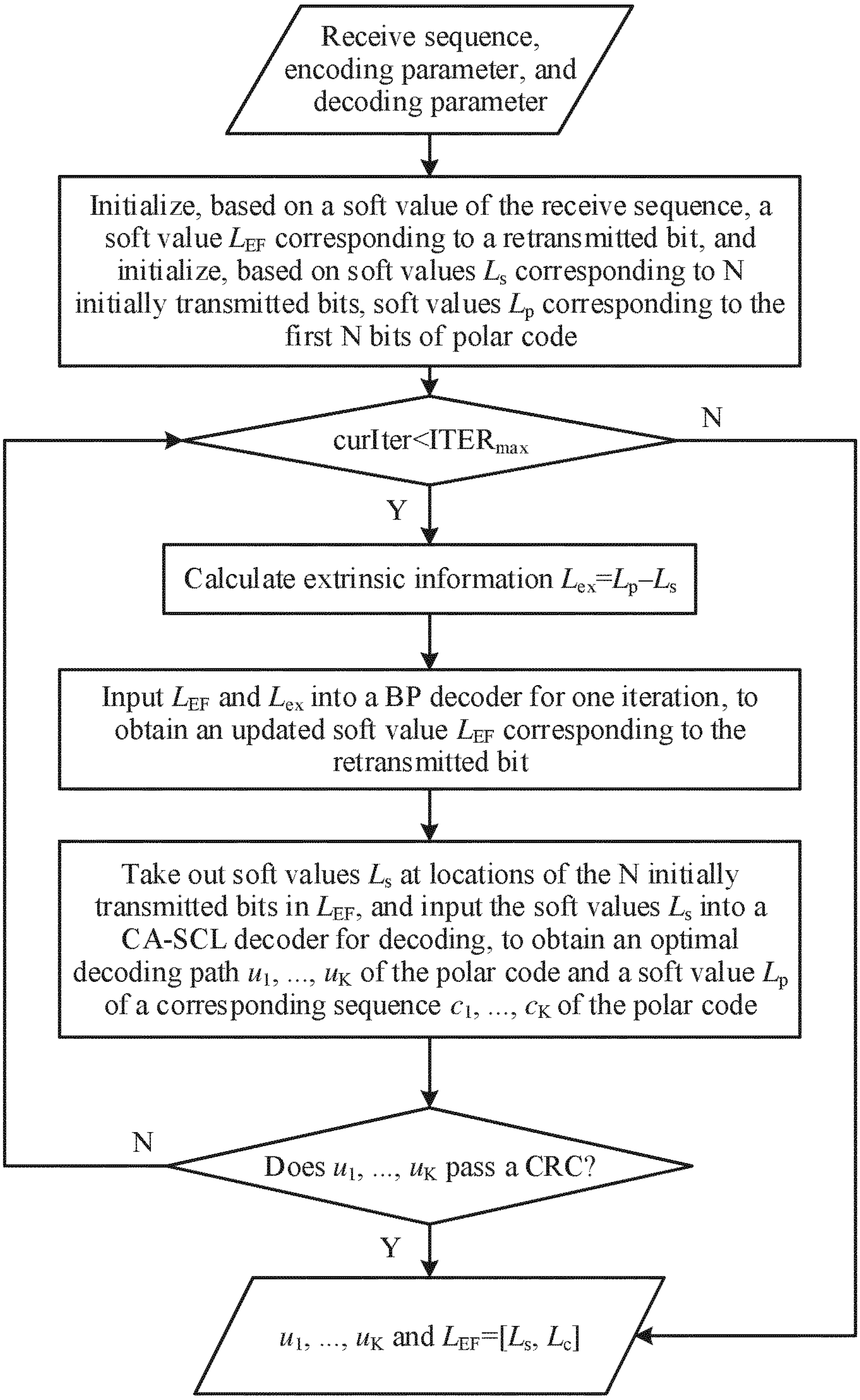
Receive sequence, encoding parameter, and decoding parameter
Initialize, based on a soft value of the receive sequence, a soft value $L_{EF}$ corresponding to a retransmitted bit, and initialize, based on soft values $L_s$ corresponding to N initially transmitted bits, soft values $L_p$ corresponding to the first N bits of polar code
curIter<$ITER_{max}$
N
Y
Calculate extrinsic information $L_{ex}=L_p-L_s$
Input $L_{EF}$ and $L_{ex}$ into a BP decoder for one iteration, to obtain an updated soft value $L_{EF}$ corresponding to the retransmitted bit
Take out soft values $L_s$ at locations of the N initially transmitted bits in $L_{EF}$, and input the soft values $L_s$ into a CA-SCL decoder for decoding, to obtain an optimal decoding path $u_1, ..., u_K$ of the polar code and a soft value $L_p$ of a corresponding sequence $c_1, ..., c_K$ of the polar code
N
Does $u_1, ..., u_K$ pass a CRC?
Y
$u_1, ..., u_K$ and $L_{EF}=[L_s, L_c]$

FIG. 11a

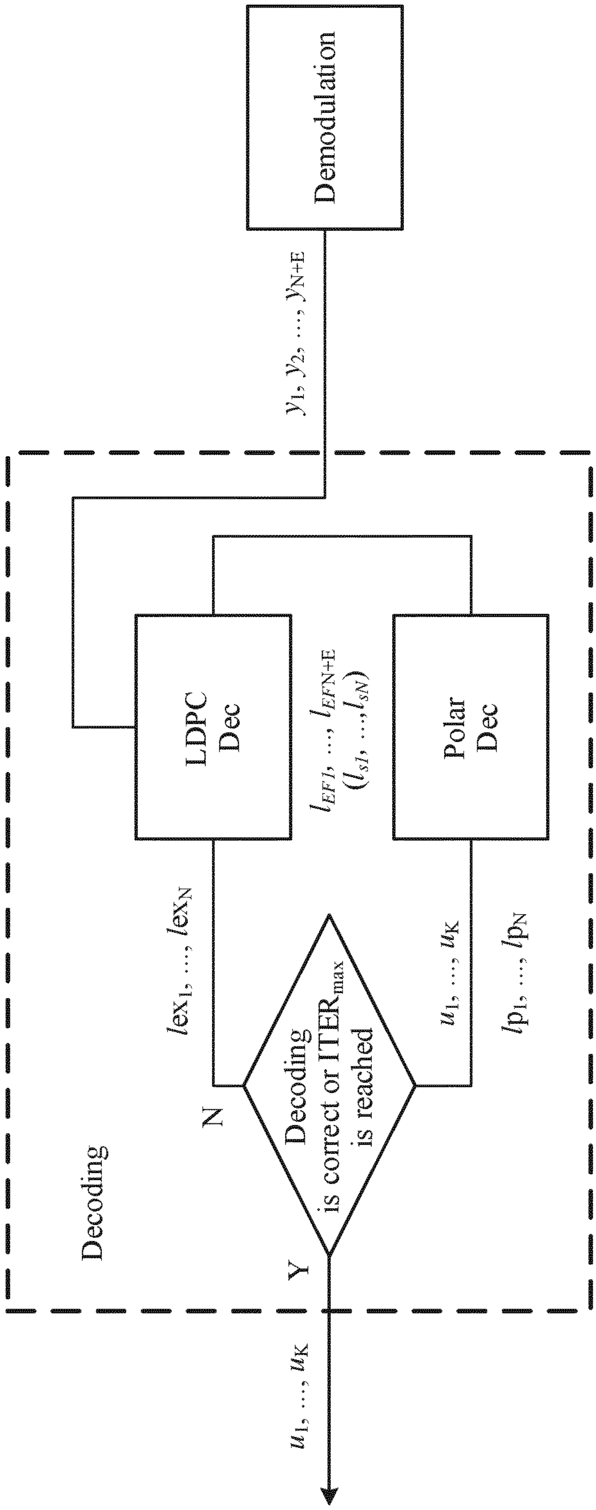
Demodulation
$y_1, y_2, \ldots, y_{N+E}$
Decoding
LDPC Dec
Polar Dec
$l_{EF1}, \ldots, l_{EFN+E}$
$(l_{s1}, \ldots, l_{sN})$
$le x_1, \ldots, le x_N$
$u_1, \ldots, u_K$
$lp_1, \ldots, lp_N$
Decoding is correct or $ITER_{max}$ is reached
N
Y
$u_1, \ldots, u_K$

FIG. 11b

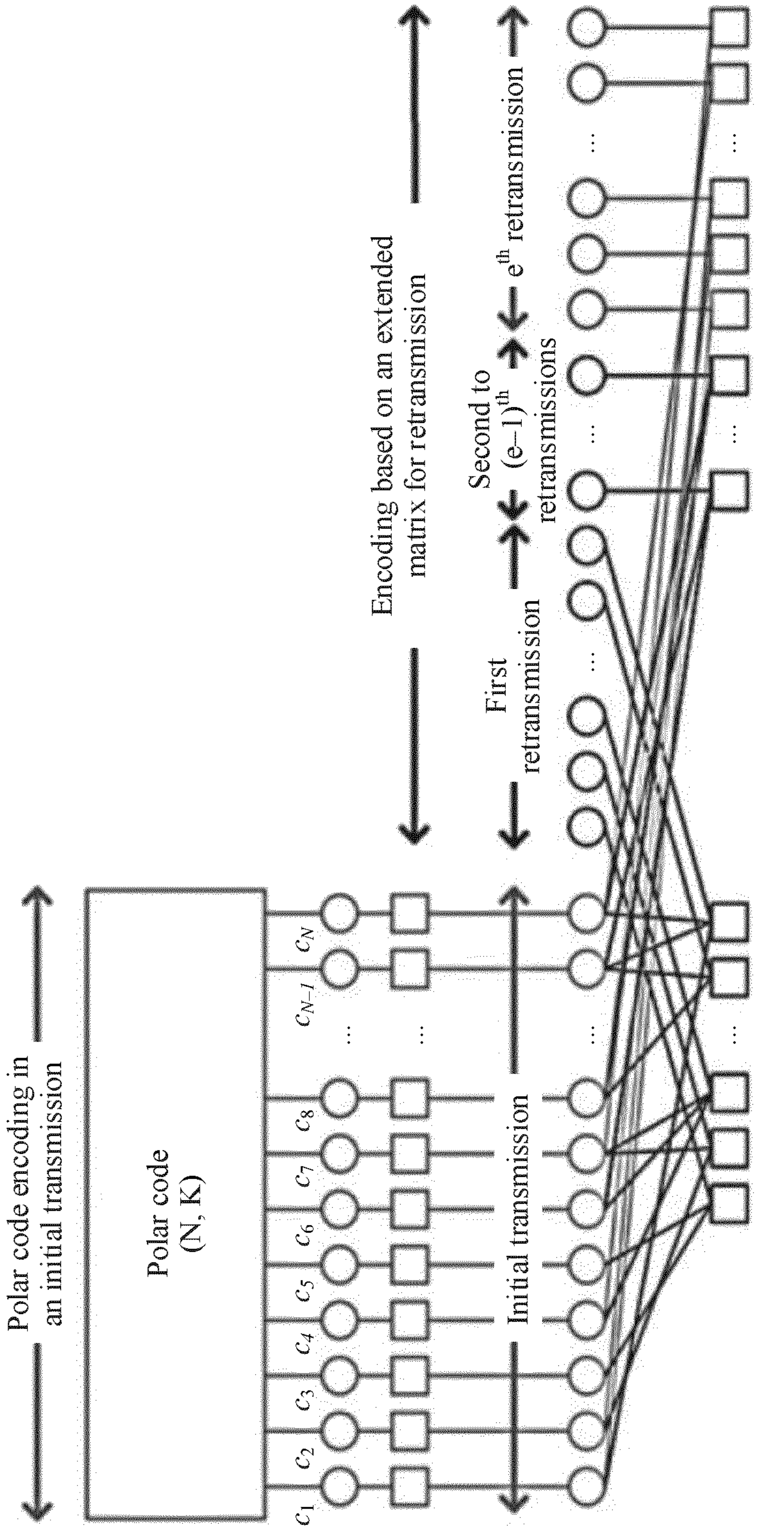
Polar code encoding in an initial transmission
Polar code (N, K)
$c_1$ $c_2$ $c_3$ $c_4$ $c_5$ $c_6$ $c_7$ $c_8$ ... $c_{N-1}$ $c_N$
Initial transmission
Encoding based on an extended matrix for retransmission
First retransmission
Second to (e–1)$^{th}$ retransmissions
e$^{th}$ retransmission

FIG. 11c

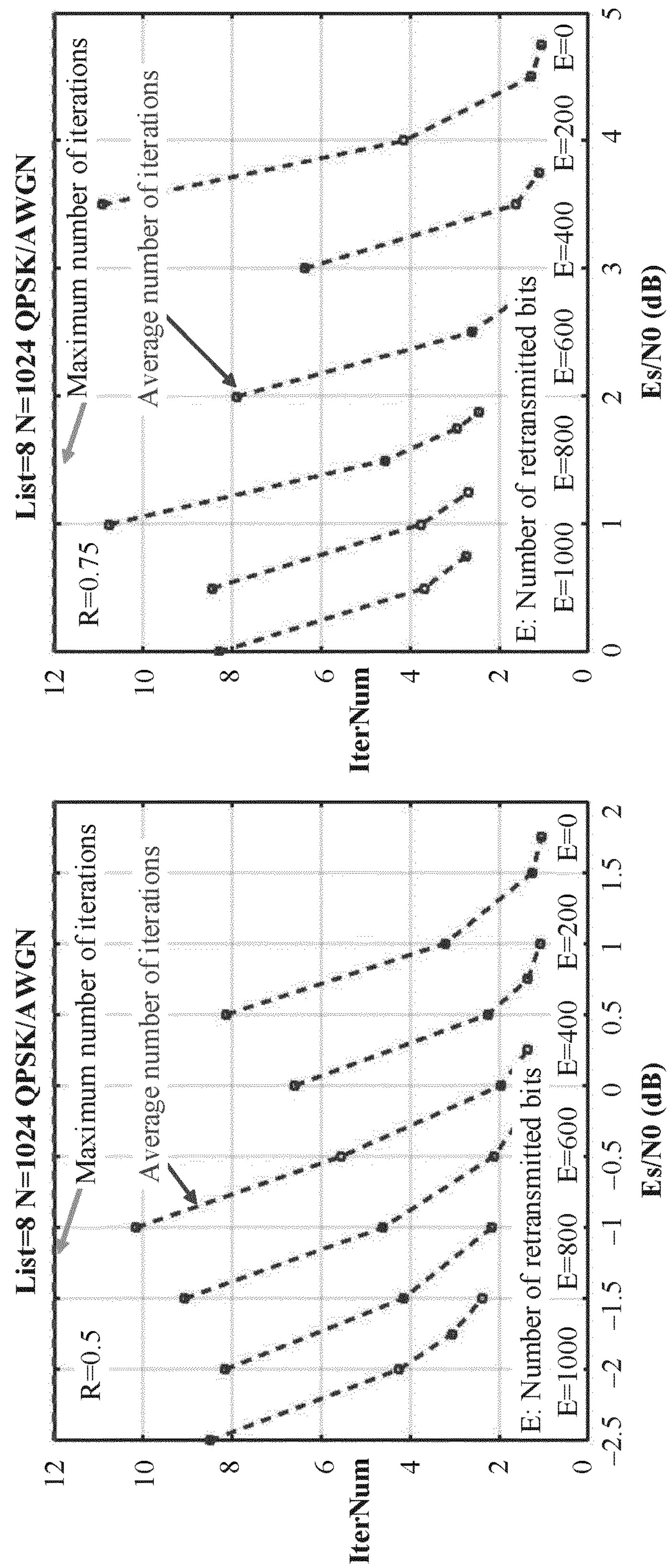
List=8 N=1024 QPSK/AWGN
R=0.5
Maximum number of iterations
Average number of iterations
E: Number of retransmitted bits
E=1000 E=800 E=600 E=400 E=200 E=0
IterNum
Es/N0 (dB)
List=8 N=1024 QPSK/AWGN
R=0.75
Maximum number of iterations
Average number of iterations
E: Number of retransmitted bits
E=1000 E=800 E=600 E=400 E=200 E=0
IterNum
Es/N0 (dB)

FIG. 12a

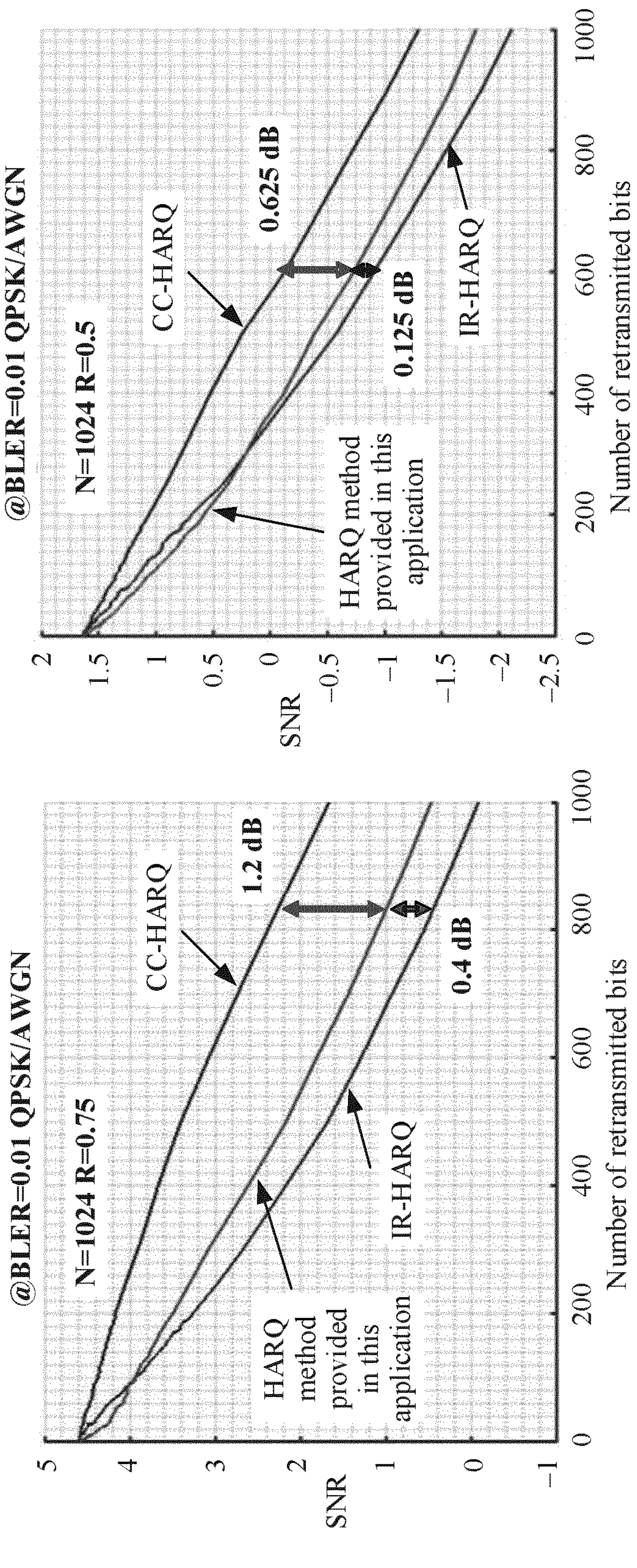
@BLER=0.01 QPSK/AWGN
N=1024 R=0.75
CC-HARQ
1.2 dB
0.4 dB
HARQ method provided in this application
IR-HARQ
SNR
Number of retransmitted bits
@BLER=0.01 QPSK/AWGN
N=1024 R=0.5
CC-HARQ
0.625 dB
0.125 dB
HARQ method provided in this application
IR-HARQ
SNR
Number of retransmitted bits

FIG. 12b

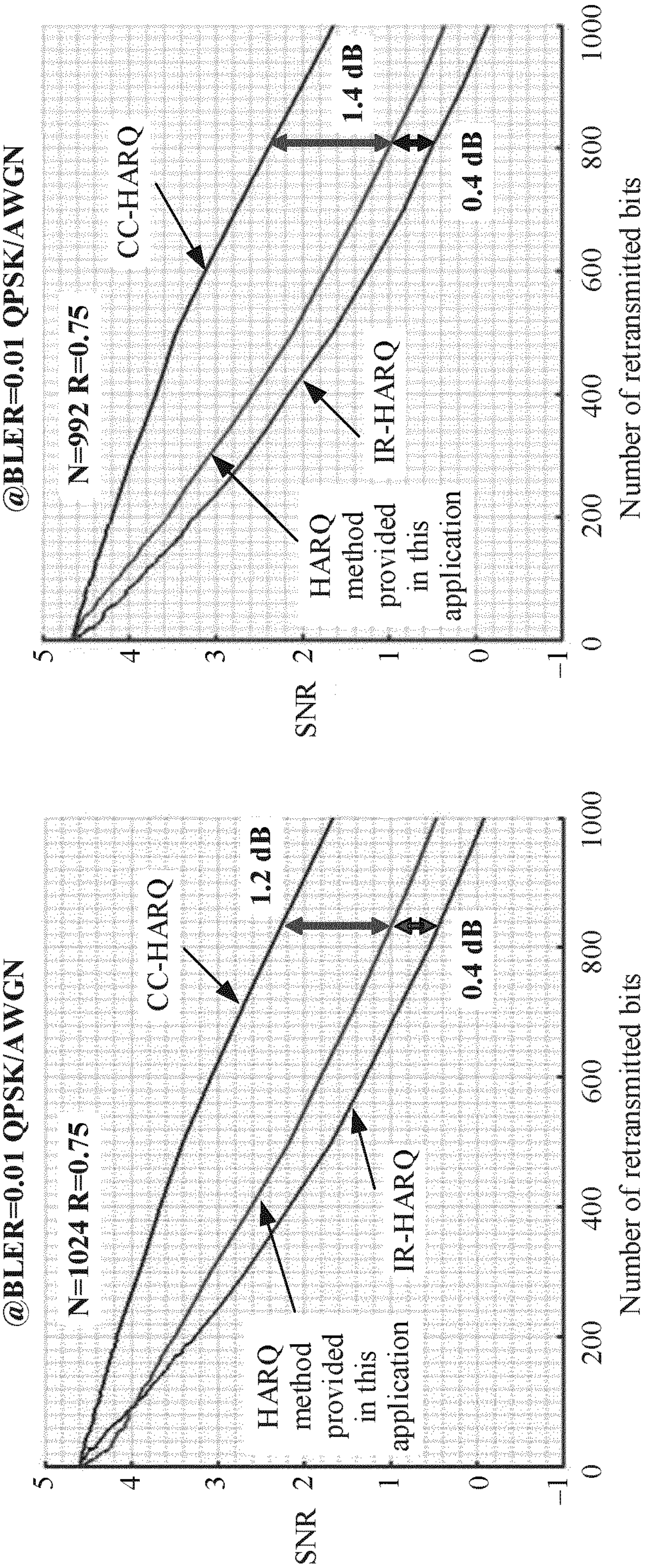
@BLER=0.01 QPSK/AWGN
N=1024 R=0.75
CC-HARQ
1.2 dB
HARQ method provided in this application
IR-HARQ
0.4 dB
SNR
Number of retransmitted bits
@BLER=0.01 QPSK/AWGN
N=992 R=0.75
CC-HARQ
1.4 dB
HARQ method provided in this application
IR-HARQ
0.4 dB
SNR
Number of retransmitted bits

FIG. 12c

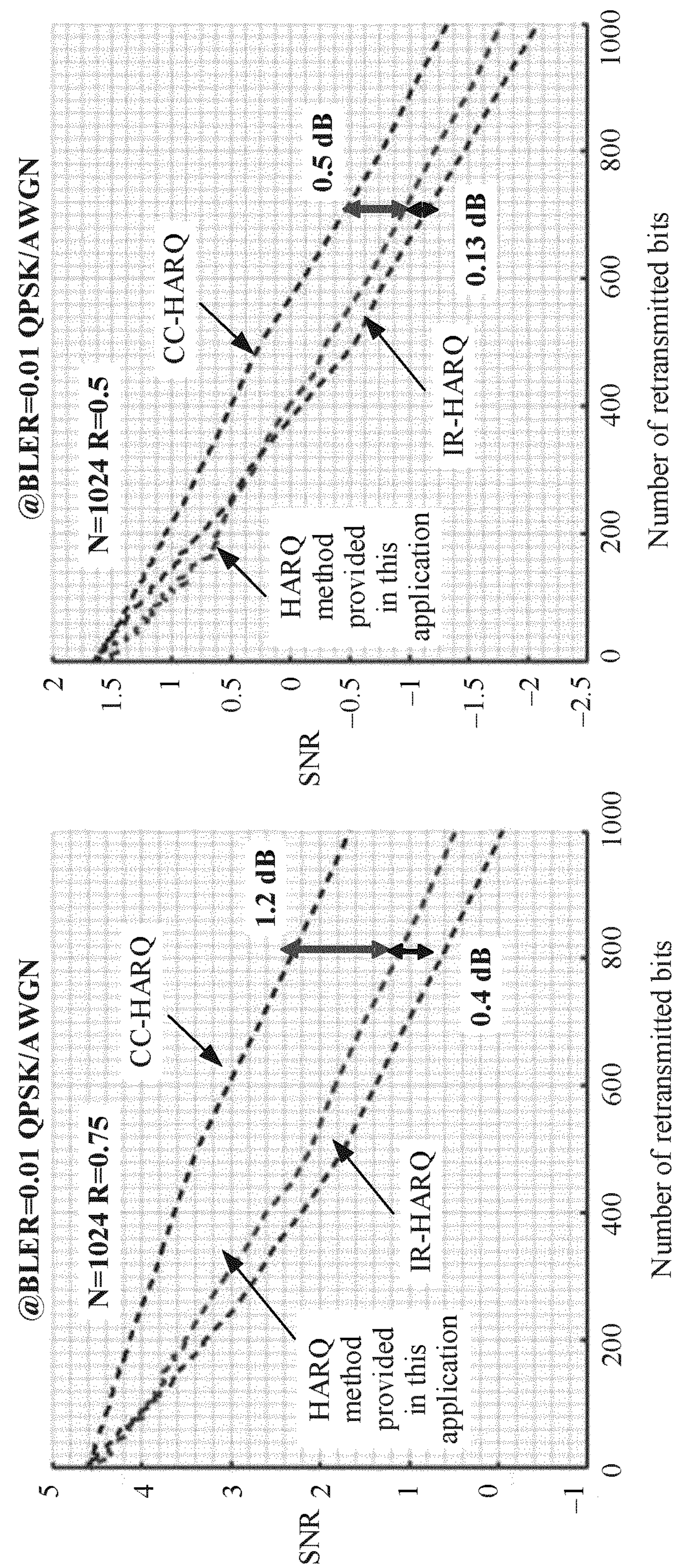
@BLER=0.01 QPSK/AWGN
N=1024 R=0.75
CC-HARQ
1.2 dB
0.4 dB
HARQ method provided in this application
IR-HARQ
SNR
5
4
3
2
1
0
−1
0
200
400
600
800
1000
Number of retransmitted bits
@BLER=0.01 QPSK/AWGN
N=1024 R=0.5
CC-HARQ
0.5 dB
0.13 dB
HARQ method provided in this application
IR-HARQ
SNR
2
1.5
1
0.5
0
−0.5
−1
−1.5
−2
−2.5
0
200
400
600
800
1000
Number of retransmitted bits

FIG. 12d

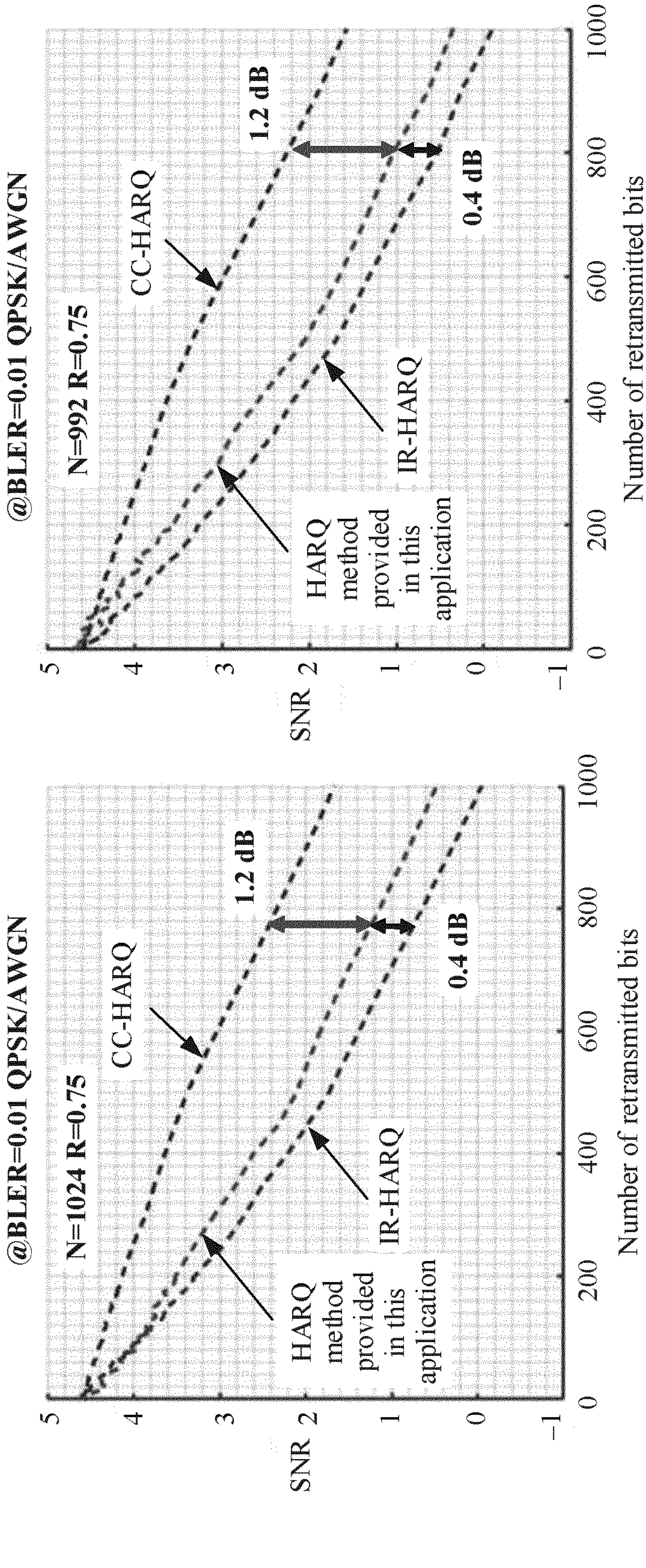
@BLER=0.01 QPSK/AWGN
N=992 R=0.75
CC-HARQ
1.2 dB
0.4 dB
IR-HARQ
HARQ method provided in this application
SNR
5
4
3
2
1
0
−1
0
200
400
600
800
1000
Number of retransmitted bits
@BLER=0.01 QPSK/AWGN
N=1024 R=0.75
CC-HARQ
1.2 dB
0.4 dB
IR-HARQ
HARQ method provided in this application
SNR
5
4
3
2
1
0
−1
0
200
400
600
800
1000
Number of retransmitted bits

FIG. 12e

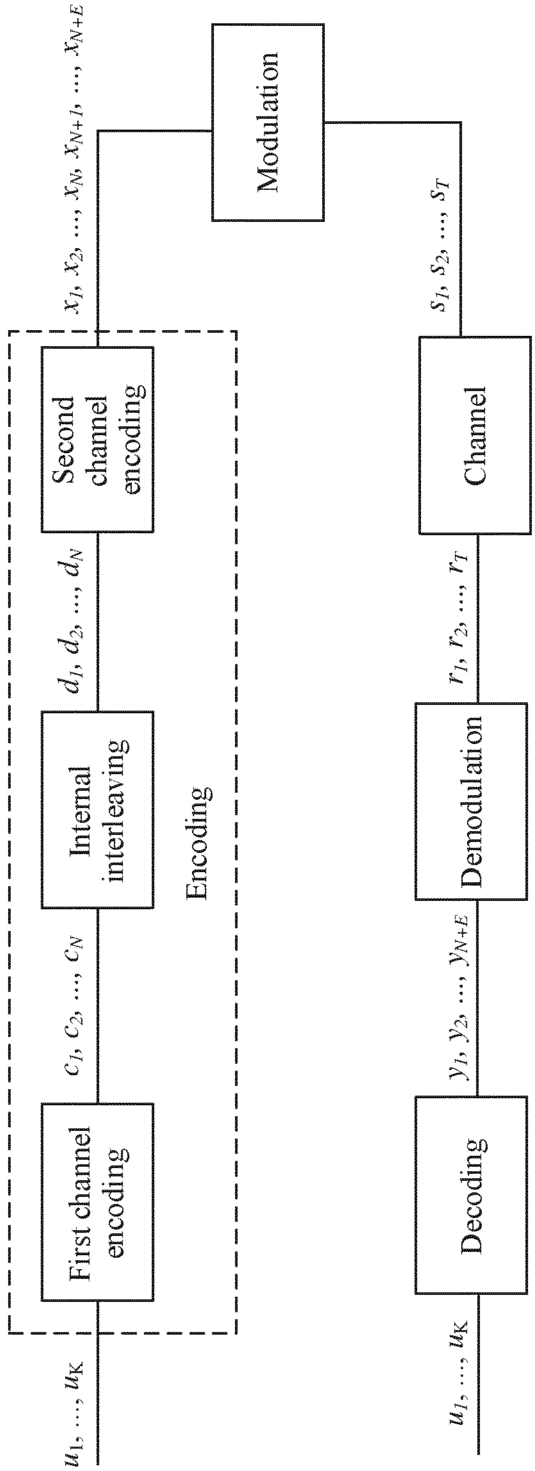
$u_1, ..., u_K$
First channel encoding
$c_1, c_2, ..., c_N$
Internal interleaving
$d_1, d_2, ..., d_N$
Second channel encoding
Encoding
$x_1, x_2, ..., x_N, x_{N+1}, ..., x_{N+E}$
Modulation
$s_1, s_2, ..., s_T$
Channel
$r_1, r_2, ..., r_T$
Demodulation
$y_1, y_2, ..., y_{N+E}$
Decoding
$u_1, ..., u_K$

FIG. 13

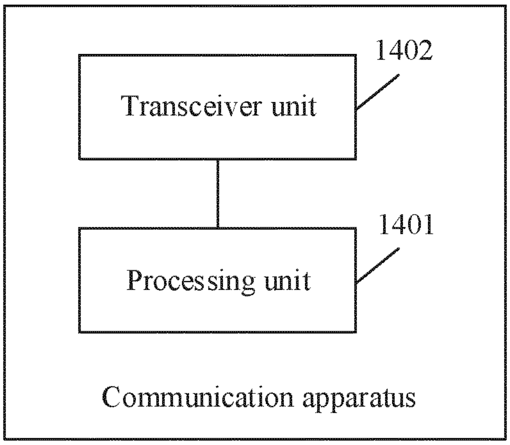
1402
Transceiver unit
1401
Processing unit
Communication apparatus

FIG. 14

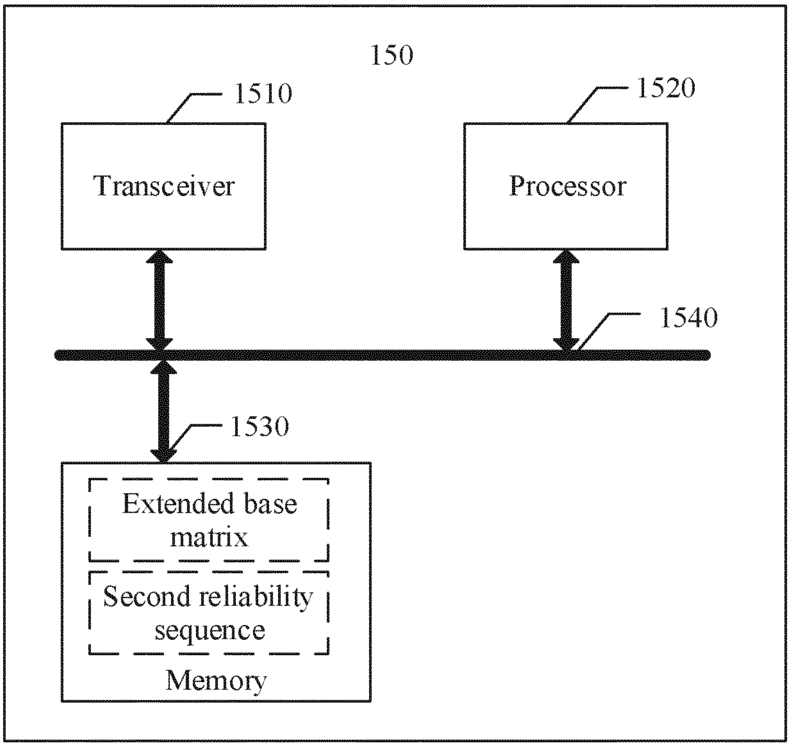
150
1510
Transceiver
1520
Processor
1540
1530
Extended base matrix
Second reliability sequence
Memory

FIG. 15

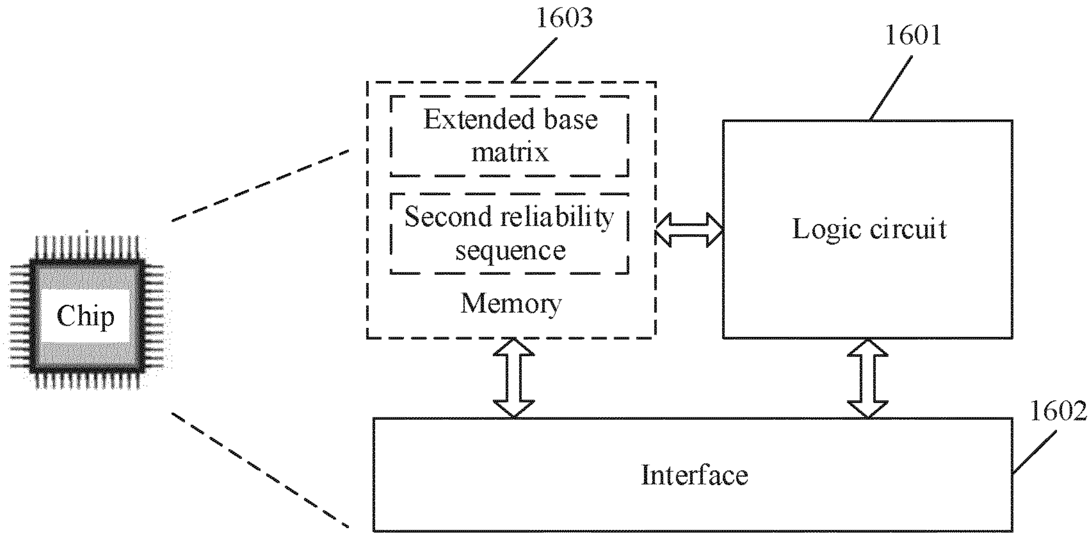
1603
1601
Extended base matrix
Second reliability sequence
Memory
Logic circuit
Chip
1602
Interface

FIG. 16

## INTERNATIONAL SEARCH REPORT

International application No.
**PCT/CN2022/116911**

**A. CLASSIFICATION OF SUBJECT MATTER**

H04L 1/18(2006.01)i；H04L 1/00(2006.01)i

According to International Patent Classification (IPC) or to both national classification and IPC

**B. FIELDS SEARCHED**

Minimum documentation searched (classification system followed by classification symbols)

H04L 1/-

Documentation searched other than minimum documentation to the extent that such documents are included in the fields searched

Electronic data base consulted during the international search (name of data base and, where practicable, search terms used)

CNABS; CNTXT; CNKI: 重传, 初始比特, 初始比特, 重传比特, 重传信息比特, 信道编码, 扩展矩阵, 基矩阵, 极化码, 码长, 扩展, 灵活; VEN; USTXT; EPTXT; WOTXT; 3GPP: polar code, retransm+, bit sequence?, decod+, expansion matrix, flexibl+

**C. DOCUMENTS CONSIDERED TO BE RELEVANT**

| Category* | Citation of document, with indication, where appropriate, of the relevant passages | Relevant to claim No. |
|---|---|---|
| X | CN 107409006 A (HUAWEI TECHNOLOGIES CO., LTD.) 28 November 2017 (2017-11-28) claim 1, and description, page 12, line 21-page 25, line 20 | 1, 22, 43-47 |
| A | CN 108023675 A (HUAWEI TECHNOLOGIES CO., LTD.) 11 May 2018 (2018-05-11) entire document | 1-47 |
| A | US 2020304246 A1 (ELECTRONICS AND TELECOMMUNICATIONS RESEARCH INSTITUTE) 24 September 2020 (2020-09-24) entire document | 1-47 |
| A | US 2019140663 A1 (LG ELECTRONICS INC.) 09 May 2019 (2019-05-09) entire document | 1-47 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 November 2022** | **30 November 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.
**PCT/CN2022/116911**

| Patent document cited in search report | Publication date (day/month/year) | Patent family member(s) | Publication date (day/month/year) |
|---|---|---|---|
| CN 107409006 A | 28 November 2017 | WO 2016154972 A1 | 06 October 2016 |
| | | EP 3264651 A1 | 03 January 2018 |
| | | US 2018026751 A1 | 25 January 2018 |
| | | EP 3264651 A4 | 04 April 2018 |
| | | US 10484137 B2 | 19 November 2019 |
| | | CN 107409006 B | 21 April 2020 |
| | | EP 3264651 B1 | 06 May 2020 |
| CN 108023675 A | 11 May 2018 | None | |
| US 2020304246 A1 | 24 September 2020 | US 11336401 B2 | 17 May 2022 |
| | | KR 20200112668 A | 05 October 2020 |
| US 2019140663 A1 | 09 May 2019 | WO 2017217711 A1 | 21 December 2017 |
| | | US 10903857 B2 | 26 January 2021 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202111169363